# EUROPEAN PATENT APPLICATION

(11) **EP 4 629 292 A2**
(43) Date of publication of application: **08.10.2025**
(21) Application number: 25196791.5
(22) Date of filing: 13.04.2023
(51) Int. Cl.: H01L 25/18

(54) **SEMICONDUCTOR DEVICE**

(30) Priority: 02.05.2022 JP 2022075921; 09.08.2022 JP 2022127149
(62) Divisional of application: 23799432.2
(71) Applicant: Rohm Co., Ltd., Kyoto-shi, Kyoto 615-8585 (JP)
(72) Inventor: TANIKAWA, Kohei, Kyoto, 615-8585 (JP); IKEDA, Daiki, Kyoto, 615-8585 (JP)
(74) Representative: Witte, Weller & Partner Patentanwälte mbB

(57) **Abstract**

A semiconductor device includes at least one terminal, and the terminal includes a cylindrical holder having electrical conductivity and a metal pin inserted in the holder. The semiconductor device further includes a terminal support supporting the holder, and a sealing resin covering a part of the holder and covering the terminal support. The sealing resin includes a resin obverse surface facing a first side in a thickness direction. The holder includes a first surface located at one end on the first side in the thickness direction and a first outer side surface extending in the thickness direction. The first surface is located at a position different from the resin obverse surface in the thickness direction. The first outer side surface is in contact with the sealing resin. The metal pin protrudes beyond the resin obverse surface toward the first side in the thickness direction.

## Description

### TECHNICAL FIELD

The present disclosure relates to a semiconductor device.

### BACKGROUND ART

Semiconductor devices with power switching elements such as MOSFETs (Metal Oxide Semiconductor Field Effect Transistors) or IGBTs (Insulated Gate Bipolar Transistors) are conventionally known. These semiconductor devices are used in a variety of electronic equipment, including industrial equipment, home appliances, information terminals, and automotive equipment. A conventional semiconductor device (power module) is disclosed in Patent Document 1. The semiconductor device disclosed in Patent Document 1 includes a semiconductor element and a support substrate (ceramic substrate). The semiconductor element is, for example, an IGBT made of Si (silicon). The support substrate supports the semiconductor element. The support substrate includes an insulating base and a conductive layer provided on each side of the base. The base is made of, for example, a ceramic material. The conductive layers are made of Cu (copper), for example. The semiconductor element is bonded to one of the conductive layers.

### PRIOR ART DOCUMENT

### Patent Document

Patent Document 1: JP-A-2021-190505

### SUMMARY OF THE INVENTION

### Problem to be Solved by the Invention

In recent years, energy-saving, high-performance and miniaturization have been demanded of electronic equipment. To meet the demand, improved performance and miniaturization of semiconductor modules mounted in the electronic equipment are required.

An object of the present disclosure is to provide a semiconductor device that is improved over conventional ones. In particular, in light of the above circumstances, an object of the present disclosure is to provide a semiconductor device suitable for improving the performance and miniaturization.

A semiconductor device provided according to a first aspect of the present disclosure includes: at least one terminal including a cylindrical holder having electrical conductivity and a metal pin inserted in the holder; a terminal support supporting the holder; and a sealing resin covering a part of the holder and covering the terminal support. The sealing resin has a resin obverse surface facing a first side in the thickness direction. The holder has a first surface located at one end on the first side in the thickness direction and a first outer side surface extending in the thickness direction. The first surface is located at a position different from the resin obverse surface in the thickness direction. The first outer side surface is in contact with the sealing resin. The metal pin protrudes beyond the resin obverse surface toward the first side in the thickness direction.

A semiconductor device provided according to a second aspect of the present disclosure includes: a support substrate including an obverse surface facing a first side in a thickness direction; at least one terminal including a holder disposed on the obverse surface and having electrical conductivity and a metal pin inserted in the holder; and a sealing resin including a resin obverse surface facing the first side in the thickness direction and covering at least a part of the support substrate. The holder of at least one of the at least one terminal is entirely exposed from the sealing resin. The metal pin protrudes beyond the resin obverse surface toward the first side in the thickness direction.

### Advantages of the Invention

With the above-described configuration, a semiconductor device having a configuration favorable for improving the performance and reducing the size is provided.

Other features and advantages of the present disclosure will become apparent from the detailed description given below with reference to the accompanying drawings.

### BRIEF DESCRIPTION OF THE DRAWINGS

Fig. 1 is a perspective view of a semiconductor device according to a first embodiment of the present disclosure.
Fig. 2 is a perspective view showing relevant portions of the semiconductor device according to the first embodiment of the present disclosure.
Fig. 3 is a perspective view showing relevant portions of the semiconductor device according to the first embodiment of the present disclosure.
Fig. 4 is a plan view of the semiconductor device according to the first embodiment of the present disclosure.
Fig. 5 is a plan view showing relevant portions of the semiconductor device according to the first embodiment of the present disclosure.
Fig. 6 is a side view showing relevant portions of the semiconductor device according to the first embodiment of the present disclosure.
Fig. 7 is an enlarged plan view showing relevant portions of the semiconductor device according to the first embodiment of the present disclosure.
Fig. 8 is a plan view showing relevant portions of the semiconductor device according to the first embodiment of the present disclosure.
Fig. 9 is a plan view showing relevant portions of the semiconductor device according to the first embodiment of the present disclosure.
Fig. 10 is a side view showing relevant portions of the semiconductor device according to the first embodiment of the present disclosure.
Fig. 11 is a bottom view showing relevant portions of the semiconductor device according to the first embodiment of the present disclosure.
Fig. 12 is a sectional view taken along line XII-XII in Fig. 5.
Fig. 13 is a sectional view taken along line XIII-XIII in Fig. 5.
Fig. 14 is an enlarged sectional view showing relevant portions of the semiconductor device according to the first embodiment of the present disclosure.
Fig. 15 is an enlarged sectional view showing relevant portions of the semiconductor device according to the first embodiment of the present disclosure.
Fig. 16 is a partial enlarged view showing a part of Fig. 13.
Fig. 17 is a partial enlarged view showing a part of Fig. 4**.**
Fig. 18 is a sectional view taken along line XVIII-XVIII in Fig. 5.
Fig. 19 is a sectional view taken along line XIX-XIX in Fig. 5.
Fig. 20 is a sectional view taken along line XX-XX in Fig. 5.
Fig. 21 is a sectional view taken along line XXI-XXI in Fig. 5.
Fig. 22 is a sectional view taken along line XXII-XXII in Fig. 5.
Fig. 23 is an enlarged sectional view corresponding to Fig. 16, showing a semiconductor device according to a first variation of the first embodiment.
Fig. 24 is an enlarged sectional view corresponding to Fig. 16, showing a semiconductor device according to a second variation of the first embodiment.
Fig. 25 is an enlarged sectional view corresponding to Fig. 16, showing a semiconductor device according to a third variation of the first embodiment.
Fig. 26 is an enlarged sectional view corresponding to Fig. 16, showing a semiconductor device according to a fourth variation of the first embodiment.
Fig. 27 is an enlarged sectional view corresponding to Fig. 16, showing a semiconductor device according to a fifth variation of the first embodiment.
Fig. 28 is a perspective view of a semiconductor device according to a second embodiment of the present disclosure.
Fig. 29 is an enlarged sectional view corresponding to Fig. 16, showing the semiconductor device according to the second embodiment of the present disclosure.
Fig. 30 is a perspective view of a semiconductor device according to a first embodiment based on a second aspect of the present disclosure.
Fig. 31 is a plan view of the semiconductor device according to the first embodiment based on the second aspect of the present disclosure.
Fig. 32 is a plan view corresponding to Fig. 31, in which the sealing resin is shown by imaginary lines.
Fig. 33 is a plan view corresponding to Fig. 32, from which the sealing resin and the second conductive member are omitted.
Fig. 34 is a plan view corresponding to Fig. 33, from which the first conductive member is omitted.
Fig. 35 is a bottom view of the semiconductor device according to the first embodiment based on the second aspect of the present disclosure.
Fig. 36 is a sectional view taken along line XXXVI-XXXVI in Fig. 32.
Fig. 37 is a partially enlarged sectional view showing a part (near the first element) of Fig. 36.
Fig. 38 is a partially enlarged sectional view showing a part (near the second element) of Fig. 36.
Fig. 39 is a sectional view taken along line XXXIX-XXXIX in Fig. 32.
Fig. 40 is a sectional view taken along line XL-XL in Fig. 32.
Fig. 41 is a sectional view taken along line XLI-XLI in Fig. 32.
Fig. 42 is a sectional view taken along line XLII-XLII in Fig. 32.
Fig. 43 is a sectional view taken along line XLIII-XLIII in Fig. 32.
Fig. 44 is a partial enlarged sectional view showing a part of Fig. 40.
Fig. 45 is a sectional view showing a step of a method for manufacturing the semiconductor device according to the first embodiment based on the second aspect of the present disclosure.
Fig. 46 is a plan view of a semiconductor device according to a first variation of the first embodiment based on the second aspect of the present disclosure.
Fig. 47 is a sectional view taken along line XLVII-XLVII in Fig. 46.
Fig. 48 is a sectional view taken along line XLVIII-XLVIII in Fig. 46.
Fig. 49 is a sectional view corresponding to Fig. 40, showing a semiconductor device according to a second variation of the first embodiment of the second aspect.
Fig. 50 is a sectional view corresponding to Fig. 47, showing a semiconductor device according to a third variation of the first embodiment of the second aspect.
Fig. 51 is a sectional view corresponding to Fig. 40, showing a semiconductor device according to a fourth variation of the first embodiment of the second aspect.
Fig. 52 is a plan view of a semiconductor device according to a fifth variation of the first embodiment of the second aspect.
Fig. 53 is a sectional view taken along line LIII-LIII in Fig. 52.

### MODE FOR CARRYING OUT THE INVENTION

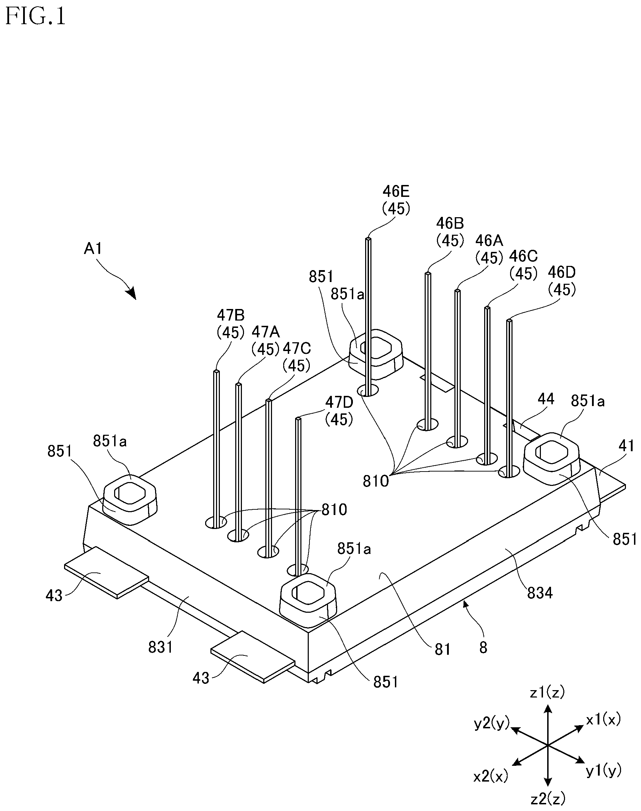

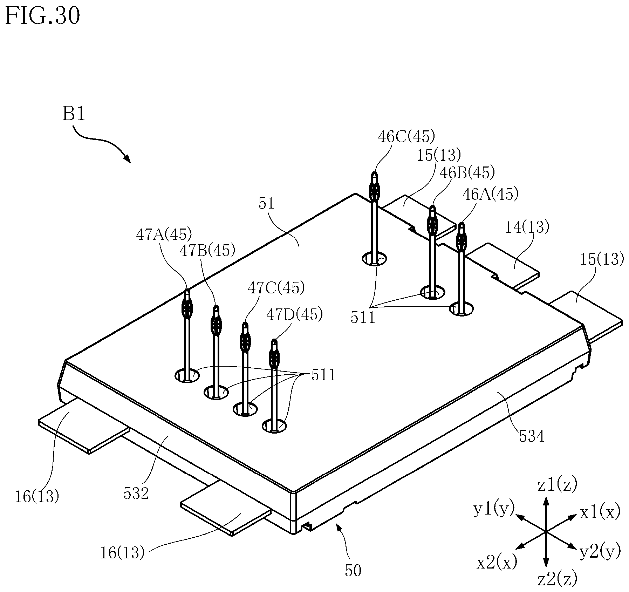

The following describes preferred embodiments of the present disclosure in detail with reference to the drawings. First, a semiconductor device based on a first aspect of the present disclosure will be described with reference to Figs. 1 to 29. Thereafter, a semiconductor device based on a second aspect of the present disclosure will be described with reference to Figs. 30 to 53. Incidentally, the reference signs used in Figs. 1 to 29 (the first aspect) and the reference signs used in Figs. 30 to 53 (the second aspect) are independent of each other. Therefore, the same reference sign may denote different members of the first aspect and the second aspect, or different reference signs may denote the same (or similar) members of the first aspect and the second aspect.

In the present disclosure, the terms such as "first", "second", and "third" are used merely as labels and are not intended to impose ordinal requirements on the items to which these terms refer.

In the description of the present disclosure, the expression "An object A is formed in an object **B",** and "An object A is formed on an object B" imply the situation where, unless otherwise specifically noted, "the object A is formed directly in or on the object **B",** and "the object A is formed in or on the object B, with something else interposed between the object A and the object B". Likewise, the expression "An object A is disposed in an object **B",** and "An object A is disposed on an object B" imply the situation where, unless otherwise specifically noted, "the object A is disposed directly in or on the object **B",** and "the object A is disposed in or on the object B, with something else interposed between the object A and the object B"**.** Further, the expression "An object A is located on an object B" implies the situation where, unless otherwise specifically noted, "the object A is located on the object B, in contact with the object **B",** and "the object A is located on the object B, with something else interposed between the object A and the object B"**.** Still further, the expression "An object A overlaps with an object B as viewed in a certain direction" implies the situation where, unless otherwise specifically noted, "the object A overlaps with the entirety of the object **B",** and "the object A overlaps with a part of the object B"**.** Furthermore, in the description of the present disclosure, the expression "A surface A faces (a first side or a second side) in a direction B" is not limited to the situation where the angle of the surface A to the direction B is 90° and includes the situation where the surface A is inclined with respect to the direction B.

### First embodiment (First aspect):

Figs. 1 to 22 show a semiconductor device according to a first embodiment based on the first aspect of the present disclosure. The semiconductor device A1 of the present embodiment includes a plurality of first semiconductor elements 10A, a plurality of second semiconductor elements 10B, a support substrate 3, a first terminal 41, a second terminal 42, a plurality of third terminals 43, a fourth terminal 44, a plurality of control terminals 45, a control terminal support 48, a first conductive member 5, a second conductive member 6, and a sealing resin 8.

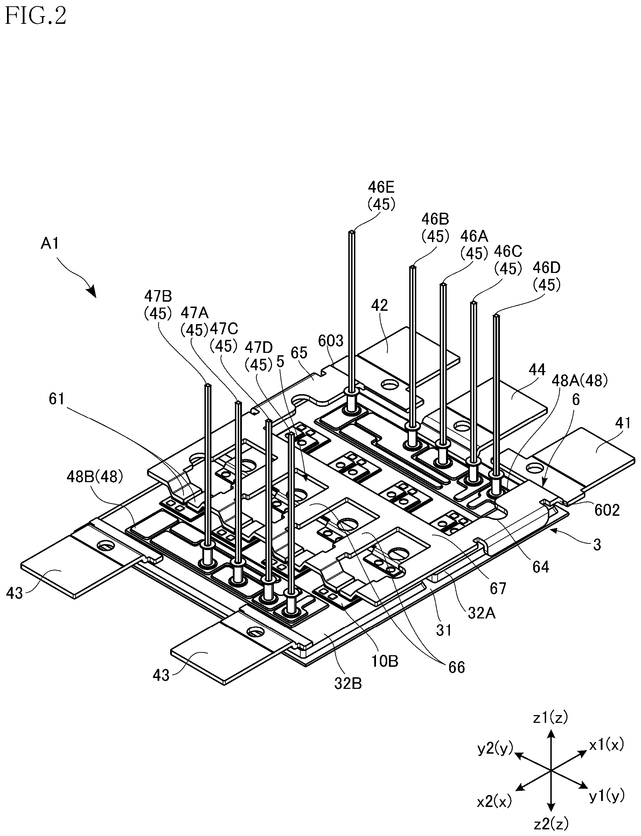

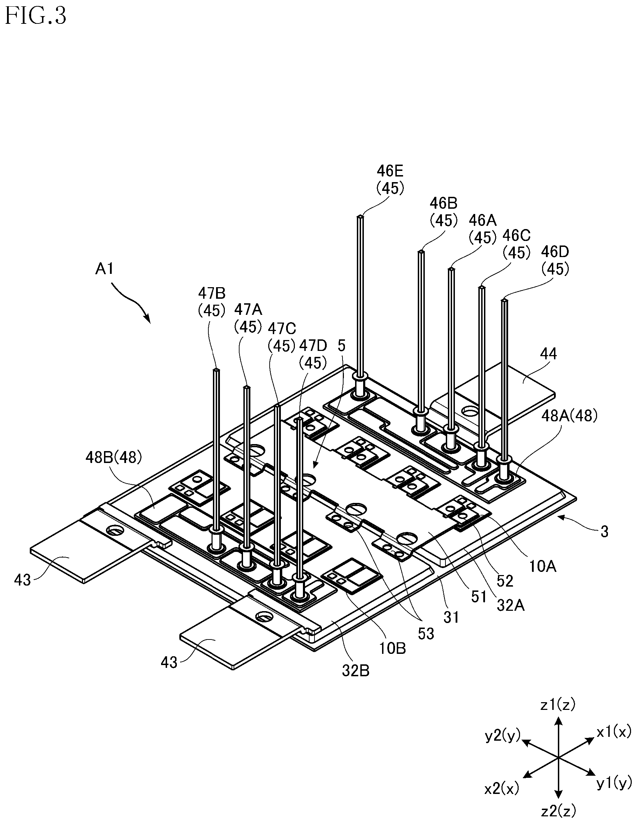

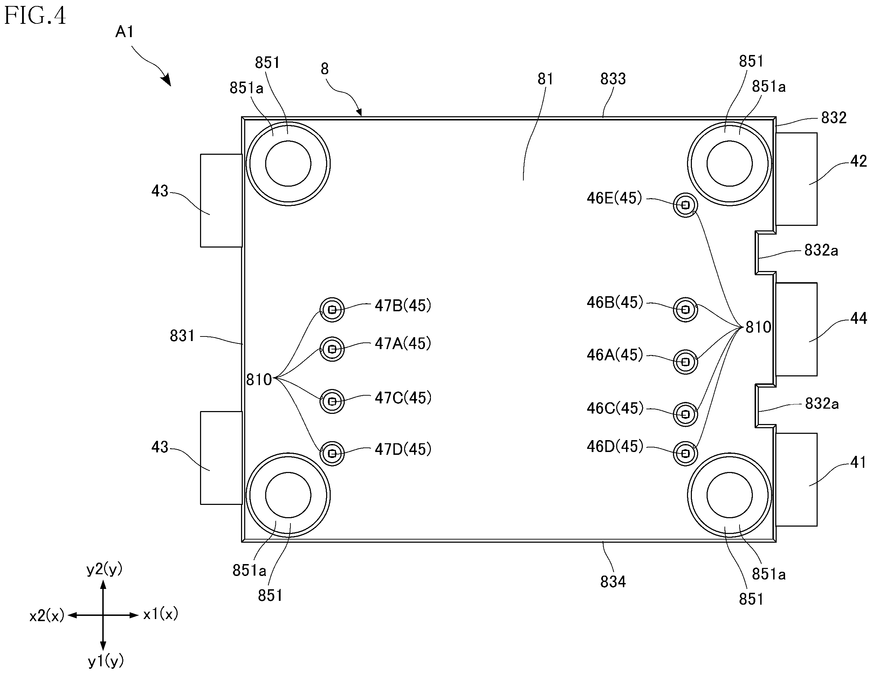

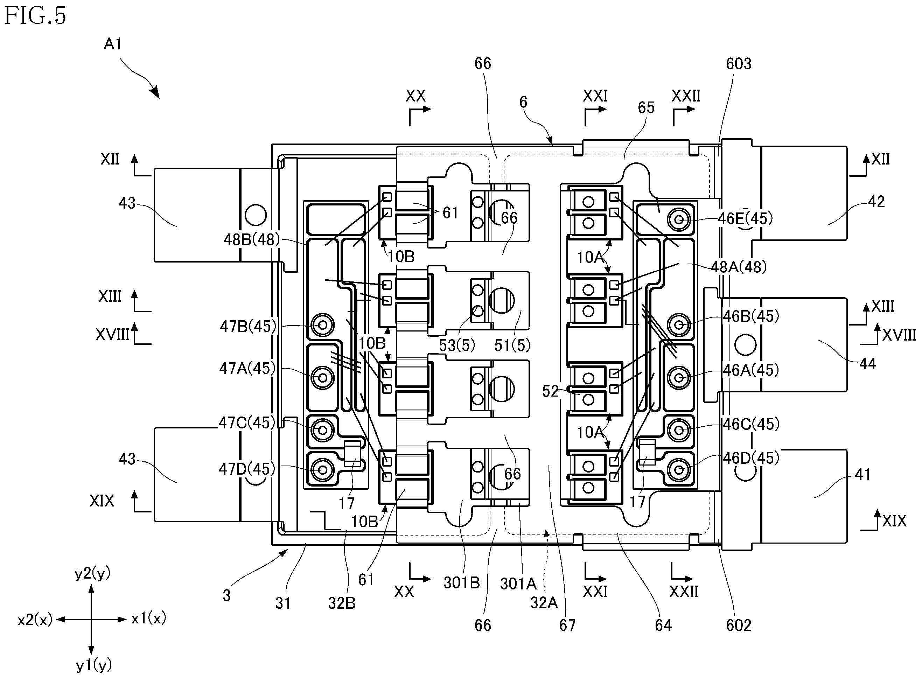

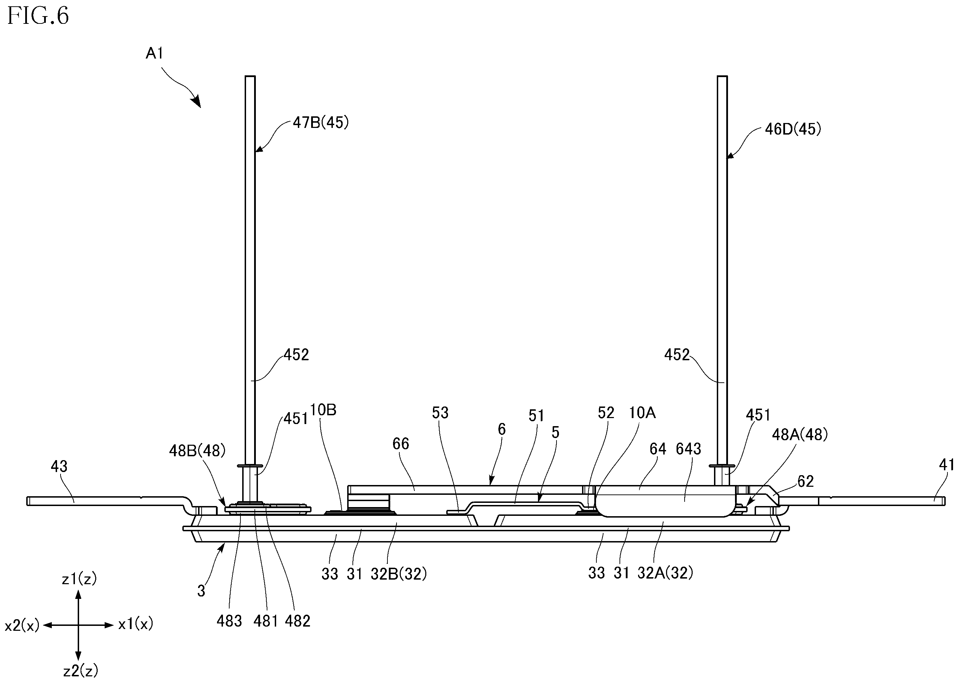

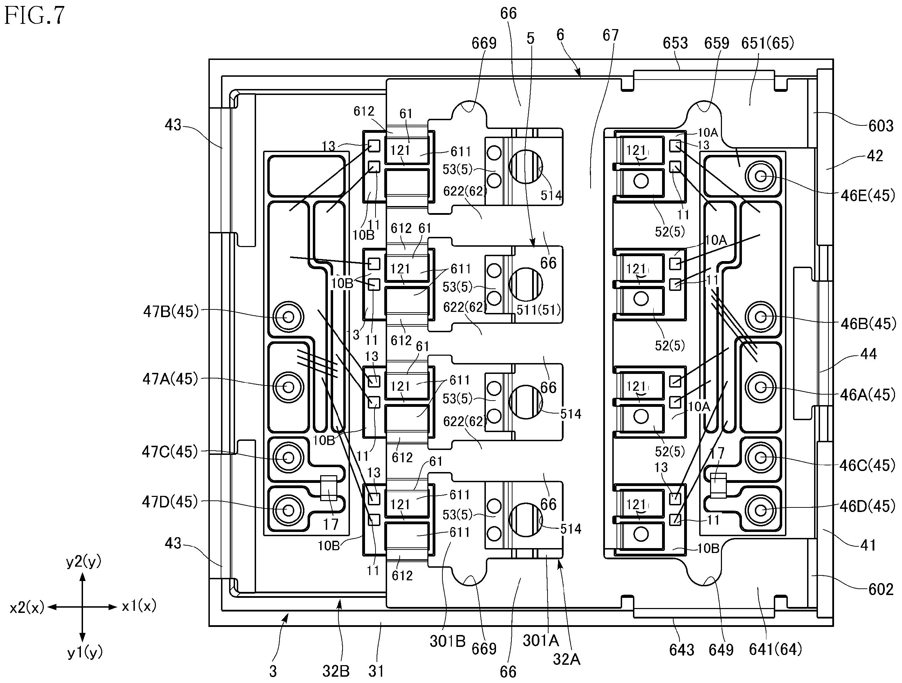

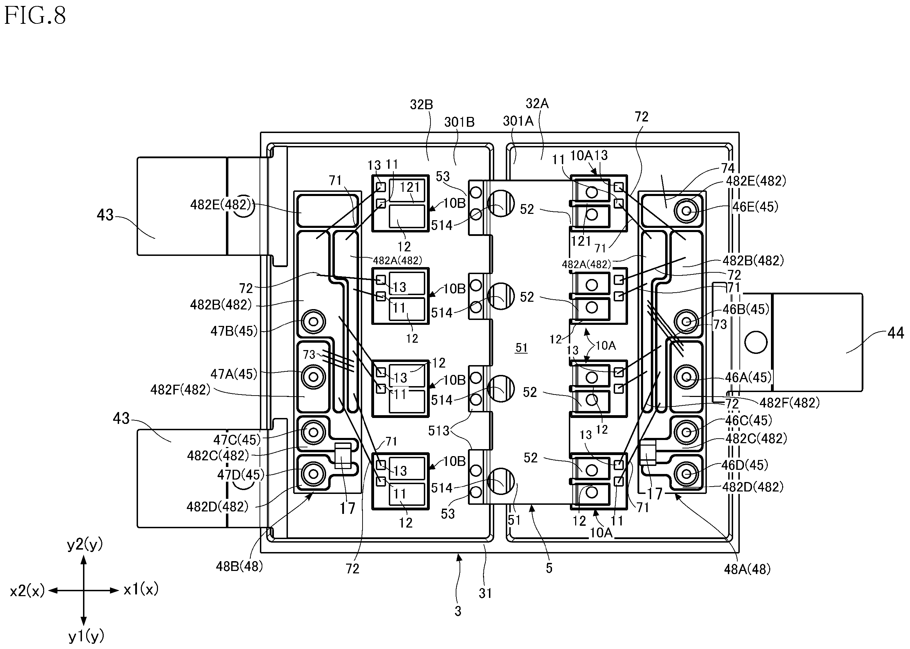

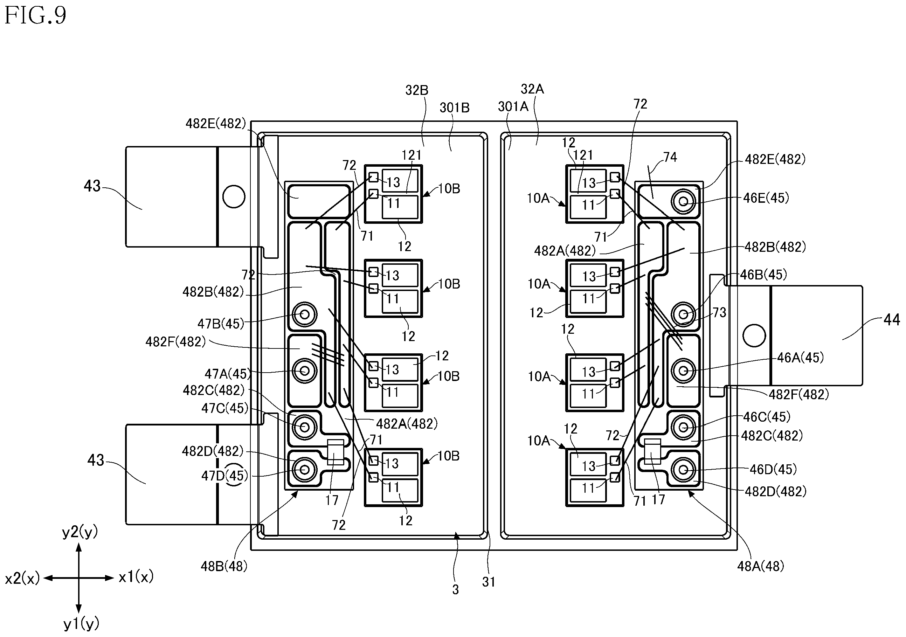

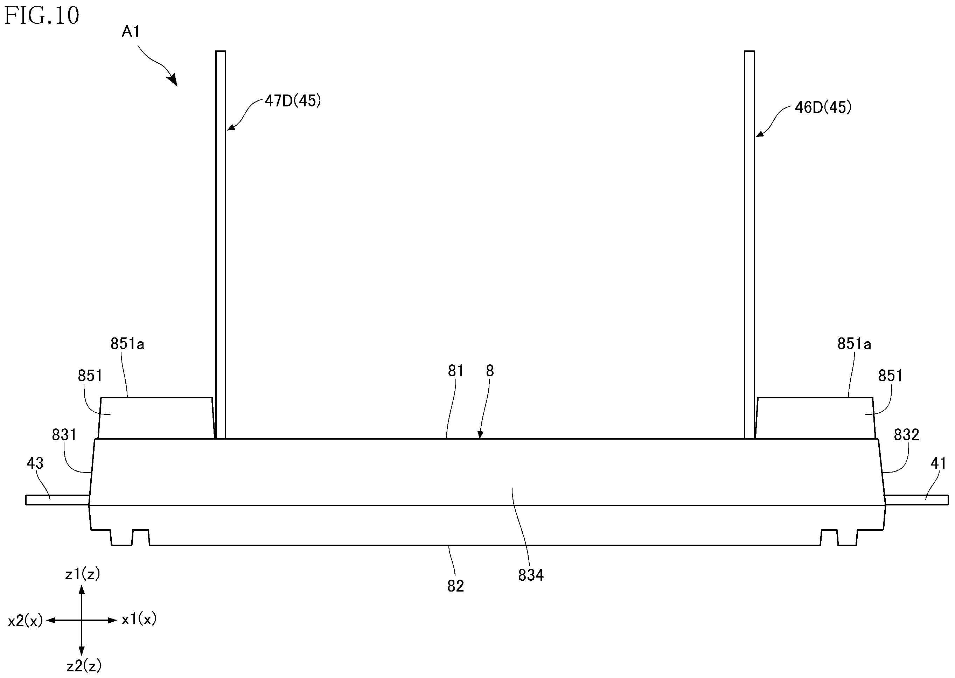

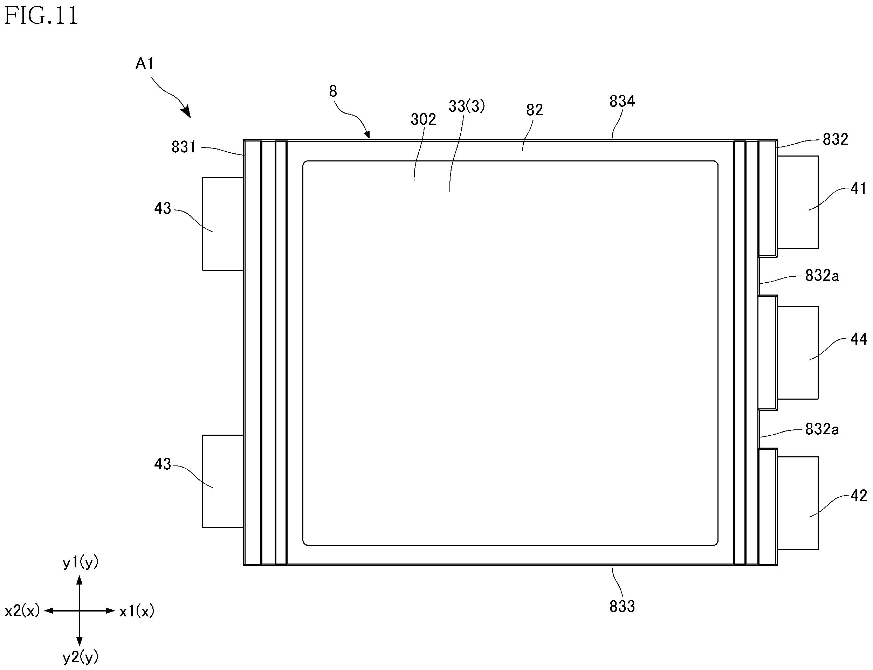

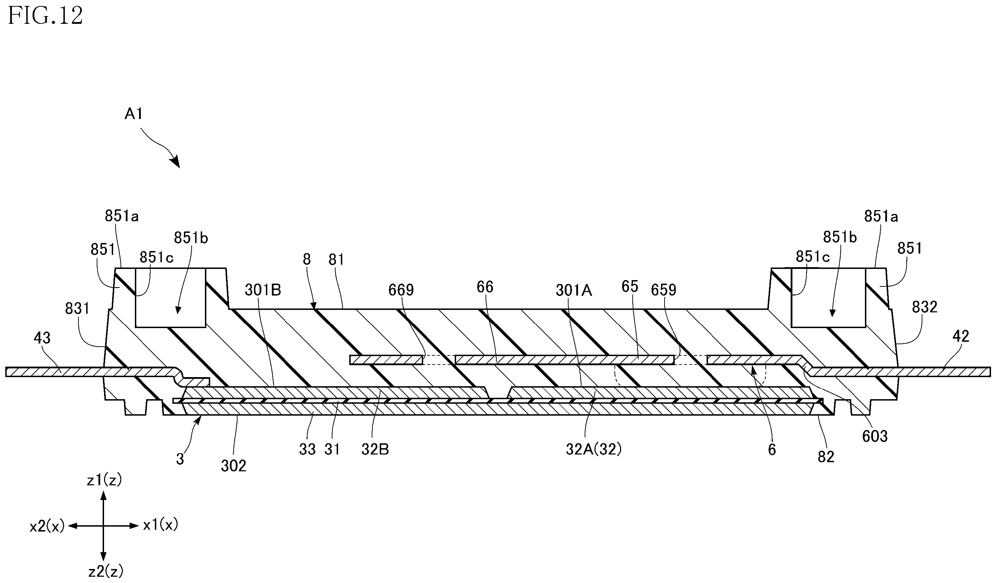

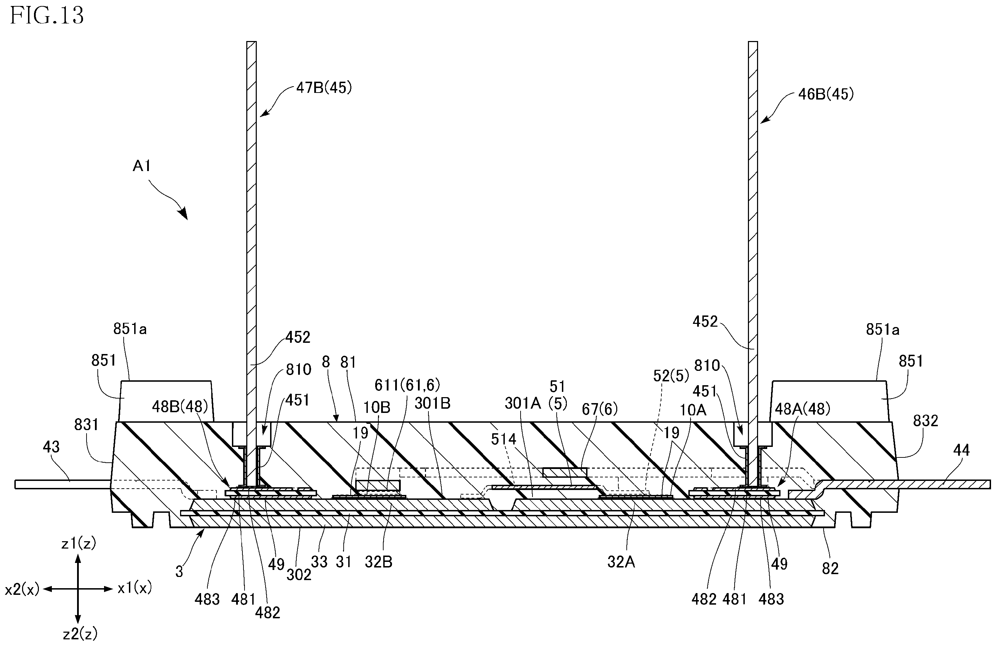

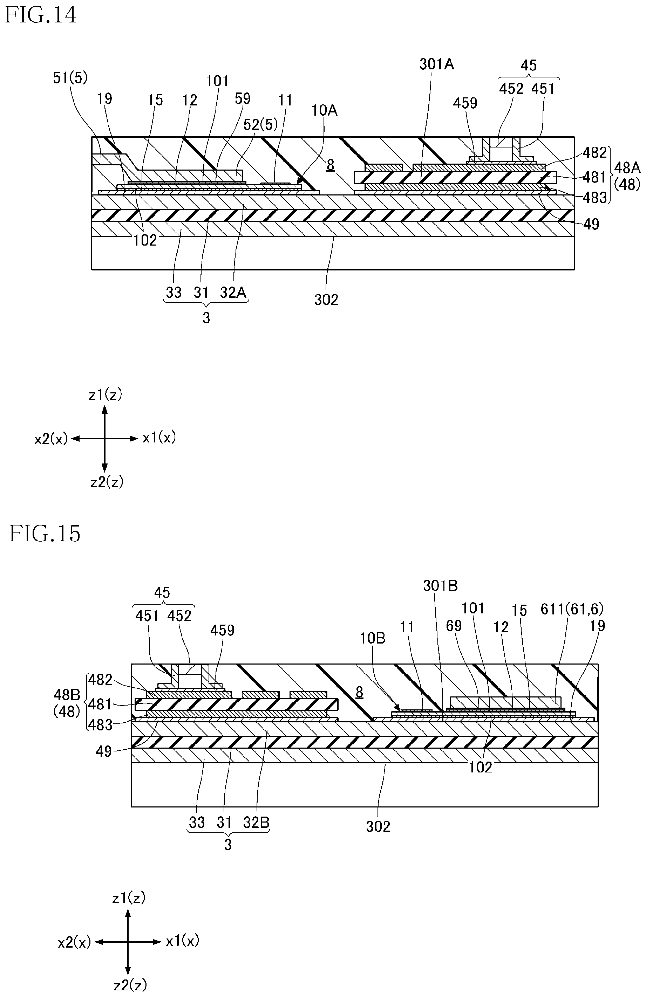

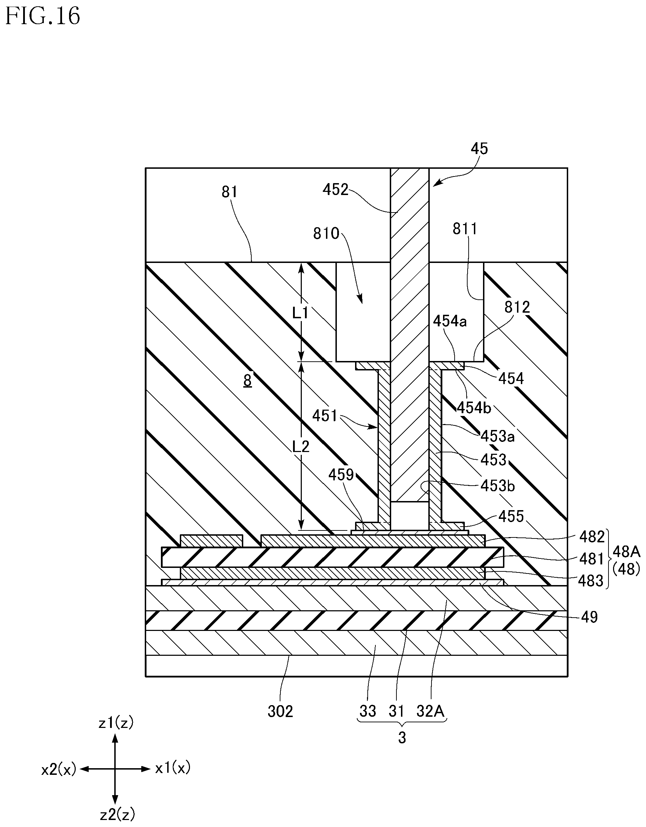

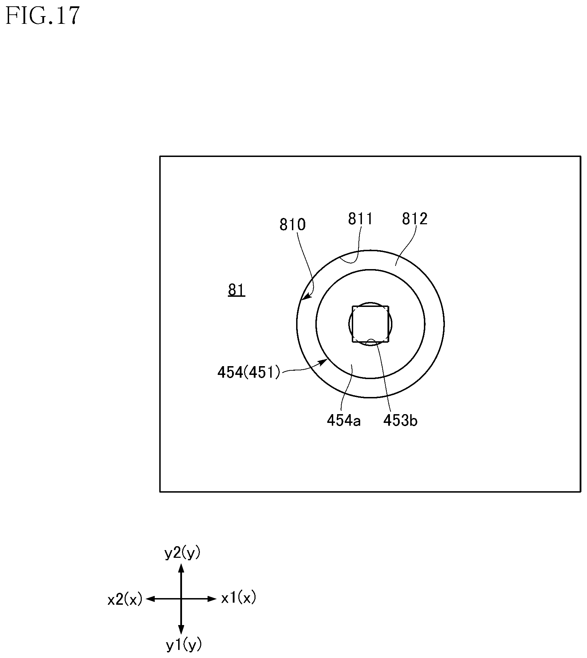

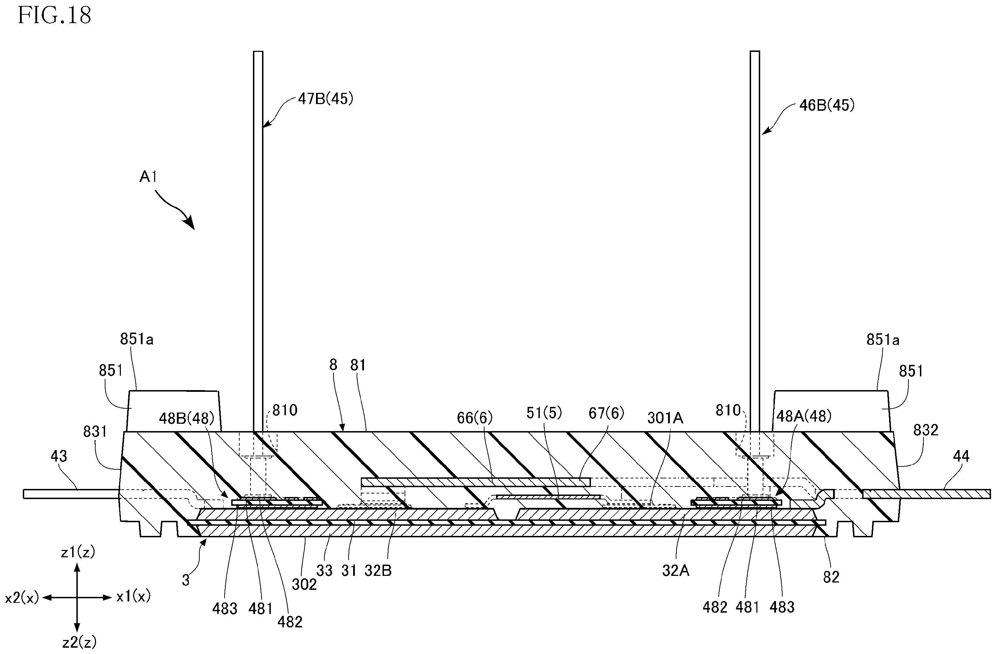

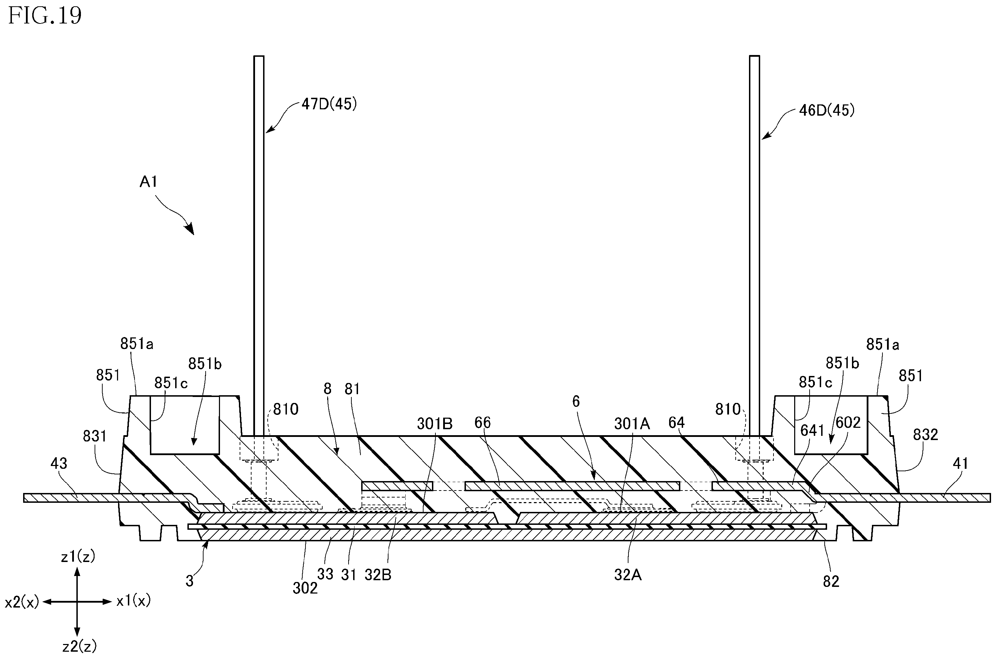

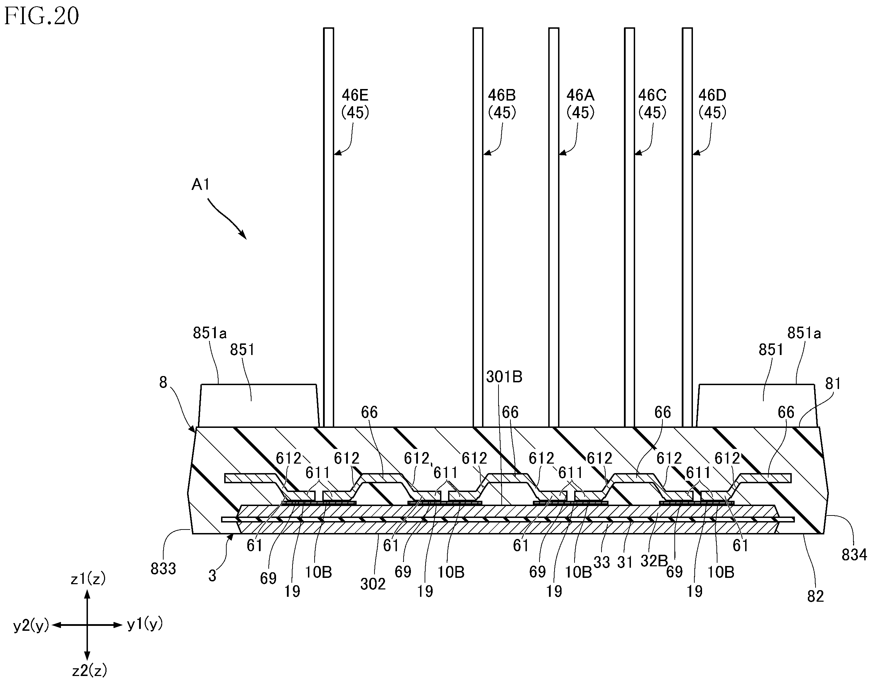

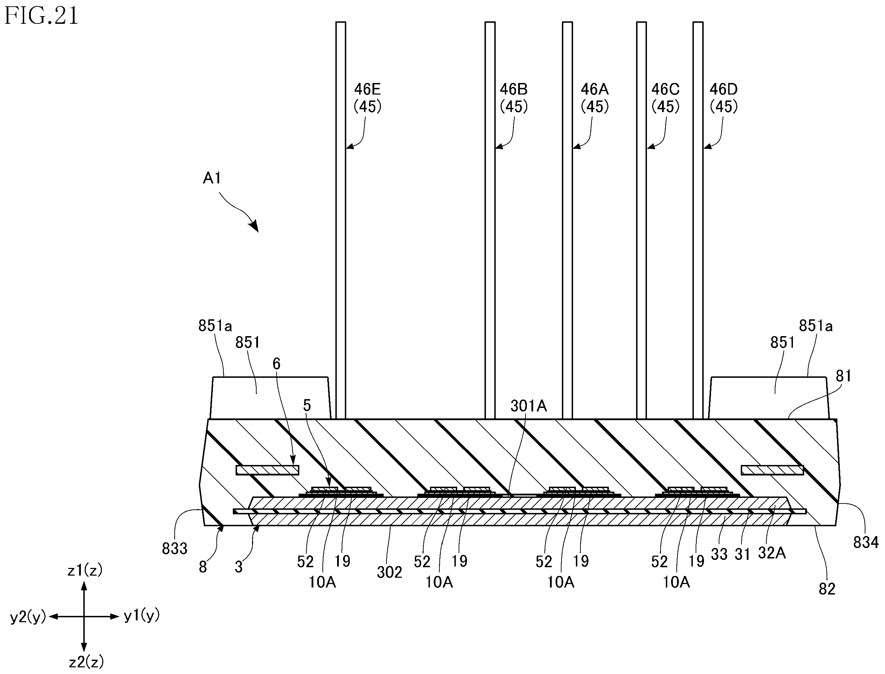

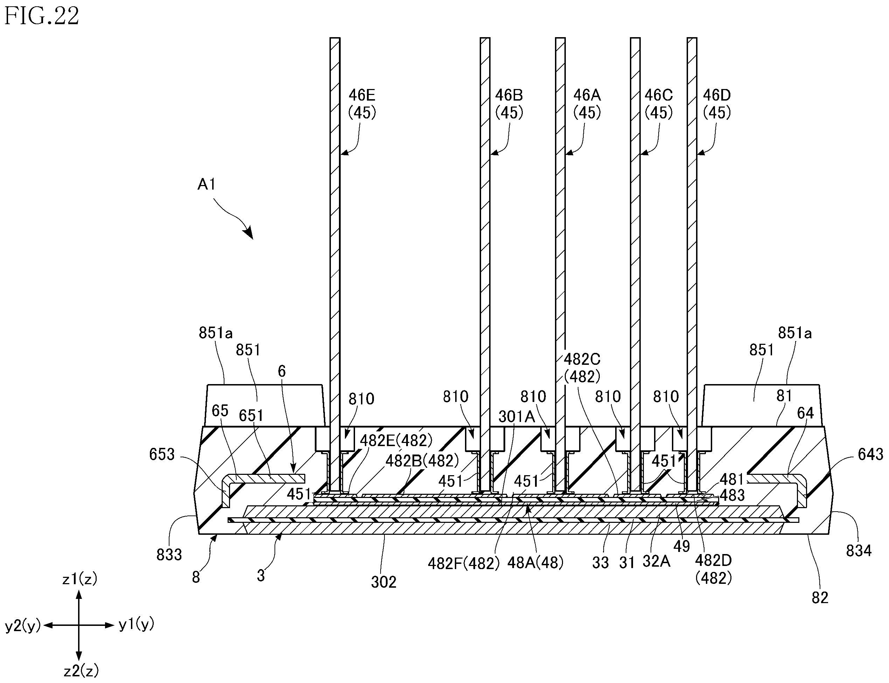

Fig. 1 is a perspective view of the semiconductor device A1. Figs. 2 and 3 are perspective views showing relevant portions of the semiconductor device A1. Fig. 4 is a plan view of the semiconductor device A1. Fig. 5 is a plan view showing relevant portions of the semiconductor device A1. Fig. 6 is a side view showing relevant portions of the semiconductor device A1. Fig. 7 is an enlarged plan view showing relevant portions of the semiconductor device A1. Figs. 8 and 9 are plan views showing relevant portions of the semiconductor device A1. Fig. 10 is a side view of the semiconductor device A1. Fig. 11 is a bottom view of the semiconductor device A1. Fig. 12 is a sectional view taken along line XII-XII in Fig. 5. Fig. 13 is a sectional view taken along line XIII-XIII in Fig. 5. Figs. 14 and 15 are plan views showing relevant portions of the semiconductor device A1. Fig. 16 is a partial enlarged view showing a part of Fig. 13. Fig. 17 is a partial enlarged view showing a part of Fig. 4. Fig. 18 is a sectional view taken along line XVIII-XVIII in Fig. 5. Fig. 19 is a sectional view taken along line XIX-XIX in Fig. 5. Fig. 20 is a sectional view taken along line XX-XX in Fig. 5. Fig. 21 is a sectional view taken along line XXI-XXI in Fig. 5. Fig. 22 is a sectional view taken along line XXII-XXII in Fig. 5.

For the convenience of description, three mutually orthogonal directions are defined as an x direction, a y direction, and a z direction. The z direction is one example of the thickness direction, and the x direction is one example of the first direction. Further, one side in the x direction is referred to as the x1 side in the x direction, whereas the other side in the x direction is referred to as the x2 side in the x direction. Also, one side in the y direction is referred to as the y1 side in the y direction, whereas the other side in the y direction is referred to as the y2 side in the y direction. Also, one side in the z direction is referred to as the z1 side in the z direction, whereas the other side in the z direction is referred to as the z2 side in the z direction.

Each of the first semiconductor elements 10A and the second semiconductor elements 10B is an electronic component as a core for the function of the semiconductor device A1. The constituent material of the first semiconductor elements 10A and the second semiconductor elements 10B is, for example, a semiconductor material mainly composed of SiC (silicon carbide). The semiconductor material is not limited to SiC, and may be, for example, Si (silicon), GaN (gallium nitride) or C (diamond). Each of the first semiconductor elements 10A and the second semiconductor elements 10B is a power semiconductor chip having a switching function, such as a MOSFET (Metal Oxide Semiconductor Field Effect Transistor). The first semiconductor elements 10A and the second semiconductor elements 10B are MOSFETs in the present embodiment, but are not limited to these and may be other transistors such as IGBTs (Insulated Gate Bipolar Transistors). The first semiconductor elements 10A and the second semiconductor elements 10B are all identical with each other. Each of the first semiconductor elements 10A and the second semiconductor elements 10B is, for example, an n-channel MOSFET, but may be a p-channel MOSFET.

As shown in Figs. 14 and 15, each of the first semiconductor elements 10A and the second semiconductor elements 10B has an element obverse surface 101 and an element reverse surface 102. In each of the first semiconductor elements 10A and the second semiconductor elements 10B, the element obverse surface 101 and the element reverse surface 102 are spaced apart from each other in the z direction. The element obverse surface 101 faces the z1 side in the z direction, and the element reverse surface 102 faces the z2 side in the z direction.

In the present embodiment, the semiconductor device A1 includes four first semiconductor elements 10A and four second semiconductor elements 10B. However, the number of first semiconductor elements 10A and the number of second semiconductor elements 10B are not limited to this configuration, and may be changed as appropriate in accordance with the performance required of the semiconductor device A1. In the example shown in Figs. 8 and 9, four each of the first semiconductor elements 10A and the second semiconductor elements 10B are provided. The number of first semiconductor elements 10A and the number of second semiconductor elements 10B may be two, three, or five or more. The number of first semiconductor elements 10A and the number of second semiconductor elements 10B may be the same or may be different. The number of first semiconductor elements 10A and the number of second semiconductor elements 10B are determined based on the current capacity of the semiconductor device A1.

The semiconductor device A1 may be configured as a half-bridge type switching circuit. In this case, the first semiconductor elements 10A constitute the upper arm circuit of the semiconductor device A1, and the second semiconductor elements 10B constitute the lower arm circuit. In the upper arm circuit, the first semiconductor elements 10A are connected in parallel with each other. In the lower arm circuit, the second semiconductor elements 10B are connected in parallel with each other. Each first semiconductor element 10A and a relevant second semiconductor element 10B are connected in series to form a bridge layer.

As shown in Figs. 8, 9, and 21, each of the first semiconductor elements 10A is mounted on the first conductive portion 32A of the support substrate 3, described later. In the example shown in Figs. 8 and 9, the first semiconductor elements 10A may be aligned in the y direction and are spaced apart from each other. Each of the first semiconductor elements 10A is conductively bonded to the first conductive portion 32A via a conductive bonding material 19. With the first semiconductor elements 10A bonded to the first conductive portion 32A, the element reverse surfaces 102 face the first conductive portion 32A. Unlike the present embodiment, the first semiconductor elements 10A may be mounted on a metal member different from a part of a DBC substrate or the like. In such a case, the metal member corresponds to the first conductive portion of the present disclosure. The metal member may be supported on, for example, a DBC substrate or the like.

As shown in Figs. 8, 9, and 20, each of the second semiconductor elements 10B is mounted on the second conductive portion 32B of the support substrate 3, described later. In the example shown in Figs. 8 and 9, the second semiconductor elements 10B may be aligned in the y direction and are spaced apart from each other. Each of the second semiconductor elements 10B is conductively bonded to the second conductive portion 32B via a conductive bonding material 19. With the second semiconductor elements 10B bonded to the second conductive portion 32B, the element reverse surfaces 102 face the second conductive portion 32B. As understood from Fig. 9, the first semiconductor elements 10A and the second semiconductor elements 10B overlap with each other as viewed in the x direction. However, the first semiconductor elements and the second semiconductor elements may not overlap with each other. Unlike the present embodiment, the second semiconductor elements 10B may be mounted on a metal member different from a part of a DBC substrate or the like. In such a case, the metal member corresponds to the second conductive portion of the present disclosure. The metal member may be supported on, for example, a DBC substrate or the like.

Each of the first semiconductor elements 10A and the second semiconductor elements 10B has a first obverse-surface electrode 11, a second obverse-surface electrode 12, a third obverse-surface electrode 13, and a reverse-surface electrode 15. The configurations of the first obverse-surface electrode 11, the second obverse-surface electrode 12, the third obverse-surface electrode 13 and the reverse-surface electrode 15 described below are common to the first semiconductor elements 10A and the second semiconductor elements 10B. The first obverse-surface electrode 11, the second obverse-surface electrode 12, and the third obverse-surface electrode 13 are provided on the element obverse surface 101. The first obverse-surface electrode 11, the second obverse-surface electrode 12, and the third obverse-surface electrode 13 are insulated from each other by an insulating film, not shown. The reverse-surface electrode 15 is provided on the element reverse surface 102.

The first obverse-surface electrode 11 is, for example, a gate electrode, through which a drive signal (e.g., gate voltage) for driving the first semiconductor element 10A (the second semiconductor element 10B) is inputted. In each first semiconductor element 10A (each second semiconductor element 10B), the second obverse-surface electrode 12 is, for example, a source electrode, through which a source current flows. The second obverse-surface electrode 12 of the present embodiment has a gate finger 121. The gate finger 121 is made of, for example, a linear insulator extending in the x direction and divides the second obverse-surface electrode 12 into two parts in the y direction. The third obverse-surface electrode 13 is, for example, a source sense electrode, through which a source current flows. The reverse-surface electrode 15 is, for example, a drain electrode, through which a drain current flows. The reverse-surface electrode 15 covers the entire (or almost entire) region of the element reverse surface 102. The reverse-surface electrode 15 is formed, for example, by Ag (silver) plating.

Each of the first semiconductor elements 10A (the second semiconductor elements 10B) switches between a conducting state and a disconnected state in response to a drive signal (gate voltage) inputted to the first obverse-surface electrode 11 (the gate electrode). In the conducting state, a current flows from the reverse-surface electrode 15 (the drain electrode) to the second obverse-surface electrode 12 (the source electrode). In the disconnected state, this current does not flow. That is, each first semiconductor element 10A (each second semiconductor element 10B) performs a switching operation. The semiconductor device A1 uses the switching function of the first semiconductor elements 10A and the second semiconductor elements 10B to convert the DC voltage inputted between the single fourth terminal 44 and the two, i.e., the first and the second terminals 41 and 42 into e.g. AC voltage and outputs the AC voltage from the third terminal 43. Each of the first semiconductor elements 10A corresponds to the first switching element of the present disclosure. Each of the second semiconductor elements 10B corresponds to the second switching element of the present disclosure.

As shown in Figs. 5, 8, and 9, the semiconductor device A1 includes thermistors 17. The thermistors 17 are used as a temperature detection sensor. The semiconductor device may be configured to include, for example, temperature-sensitive diodes instead of the thermistors 17. Alternatively, the semiconductor device may not include the thermistors 17 or any other temperature sensors.

The support substrate 3 supports the first semiconductor elements 10A and the second semiconductor elements 10B. The specific configuration of the support substrate 3 is not limited. The support substrate is provided by, for example, a DBC (Direct Bonded Copper) substrate or an AMB (Active Metal Brazing) substrate. The support substrate 3 includes an insulating layer 31, a support conductor 32, and a reverse-surface metal layer 33. The support conductor 32 includes the first conductive portion 32A and the second conductive portion 32B. The dimension of the support substrate 3 in the z direction is, for example, equal to or greater than 0.4 mm and equal to or less than 3.0 mm.

The insulating layer 31 is made of, for example, a ceramic material having excellent thermal conductivity. Examples of such a ceramic material include SiN (silicon nitride). The insulating layer 31 is not limited to a ceramic material and may be, for example, a sheet of insulating resin. The insulating layer 31 is, for example, rectangular in plan view. The dimension of the insulating layer 31 in the z direction is, for example, equal to or greater than 0.05 mm and equal to or less than 1.0 mm.

The first conductive portion 32A supports the first semiconductor elements 10A, and the second conductive portion 32B supports the second semiconductor elements 10B. The first conductive portion 32A and the second conductive portion 32B are formed on the upper surface (the surface facing the z1 side in the z direction) of the insulating layer 31. The constituent material of the first conductive portion 32A and the second conductive portion 32B includes, for example, Cu (copper). The constituent material may include Al (aluminum) instead of Cu (copper). The first conductive portion 32A and the second conductive portion 32B are spaced apart from each other in the x direction. The first conductive portion 32A is located on the x1 side in the x direction with respect to the second conductive portion 32B. The first conductive portion 32A and the second conductive portion 32B are, for example, rectangular in plan view. The first conductive portion 32A and the second conductive portion 32B, together with the first conductive member 5 and the second conductive member 6, form paths for the main circuit current switched by the first semiconductor elements 10A and the second semiconductor elements 10B.

The first conductive portion 32A has a first obverse surface 301A. The first obverse surface 301A is a flat surface facing the z1 side in the z direction. The first obverse surface 301A of the first conductive portion 32A has the first semiconductor elements 10A bonded thereto via a conductive bonding material 19. The second conductive portion 32B has a second obverse surface 301B. The second obverse surface 301B is a flat surface facing the z1 side in the z direction. The second obverse surface 301B of the second conductive portion 32B has the second semiconductor elements 10B bonded thereto via a conductive bonding material 19. The constituent material of the conductive bonding material 19 is not limited, and may be solder, metal paste or sintered metal, for example. The dimension of the first conductive portion 32A and the second conductive portion 32B in the z direction is, for example, equal to or greater than 0.1 mm and equal to or less than 1.5 mm.

The reverse-surface metal layer 33 is formed on the lower surface (the surface facing the z2 side in the z direction) of the insulating layer 31. The constituent material of the reverse-surface metal layer 33 is the same as that of the support conductor 32. The reverse-surface metal layer 33 has a reverse surface 302. The reverse surface 302 is the surface facing the z2 side in the z direction. In the example shown in Fig. 11, the reverse surface 302 may be exposed from the sealing resin 8. A heat dissipating member (e.g., a heat sink), not shown, can be attached to the reverse surface 302. The reverse surface 302 may not be exposed from the sealing resin 8 and may be covered with the sealing resin 8. The reverse-surface metal layer 33 overlaps with both of the first conductive portion 32A and the second conductive portion 32B in plan view.

Each of the first terminal 41, the second terminal 42, the third terminals 43, and the fourth terminal 44 is made of a metal plate. The metal plate contains, for example, Cu (copper) or a copper alloy. In the example shown in Figs. 1 to 5, 8, 9, and 11, the semiconductor device A1 has one each of the first terminal 41, the second terminal 42 and the fourth terminal 44, and two third terminals 43. However, the number of the terminals is not limited.

The DC voltage to be converted is inputted to the first terminal 41, the second terminal 42, and the fourth terminal 44. The fourth terminal 44 is a positive electrode (P terminal), and each of the first terminal 41 and the second terminal 42 is a negative electrode (N terminal). The AC voltage converted by the first semiconductor elements 10A and the second semiconductor elements 10B is outputted from the third terminals 43. Each of the first terminal 41, the second terminal 42, the third terminals 43, and the fourth terminal 44 includes a portion covered with the sealing resin 8 and a portion exposed from the sealing resin 8.

As shown in Fig. 13, the fourth terminal 44 is conductively bonded to the first conductive portion 32A. The methods of conductive bonding are not limited, and methods such as ultrasonic bonding, laser bonding, welding, or other methods using solder, metal paste, sintered silver or the like are used as appropriate. As shown in Figs. 8 and 9, the fourth terminal 44 is located on the x1 side in the x direction with respect to the first semiconductor elements 10A and the first conductive portion 32A. The fourth terminal 44 electrically conducts to the first conductive portion 32A and electrically conducts to the reverse-surface electrode 15 (drain electrode) of each first semiconductor element 10A via the first conductive portion 32A.

The first terminal 41 and the second terminal 42 electrically conduct to the second conductive member 6. In the present embodiment, the first terminal 41 and the second conductive member 6 are integrally formed. "The first terminal 41 and the second conductive member 6 are integrally formed" means that they are formed, for example, by cutting and bending a single metal plate, and no bonding material or the like for bonding them together is included. Also, in the present embodiment, the second terminal 42 and the second conductive member 6 are integrally formed. The first terminal 41 and the second terminal 42 can have other configurations as long as they electrical conduct to the second conductive member 6, and may include bond portions where these terminals are bonded to the second conductive member, unlike the present embodiment. As shown in Figs. 5 and 8, the first terminal 41 and the second terminal 42 are located on the x1 side in the x direction with respect to the first semiconductor elements 10A and the first conductive portion 32A. The first terminal 41 and the second terminal 42 electrically conduct to the second conductive member 6 and electrically conduct to the second obverse-surface electrode 12 (source electrode) of each second semiconductor element 10B via the second conductive member 6.

As shown in Figs. 1 to 5 and 11, in the semiconductor device A1, the first terminal 41, the second terminal 42, and the fourth terminal 44 protrude from the sealing resin 8 toward the x1 side in the x direction. The first terminal 41, the second terminal 42, and the fourth terminal 44 are spaced apart from each other. The first terminal 41 and the second terminal 42 are located opposite to each other with the fourth terminal 44 interposed therebetween in the y direction. The first terminal 41 is located on the y1 side in the y direction of the fourth terminal 44, and the second terminal 42 is located on the y2 side in the y direction of the fourth terminal 44. The first terminal 41, the second terminal 42, and the fourth terminal 44 overlap with each other as viewed in the y direction.

As understood from Figs. 8, 9, and 12, the two third terminals 43 are conductively bonded to the second conductive portion 32B. The methods of conductive bonding are not limited, and methods such as ultrasonic bonding, laser bonding, welding, or other methods using solder, metal paste, sintered silver or the like are used as appropriate. As shown in Fig. 8, the two third terminals 43 are located on the x2 side in the x direction with respect to the second semiconductor elements 10B and the second conductive portion 32B. Each third terminal 43 electrically conducts to the second conductive portion 32B and electrically conducts to the reverse-surface electrode 15 (drain electrode) of each second semiconductor element 10B via the second conductive portion 32B. The number of third terminals 43 is not limited to two, and may be one, or three or more. When only one third terminal 43 is provided, the third terminal 43 is preferably connected to the middle part in the y direction of the second conductive portion 32B.

The control terminals 45 are pin-shaped terminals for controlling the first semiconductor elements 10A and the second semiconductor elements 10B. The control terminals 45 are, for example, press-fit terminals. The control terminals 45 include a plurality of first control terminals 46A to 46E and a plurality of second control terminals 47A to 47D. The first control terminals 46A to 46E are used to control the first semiconductor elements 10A, for example. The second control terminals 47A to 47D are used to control the second semiconductor elements 10B, for example.

The first control terminals 46A to 46E are spaced apart from each other in the y direction. As shown in Figs. 8, 13, and 22, the first control terminals 46A to 46E are supported on the first conductive portion 32A via the control terminal support 48 (the first support portion 48A, described later). As shown in Figs. 5 and 8, the first control terminals 46A to 46E are located between the first semiconductor elements 10A and the first, the second, and the fourth terminals 41, 42, and 44 in the x direction.

The first control terminal 46A is a terminal (a gate terminal) for inputting a drive signal for the first semiconductor elements 10A. A drive signal for driving the first semiconductor elements 10A is inputted (e.g., a gate voltage is applied) to the first control terminal 46A.

The first control terminal 46B is a terminal (a source sense terminal) for detecting a source signal of the first semiconductor elements 10A. The voltage applied to the second obverse-surface electrode 12 (the source electrode) of each first semiconductor element 10A (the voltage corresponding to the source current) is detected from the first control terminal 46B.

The first control terminal 46C and the first control terminal 46D are terminals electrically conducing to a thermistor 17.

The first control terminal 46E is a terminal (a drain sense terminal) for detecting a drain signal of the first semiconductor elements 10A. The voltage applied to the reverse-surface electrode 15 (the drain electrode) of each first semiconductor element 10A (the voltage corresponding to the drain current) is detected from the first control terminal 46E.

The second control terminals 47A to 47D are spaced apart from each other in the y direction. As shown in Figs. 8 and 13, the second control terminals 47A to 47D are supported on the second conductive portion 32B via the control terminal support 48 (the second support portion 48B, described later). As shown in Figs. 5 and 8, the second control terminals 47A to 47D are located between the second semiconductor elements 10B and the two third terminals 43 in the x direction.

The second control terminal 47A is a terminal (a gate terminal) for inputting a drive signal for the second semiconductor elements 10B. A drive signal for driving the second semiconductor elements 10B is inputted (e.g.**,** a gate voltage is applied) to the second control terminal 47A. The second control terminal 47B is a terminal (a source sense terminal) for detecting a source signal of the second semiconductor elements 10B. The voltage applied to the second obverse-surface electrode 12 (the source electrode) of each second semiconductor element 10B (the voltage corresponding to the source current) is detected from the second control terminal 47B. The second control terminal 47C and the second control terminal 47D are terminals electrically conducting to a thermistor 17.

Each of the control terminals 45 (the first control terminals 46A to 46E and the second control terminals 47A to 47E) includes a holder 451 and a metal pin 452.

The holders 451 are made of an electrically conductive material. As shown in Figs. 14 and 15, the holders 451 are bonded to the control terminal support 48 (the first metal layer 482, described later) via a conductive bonding material 459. As shown in Fig. 16, each holder 451 includes a tubular portion 453, a first flange portion 454, and a second flange portion 455.

The tubular portion 453 extends in the z direction and is, for example, cylindrical. The tubular portion 453 has a first outer side surface 453a and a first inner side surface 453b. The first outer side surface 453a faces radially outward of the tubular portion 453 as viewed in the z direction and extends in the z direction. The first inner side surface 453b faces the opposite side from the first outer side surface 453a, i.e., faces radially inward of the tubular portion 453 as viewed in the z direction and extends in the z direction.

The first flange portion 454 is connected to the end on the z1 side in the z direction of the tubular portion 453. The first flange portion 454 has a first surface 454a and a second surface 454b. The first surface 454a faces the z1 side in the z direction. The first surface 454a is located at the end on the z1 side in the z direction of the holder 451. The first surface 454a has the shape of a loop (a circular loop or a rectangular loop) as viewed in the z direction. The second surface 454b is located on the z2 side in the z direction relative to the first surface 454a and faces the z2 side in the z direction.

The second flange portion 455 is connected to the end on the z2 side in the z direction of the tubular portion 453. In the present embodiment, the second flange portion 455 is bonded to the control terminal support 48 (the first metal layer 482, described later) via a conductive bonding material 459.

A metal pin 452 is inserted in at least the first flange portion 454 and the tubular portion 453 of each holder 451. A part of the holder 451 is covered with the sealing resin 8. At least the first outer side surface 453a (tubular portion 453) is in contact with the sealing resin 8. In the example shown in Fig. 16, the entirety of the first outer side surface 453a of the tubular portion 453 and the second surface 454b of the first flange portion 454 are in contact with the sealing resin 8.

Each metal pin 452 is a bar-shaped member extending in the z direction. The metal pin 452 is supported by being press-fitted into a holder 451. The metal pin 452 electrically conducts to the control terminal support 48 (the first metal layer 482, described below) at least via the holder 451. In the example shown in Figs. 14 to 16, the metal pin 452 is not inserted to the lower end (the end on the z2 side in the z direction) of the holder 451, and the lower end of the metal pin 452 is spaced apart from the conductive bonding material 459. In this case, the metal pin 452 electrically conducts to the control terminal support 48 (the first metal layer 482) via the holder 451. In the case where the lower end of the metal pin 452 (the end on the z2 side in the z direction) is in contact with the conductive bonding material 459 within the through-hole of the holder 451 unlike the illustrated example, the metal pin 452 electrically conducts to the control terminal support 48 via the conductive bonding material 459. The metal pin 452 protrudes beyond the upper surface (the resin obverse surface 81, described later) of the sealing resin 8 toward the z1 side in the z direction.

The control terminal support 48 supports the control terminals 45. The control terminal support 48 is interposed between the first and the second obverse surfaces 301A and 301B and the control terminals 45 in the z direction.

The control terminal support 48 includes a first support portion 48A and a second support portion 48B. The first support portion 48A is disposed on the first conductive portion 32A and supports the first control terminals 46A to 46E of the control terminals 45. As shown in Fig. 14, the first support portion 48A is bonded to the first conductive portion 32A via a bonding material 49. The bonding material 49 may be electrically conductive or insulating, and may be solder, for example. The second support portion 48B is disposed on the second conductive portion 32B and supports the second control terminals 47A to 47D of the control terminals 45. As shown in Fig. 15, the second support portion 48B is bonded to the second conductive portion 32B via a bonding material 49.

The control terminal support 48 (each of the first support portion 48A and the second support portion 48B) is provided by a DBC (Direct Bonded Copper) substrate, for example. The control terminal support 48 includes an insulating layer 481, a first metal layer 482, and a second metal layer 483 laminated on top of each other.

The insulating layer 481 is made of, for example, a ceramic material. The insulating layer 481 is, for example, rectangular in plan view.

As shown in Figs. 14 and 15, the first metal layer 482 is formed on the upper surface of the insulating layer 481. Each control terminal 45 stands on the first metal layer 482. The first metal layer 482 contains, for example, Cu (copper) or a Cu (copper) alloy. As shown in Fig. 8, the first metal layer 482 includes a first portion 482A, a second portion 482B, a third portion 482C, a fourth portion 482D, a fifth portion 482E, and a sixth portion 482F. The first portion 482A, the second portion 482B, the third portion 482C, the fourth portion 482D, the fifth portion 482E, and the sixth portion 482F are spaced apart and insulated from each other.

The first portion 482A, to which a plurality of wires 71 are bonded, electrically conducts to the first obverse-surface electrodes 11 (gate electrodes) of the first semiconductor elements 10A (the second semiconductor elements 10B) via the wires 71. A plurality of wires 73 are connected to the first portion 482A and the sixth portion 482F. Thus, the sixth portion 482F electrically conducts to the first obverse-surface electrodes 11 (gate electrodes) of the first semiconductor elements 10A (the second semiconductor elements 10B) via the wires 73 and the wires 71. As shown in Fig. 8, the first control terminal 46A is bonded to the sixth portion 482F of the first support portion 48A, and the second control terminal 47A is bonded to the sixth portion 482F of the second support portion 48B.

The second portion 482B, to which a plurality of wires 72 are bonded, electrically conducts to the third obverse-surface electrodes 13 (source sense electrodes) of the first semiconductor elements 10A (the second semiconductor elements 10B) via the wires 72. As shown in Fig. 8, the first control terminal 46B is bonded to the second portion 482B of the first support portion 48A, and the second control terminal 47B is bonded to the second portion 482B of the second support portion 48B.

A thermistor 17 is bonded to the third portion 482C and the fourth portion 482D. As shown in Fig. 8, the first control terminals 46C and 46D are bonded to the third portion 482C and the fourth portion 482D, respectively, of the first support portion 48A. The second control terminals 47C and 47D are bonded to the third portion 482C and the fourth portion 482D, respectively, of the second support portion 48B.

The fifth portion 482E of the first support portion 48A, to which a wire 74 is bonded, electrically conducts to the first conductive portion 32A via the wire 74. As shown in Fig. 8, the first control terminal 46E is bonded to the fifth portion 482E of the first support portion 48A. The fifth portion 482E of the second support portion 48B does not electrically conduct to other components. Each of the wires 71 to 74 is, for example, a bonding wire. The constituent material of the wires 71 to 74 includes, for example, one of Au (gold), Al (aluminum) or Cu (copper).

As shown in Figs. 14 and 15, the second metal layer 483 is formed on the lower surface of the insulating layer 481. As shown in Fig. 14, the second metal layer 483 of the first support portion 48A is bonded to the first conductive portion 32A via a bonding material 49. As shown in Fig. 15, the second metal layer 483 of the second support portion 48B is bonded to the second conductive portion 32B via a bonding material 49.

The first conductive member 5 and the second conductive member 6, together with the first conductive portion 32A and the second conductive portion 32B, constitute a path for the main circuit current switched by the first semiconductor elements 10A and the second semiconductor elements 10B. The first conductive member 5 and the second conductive member 6 are spaced apart from first obverse surface 301A and the second obverse surface 301B to the z1 side in the z direction and overlap with the first obverse surface 301A and the second obverse surface 301B in plan view. In the present embodiment, the first conductive member 5 and the second conductive member 6 are made of metal plates. The metal includes, for example, Cu (copper) or a Cu (copper) alloy. Specifically, the first conductive member 5 and the second conductive member 6 are metal plates that are bent as appropriate.

The first conductive member 5 is connected to the second obverse-surface electrode 12 (the source electrode) of each first semiconductor element 10A and the second conductive portion 32B to electrically conduct the second obverse-surface electrode 12 of each first semiconductor element 10A and the second conductive portion 32B. The first conductive member 5 constitutes a path for the main circuit current switched by the first semiconductor elements 10A. As shown in Figs. 7 and 8, the first conductive member 5 includes a main portion 51, a plurality of first bond portions 52, and a plurality of second bond portions 53.

The main portion 51 is located between the first semiconductor elements 10A and the second conductive portion 32B in the x direction and has a strip shape extending in the y direction in plan view. The main portion 51 overlaps with both of the first conductive portion 32A and the second conductive portion 32B in plan view and is spaced apart from the first obverse surface 301A and the second obverse surface 301B to the z1 side in the z direction. As shown in Fig. 18, the main portion 51 is located on the z2 side in the z direction with respect to the third path portion 66 and the fourth path portion 67 of the second conductive member 6, described later, and located closer to the first obverse surface 301A and the second obverse surface 301B than are the third path portion 66 and the fourth path portion 67.

In the present embodiment, the main portion 51 is parallel to the first obverse surface 301A and the second obverse surface 301B.

As shown in Fig. 8, the main portion 51 extends continuously in the y direction to correspond to the areas in which the first semiconductor elements 10A are arranged. In the present embodiment, the main portion 51 is formed with a plurality of first openings 514 as shown in Figs. 7, 8, and 13. Each of the first openings 514 is a through-hole penetrating, for example, in the z direction (the plate thickness direction of the main portion 51). The first openings 514 are arranged at intervals in the y direction. The first openings 514 are provided to correspond to the first semiconductor elements 10A, respectively. In the present embodiment, four first openings 514 are provided in the main portion 51, and these first openings 514 and the plurality of (four) first semiconductor elements 10A are at the same positions in the y direction.

In the present embodiment, each of the first openings 514 overlaps with the gap between the first conductive portion 32A and the second conductive portion 32B in plan view as shown in Figs. 8 and 13. The first openings 514 are formed to facilitate the flow of the resin material between the upper side (z1 side in the z direction) and the lower side (z2 side in the z direction) at or near the main portion 51 (the first conductive member 5) when the flowable resin material is injected to form the sealing resin 8.

As shown in Fig. 8, the first bond portions 52 and the second bond portions 53 are connected to the main portion 51 and disposed to correspond to the first semiconductor elements 10A. Specifically, each of the first bond portions 52 is located on the x1 side in the x direction with respect to the main portion 51. Each of the second bond portions 53 is located on the x2 side in the x direction with respect to the main portion 51. As shown in Fig. 14, each of the first bond portions 52 and the second obverse-surface electrode 12 of a relevant one of the first semiconductor elements 10A are bonded via a conductive bonding material 59. Each of the second bond portions 53 and the second conductive portion 32B are bonded via a conductive bonding material 59. The constituent material of the conductive bonding materials 59 is not particularly limited, and may be solder, metal paste or sintered metal, for example. In the present embodiment, each of the first bond portions 52 has two parts separated in the y direction. These two parts are bonded to the second obverse-surface electrode 12 of the first semiconductor element 10A to flank the gate finger 121 of the second obverse-surface electrode 12 in the y direction.

The second conductive member 6 electrically conducts the second obverse-surface electrode 12 (source electrode) of each second semiconductor element 10B and the first and the second terminals 41 and 42. The second conductive member 6 is integrally formed with the first terminal 41 and the second terminal 42. The second conductive member 6 constitutes a path for the main circuit current switched by the second semiconductor elements 10B. As shown in Figs. 5 to 7, 12, 13, and 18 to 22, the second conductive member 6 includes a plurality of third bond portions 61, a first path portion 64, a second path portion 65, a plurality of third path portions 66, and a fourth path portion 67. Also, in the illustrated example, the second conductive member 6 includes a first stepped portion 602 and a second stepped portion 603.

The third bond portions 61 are individually bonded to the second semiconductor elements 10B. Each of the third bond portions 61 and the second obverse-surface electrode 12 of a relevant second semiconductor element 10B are bonded via a conductive bonding material 69. The constituent material of the conductive bonding materials 69 is not particularly limited, and may be solder, metal paste or sintered metal, for example. In the present embodiment, each third bond portion 61 has two flat sections 611 and two first inclined sections 612.

The two flat sections 611 are aligned in the y direction. The two flat sections 611 are spaced apart from each other in the y direction. The shape of the flat sections 611 is not limited, but is rectangular in the illustrated example. The two flat sections are bonded to the second obverse-surface electrode 12 of the second semiconductor element 10B to flank the gate finger 121 of the second obverse-surface electrode 12 in the y direction.

The two first inclined sections 612 are connected to the outer edges of the two flat sections 611 in the y direction. That is, the first inclined section 612 located on the y1 side in the y direction is connected to the edge on the y1 side in the y direction of the flat section 611 located on the y1 side in the y direction. Also, the first inclined section 612 located on the y2 side in the y direction is connected to the edge on the y2 side in the y direction of the flat section 611 located on the y2 side in the y direction. Each first inclined section 612 is inclined to extend toward the z1 side in the z direction as it becomes farther away from the flat section 611 in the y direction.

The first path portion 64 is interposed between the third bond portions 61 and the first terminal 41. In the illustrated example, the first path portion 64 is connected to the first terminal 41 via the first stepped portion 602. The first path portion 64 overlaps with the first conductive portion 32A in plan view. The first path portion 64 has a shape extending in the x direction as a whole.

The first path portion 64 includes a first strip portion 641 and a first extension portion 643. The first strip portion 641 is located on the x2 side in the x direction with respect to the first terminal 41 and is generally parallel to the first obverse surface 301A. The first strip portion 641 has a shape extending in the x direction as a whole. In the illustrated example, the first strip portion 641 has a recess 649. The recess 649 is the portion where a part of the first strip portion 641 is recessed toward the y1 side in the y direction. In Figs. 5 and 7, the first conductive portion 32A is visible through the recess 649.

The first extension portion 643 extends toward the z2 side in the z direction from the side edge of the first strip portion 641 on the y1 side in the y direction. The first extension portion 643 is spaced apart from the first conductive portion 32A. In the illustrated example, the first extension portion 643 extends along the z direction and has a rectangular shape elongated in the x direction. Incidentally, the first path portion 64 may not have the first extension portion 643.

The second path portion 65 is interposed between the third bond portions 61 and the second terminal 42. In the illustrated example, the second path portion 65 is connected to the second terminal 42 via the second stepped portion 603. The second path portion 65 overlaps with the first conductive portion 32A in plan view. The second path portion 65 has a shape extending in the x direction as a whole.

The second path portion 65 includes a second strip portion 651 and a second extension portion 653. The second strip portion 651 is located on the x2 side in the x direction with respect to the second terminal 42 and is generally parallel to the first obverse surface 301A. The second strip portion 651 has a shape extending in the x direction as a whole. In the illustrated example, the second strip portion 651 has a recess 659. The recess 659 is the portion where a part of the second strip portion 651 is recessed toward the y2 side in the y direction. In Figs. 5 and 7, the first conductive portion 32A is visible through the recess 659.

The second extension portion 653 extends toward the z2 side in the z direction from the side edge of the second strip portion 651 on the y2 side in the y direction. The second extension portion 653 is spaced apart from the first conductive portion 32A. As with the first extension portion 643, the second extension portion 653 extends along the z direction and has a rectangular shape elongated in the x direction. Incidentally, the second path portion 65 may not have the second extension portion 653.

The third path portions 66 are individually connected to the third bond portions 61. The third path portions 66, each extending in the x direction, are spaced apart from each other in the y direction. The number of third path portions 66 is not limited. In the illustrated example, five third path portions 66 are disposed. Each of the third path portions 66 is disposed to be located between the second semiconductor elements 10B in the y direction or on the outer side of the second semiconductor elements 10B in the y direction.

The two third path portions 66 located on opposite outer sides in the y direction are formed with recesses 669. The recesses 669 are recessed from the inner side toward the outer side in the y direction. In the illustrated example, one recess 669 is formed in each of the two third path portions 66. In Figs. 5 and 7, the second conductive portion 32B is visible through the recesses 669.

In the present embodiment, one third bond portion 61 is disposed between two adjacent third path portions 66 in the y direction. In each third bond portion 61, the first inclined section 612 located on the y1 side in the y direction is connected to one of the two third path portions 66 adjacent in the y direction that is located on the y1 side in the y direction. In each third bond portion 61, the first inclined section 612 located on the y2 side in the y direction is connected to one of the two third path portions 66 adjacent in the y direction that is located on the y2 side in the y direction.

The fourth path portion 67 is connected to the ends on the x1 side in the x direction of the plurality of third path portions 66. The fourth path portion 67 has a shape elongated in the y direction. The fourth path portion 67 is connected to the ends on the x2 side in the x direction of the first strip portion 641 of the first path portion 64 and the second strip portion 651 of the second path portion 65. In the illustrated example, the first path portion 64 is connected to the end on the y1 side in the y direction of the fourth path portion 67. The second path portion 65 is connected to the end on the y2 side in the y direction of the fourth path portion 67.

The sealing resin 8 covers the first semiconductor elements 10A, the second semiconductor elements 10B, the support substrate 3 (excluding the reverse surface 302), a part of each of the first terminal 41, the second terminal 42, the third terminals 43 and the fourth terminal 44, a part of each of the control terminals 45, the control terminal support 48, the first conductive member 5, the second conductive member 6, and the wires 71 to 74. The sealing resin 8 is made of, for example, black epoxy resin. The sealing resin 8 is formed by, for example, molding. The sealing resin 8 has dimensions of, for example, about 35 mm to 60 mm in the x direction, about 35 mm to 50 mm in the y direction, and about 4 mm to 15 mm in the z direction. These dimensions are the size of the largest portion along each direction. The sealing resin 8 has a resin obverse surface 81, a resin reverse surface 82, and a plurality of resin side surfaces 831 to 834.

As shown in Figs. 10, 12, and 20, the resin obverse surface 81 and the resin reverse surface 82 are spaced apart from each other in the z direction. The resin obverse surface 81 faces the z1 side in the z direction, and the resin reverse surface 82 faces the z2 side in the z direction. The metal pins 452 of the control terminals 45 (the first control terminals 46A to 46E and the second control terminals 47A to 47D) protrude from the resin obverse surface 81. As shown in Fig. 11, the resin reverse surface 82 has a frame shape surrounding the reverse surface 302 of the support substrate 3 (the lower surface of the reverse-surface metal layer 33) in plan view. The reverse surface 302 of the support substrate 3 is exposed at the resin reverse surface 82 and may be flush with the resin reverse surface 82. Each of the resin side surfaces 831 to 834 is connected to the resin obverse surface 81 and the resin reverse surface 82 and disposed between these surfaces in the z direction. As shown in Fig. 4, the resin side surface 831 and the resin side surface 832 are spaced apart from each other in the x direction. The resin side surface 831 faces the x2 side in the x direction, and the resin side surface 832 faces the x1 side in the x direction. The two third terminals 43 protrude from the resin side surface 831, and the first terminal 41, the second terminal 42 and the fourth terminal 44 protrude from the resin side surface 832. As shown in Fig. 4, the resin side surface 833 and the resin side surface 834 are spaced apart from each other in the y direction. The resin side surface 833 faces the y2 side in the y direction, and the resin side surface 834 faces the y1 side in the y direction.

In the present embodiment, the resin obverse surface 81 is formed with a plurality of first recesses 810, as shown in Figs. 1, 4, 13, and 22. Each of the first recesses 810 is recessed from the resin obverse surface 81 toward the z2 side in the z direction. The first recesses 810 are provided correspondingly to the control terminals 45.

As shown in Figs. 16 and 17, the first recess 810 overlaps with the entirety of the tubular portion 453 of the holder 451 in plan view. In the illustrated example, the first recess 810 has a recess inner side surface 811 and a recess bottom surface 812. The recess inner side surface 811 is connected to the resin obverse surface 81 and extends toward the z2 side in the z direction. In the illustrated example, the cross section of the recess inner side surface 811 that is orthogonal to the z direction is circular. The recess bottom surface 812, which is connected to the end on the z2 side in the z direction of the recess inner side surface 811, is a flat surface facing the z1 side in the z direction.

The recess bottom surface 812 surrounds the first surface 454a of the holder 451 (the first flange portion 454) in plan view. The first surface 454a and the recess bottom surface 812 are flush with each other. The first recess 810 having such a configuration is a trace of forming the sealing resin 8 by molding while pressing the upper end (first flange portion 454) of the holder 451 with a pin or the like having a shape corresponding to first recess 810, for example. In each of the variations described later as well, the first recess 810 is a trace from the molding process. The first flange portion 454 is located on the z2 side in the z direction with respect to the resin obverse surface 81. As shown in Fig. 16, the first outer side surface 453a of the tubular portion 453 and the second surface 454b of the first flange portion 454 are both entirely in contact with the sealing resin 8. In contrast, the first inner side surface 453b of the tubular portion 453 and the first surface 454a of the first flange portion 454 are exposed from the sealing resin 8. In the example shown in Figs. 16 and 17, the first recess 810 overlaps with the entirety of the first flange portion 454 as viewed in the z direction. Thus, the diameter (the maximum value of the inner diameter) of the first recess 810 is larger than the outer diameter of the first flange portion 454.

The first surface 454a, which is flush with the recess bottom surface 812, is located at a position different from the resin obverse surface 81 in the z direction. Specifically, the first surface 454a is located on the z2 side in the z direction with respect to the resin obverse surface 81. In the present embodiment, the first dimension L1, which is the distance between the resin obverse surface 81 and the first surface 454a in the z direction, is smaller than the second dimension L2, which is the length of the holder 451 in the z direction. Preferably, the ratio of the distance in the z direction between the resin obverse surface 81 and the first surface 454a (the first dimension L1) to the length of holder 451 in the z direction (the second dimension L2) is equal to or greater than 1/3.

Although the recess inner side surface 811 is cylindrical in the example shown in Figs. 16 and 17, the recess inner side surface may have a draft angle for molding. When the recess inner side surface 811 has a draft angle, the recess inner side surface 811 is inclined to form a conical shape having an inner diameter decreasing toward the z2 side in the z direction. The draft angle of the recess inner side surface 811 may be set appropriately in the range of 0° to 30°, for example. In the case where the recess inner side surface 811 is conically inclined, when the inclination angle is relatively large, the inner diameter of the lower end (the end on the z2 side in the z direction) of the recess inner side surface 811 can be smaller than the outer diameter of the first flange portion 454. In such a case, the above-described recess bottom surface 812 is not formed. In this case, the lower end of the recess inner side surface 811 is in contact with the first surface 454a and forms a recess end edge.

As shown in Fig 4, the resin side surface 832 is formed with a plurality of recesses 832a. Each recess 832a is a portion recessed in the x direction in plan view. The recesses 832a include one formed between the first terminal 41 and the fourth terminal 44 and one formed between the second terminal 42 and the fourth terminal 44 in plan view. The recesses 832a are provided to increase the creepage distance between the first terminal 41 and the fourth terminal 44 along the resin side surface 832 and the creepage distance between the second terminal 42 and the fourth terminal 44 along the resin side surface 832.

As shown in Figs. 1, 12, and 13, the sealing resin 8 has a plurality of protrusions 851. The protrusions 851 protrude from the resin obverse surface 81 toward the z1 side in the z direction. The protrusions 851 are disposed at four corners of the sealing resin 8 in plan view. Each protrusion 851 has a protrusion end surface 851a at its extremity (the end on the z1 side in the z direction). The protrusion end surfaces 851a of the protrusions 851 are parallel (or generally parallel) to the resin obverse surface 81 and located on the same plane (x-y plane). Each protrusion 851 may have the shape of a hollow conical frustum with a bottom, for example. The protrusions 851 are used as spacers when the semiconductor device A1 is mounted on a control circuit board or the like of a device configured to use the power produced by the semiconductor device A1. Each of the protrusions 851 has a recess 851b and an inner wall surface 851c formed around the recess 851b. The shape of each protrusion 851 may be columnar, and preferably cylindrical. The shape of the recess 851b may be cylindrical. The inner wall surface 851c may preferably have the shape of a single perfect circle in plan view.

The semiconductor device A1 may be mechanically fixed to a control circuit board or the like by screwing, for example. In such a case, female threads can be formed on the inner wall surfaces 851c of the recesses 851b of the protrusions 851. Insert nuts may be embedded in the recesses 851b of the protrusions 851.

Next, the effects of the present embodiment will be described.

Each of the holders 451 constituting the control terminals 45 has the first surface 454a and the first outer side surface 453a. The first surface 454a is located at the end on the z1 side in the z direction of the holder 451. The first surface 454a is located at a position different from the resin obverse surface 81 in the z direction. The first outer side surface 453a extends in the z direction and is in contact with the sealing resin **8.** The metal pins 452 constituting the control terminals 45 protrude beyond the resin obverse surface 81 toward the z1 side in the z direction. With such a configuration, the control terminals 45 are located in the regions surrounded by the resin obverse surface 81 (sealing resin 8) in plan view. The semiconductor device A1 having such a configuration allows reduction in size in plan view. Further, the first surface 454a is located at a position different from the resin obverse surface 81 in the z direction. Such a configuration increases the creepage distance between adjacent control terminals 45 along the surfaces (resin obverse surface 81, etc.) of the sealing resin 8. Thus, the semiconductor device A1 is suitable for increasing the withstand voltage of adjacent control terminals 45 while reducing the size in plan view.

The holder 451 includes the tubular portion 453 extending in the z direction and the first flange portion 454 connected to the end on the z1 side in the z direction of the tubular portion 453. The first flange portion 454 has the first surface 454a facing toward the z1 side in the z direction. The sealing resin 8 has the first recess 810. The first recess 810 is recessed from the resin obverse surface 81 toward the z1 side in the z direction. The first flange portion 454 is located on the z2 side in the z direction with respect to the resin obverse surface 81. The sealing resin 8 having the first recess 810 allows the first surface 454a (the first flange portion 454) to be appropriately located at a position different from the resin obverse surface 81 in the z direction.

Further, the first recess 810 overlaps with the entirety of the tubular portion 453 in plan view (as viewed in the z direction) . With such a configuration, when the metal pin 452 is press-fitted into the holder 451, it is possible to insert the metal pin 452 into the holder 451 (tubular portion 453) while advancing the lower end of the metal pin 452 through the first recess 810. This facilitates the press-fitting work.

The first recess 810 has the recess inner side surface 811 and the recess bottom surface 812. The recess bottom surface 812 faces the z1 side in the z direction and surrounds the first surface 454a in the z direction. The entirety of the first surface 454a is exposed from the sealing resin 8. With such a configuration, the first surface 454a (first flange portion 454), which is surrounded by the recess bottom surface 812, is clearly visible in plan view. This facilitates the work of press-fitting the metal pin 452 into the holder 451. Further, the configuration in which the recess bottom surface 812 of the first recess 810 surrounds the first surface 454a (the first flange portion 454) in plan view can increase the creepage distance between adjacent control terminals 45 along the surfaces of the sealing resin 8. This is favorable for increasing the withstand voltage of adjacent control terminals 45.

The distance between the resin obverse surface 81 and the first surface 454a in the z direction (the first dimension L1) is smaller than the length of the holder 451 in the z direction (the second dimension L2). The ratio of the distance in the z direction between the resin obverse surface 81 and the first surface 454a (the first dimension L1) to the length of holder 451 in the z direction (the second dimension L2) is, for example, equal to or greater 50%. Such a configuration makes it possible to increase the creepage distance between adjacent control terminals 45 along the surfaces of the sealing resin 8 while avoiding an increase in the dimension of the sealing resin 8 in the z direction.

### First variation of the first embodiment (First aspect):

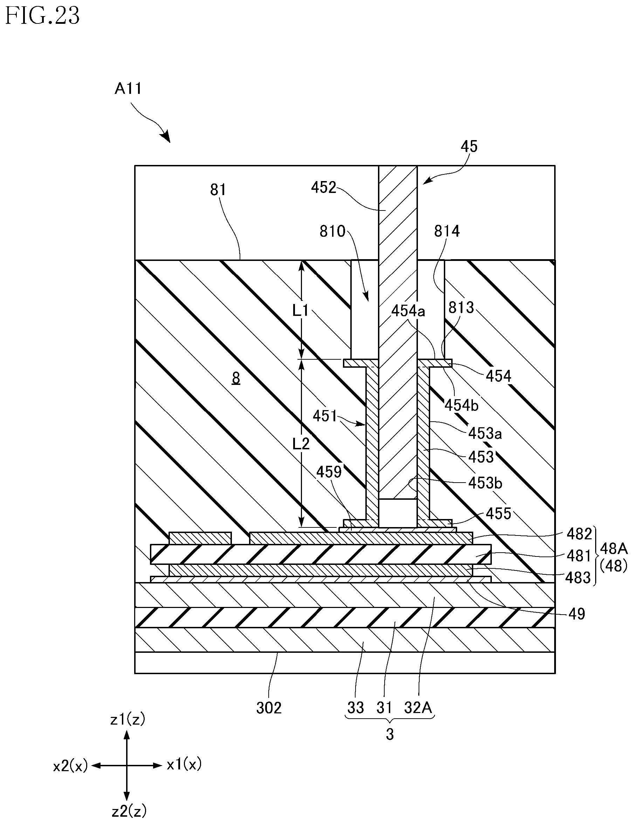

Fig. 23 shows a semiconductor device according to a first variation of the first embodiment. Fig. 23 is an enlarged sectional view corresponding to Fig. 16, showing relevant portions of the semiconductor device A11 of the present variation. In Figs. 23 to 29, the elements that are identical or similar to those of the semiconductor device A1 of the above-described embodiment are denoted by the same reference signs as those used for the above-described embodiment, and the descriptions thereof are omitted. Various parts of variations and embodiments may be selectively used in any appropriate combination as long as it is technically compatible.

The semiconductor device A11 of the present variation differs from the semiconductor device A1 of the above-described embodiment in the configuration of the first recesses 810. In the semiconductor device A11, each first recess 810 has a recess end edge 813 and a cylindrical inner side surface 814. The cylindrical inner side surface 814 has a cylindrical shape extending from the resin obverse surface 81 toward the z2 side in the z direction. The recess end edge 813 is located at the lower end (the end on the z2 side in the z direction) of the cylindrical inner side surface 814. The recess end edge 813 is in contact with the first surface 454a. In the present variation, the recess end edge 813 is in contact with the first surface 454a at a radially intermediate position. A radially outer portion of the first surface 454a is covered with the sealing resin 8, and the remaining radially inner portion is exposed from the sealing resin 8. The outer periphery of the first flange portion 454 surrounds the first recess 810 in plan view. That is, the diameter (the maximum value of the inner diameter) of the first recess 810 is smaller than the outer diameter of the first flange portion 454. Although the cylindrical inner side surface 814 is cylindrical in the example shown in Fig. 23, the cylindrical inner side surface 814 may have a draft angle. When the cylindrical inner side surface 814 has a draft angle, the cylindrical inner side surface 814 is inclined to form a conical shape having an inner diameter decreasing toward the z2 side in the z direction.

In the semiconductor device A11 of the present variation, each of the holders 451 constituting the control terminals 45 has the first surface 454a and the first outer side surface 453a. The first surface 454a is located at the end on the z1 side in the z direction of the holder 451. The first surface 454a is located at a position different from the resin obverse surface 81 in the z direction. The first outer side surface 453a extends in the z direction and is in contact with the sealing resin **8.** The metal pins 452 constituting the control terminals 45 protrude beyond the resin obverse surface 81 toward the z1 side in the z direction. With such a configuration, the control terminals 45 are located in the regions surrounded by the resin obverse surface 81 (sealing resin 8) in plan view. The semiconductor device A11 having such a configuration allows reduction in size in plan view. Further, the first surface 454a is located at a position different from the resin obverse surface 81 in the z direction. Such a configuration increases the creepage distance between adjacent control terminals 45 along the surfaces (resin obverse surface 81, etc.) of the sealing resin 8. Thus, the semiconductor device A11 is suitable for increasing the withstand voltage of adjacent control terminals 45 while reducing the size in plan view. In addition, a configuration in common with the semiconductor device A1 of the above-described embodiment provides the same effects as the above-described embodiment.

### Second variation of the first embodiment (First aspect):

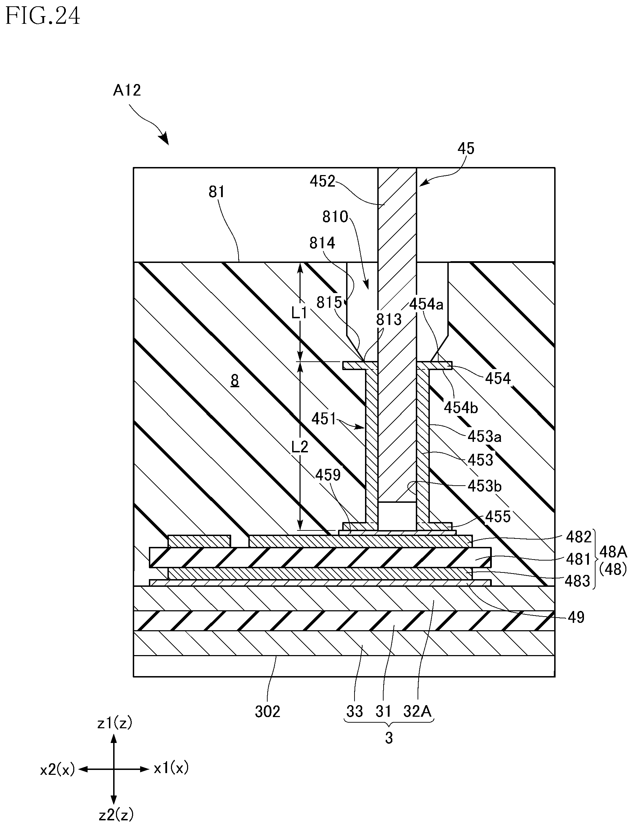

Fig. 24 shows a semiconductor device according to a second variation of the first embodiment. Fig. 24 is an enlarged sectional view corresponding to Fig. 16, showing relevant portions of the semiconductor device A12 of the present variation. The semiconductor device A12 of the present variation differs from the semiconductor device A1 of the above-described embodiment in the configuration of the first recesses 810.

Each of the first recesses 810 has a recess end edge 813, a cylindrical inner side surface 814, and a tapered inner side surface 815. The cylindrical inner side surface 814 has a cylindrical shape extending from the resin obverse surface 81 toward the z2 side in the z direction. The tapered inner side surface 815 is connected to the lower end (the end on the z2 side in the z direction) of the cylindrical inner side surface 814. The recess end edge 813 is located at the lower end (the end on the z2 side in the z direction) of the tapered inner side surface 815. The tapered inner side surface 815 is inclined such that the inner diameter increases toward the z1 side in the z direction. The recess end edge 813 is in contact with the first surface 454a. In the present variation, the recess end edge 813 is in contact with the first surface 454a at a radially intermediate position. A radially outer portion of the first surface 454a is covered with the sealing resin 8, and the remaining radially inner portion is exposed from the sealing resin **8.** The outer periphery of the first flange portion 454 surrounds the first recess 810 in plan view.

In the semiconductor device A12 of the present variation, each of the holders 451 constituting the control terminals 45 has the first surface 454a and the first outer side surface 453a. The first surface 454a is located at the end on the z1 side in the z direction of the holder 451. The first surface 454a is located at a position different from the resin obverse surface 81 in the z direction. The first outer side surface 453a extends in the z direction and is in contact with the sealing resin **8.** The metal pins 452 constituting the control terminals 45 protrude beyond the resin obverse surface 81 toward the z1 side in the z direction. With such a configuration, the control terminals 45 are located in the regions surrounded by the resin obverse surface 81 (sealing resin 8) in plan view. The semiconductor device A12 having such a configuration allows reduction in size in plan view. Further, the first surface 454a is located at a position different from the resin obverse surface 81 in the z direction. Such a configuration increases the creepage distance between adjacent control terminals 45 along the surfaces (resin obverse surface 81, etc.) of the sealing resin 8. Thus, the semiconductor device A12 is suitable for increasing the withstand voltage of adjacent control terminals 45 while reducing the size in plan view.

The recess end edge 813 of the first recess 810, which is located on the z2 side in the z direction, is in contact with the first surface 454a of the first flange portion 454. Further, the first recess 810 has the tapered inner side surface 815 connected to the recess end edge 813, and the inner diameter of the tapered inner side surface 815 increases toward the z1 side in the z direction. With such a configuration, when the metal pin 452 is press-fitted into the holder 451, the metal pin 452 advanced into the first recess 810 can be guided by the tapered inner side surface 815 toward the holder 451 (tubular portion 453). This facilitates the work of press-fitting the metal pin 452 into the holder 451. In addition, a configuration in common with the semiconductor device A1 of the above-described embodiment provides the same effects as the above-described embodiment.

### Third variation of the first embodiment (First aspect):

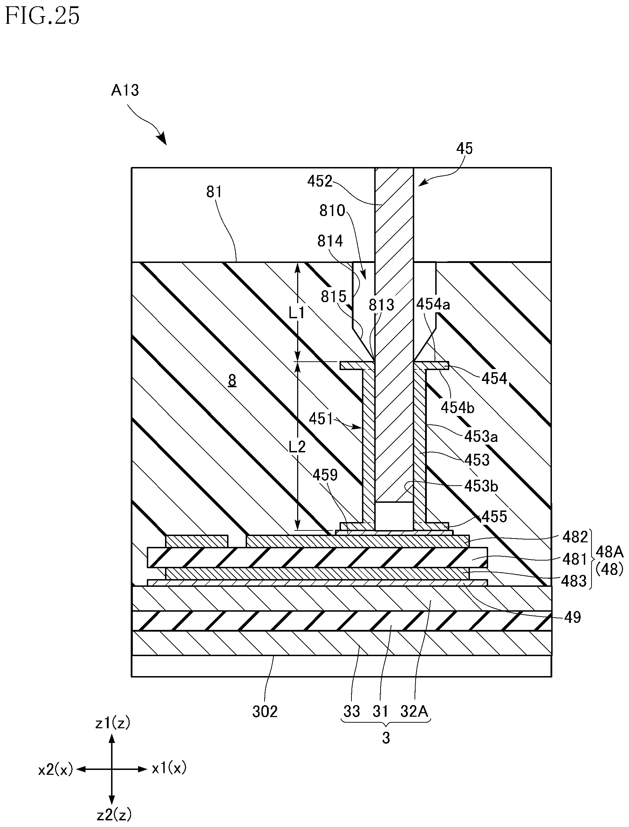

Fig. 25 shows a semiconductor device according to a third variation of the first embodiment. Fig. 25 is an enlarged sectional view corresponding to Fig. 16, showing relevant portions of the semiconductor device A13 of the present variation. The semiconductor device A13 of the present variation differs from the semiconductor device A1 of the above-described embodiment in the configuration of the first recesses 810.

Each of the first recesses 810 has a recess end edge 813, a cylindrical inner side surface 814, and a tapered inner side surface 815. In the present variation, the shapes of the cylindrical inner side surface 814 and the tapered inner side surface 815 in the longitudinal section are the same as those of the semiconductor device A12 shown in Fig. 24. In the present variation, the recess end edge 813 is in contact with the radially inward edge of the first surface 454a. Therefore, the entirety (or almost entirety) of the first surface 454a is covered with the sealing resin 8. The outer periphery of the first flange portion 454 surrounds the first recess 810 in plan view.

In the semiconductor device A13 of the present variation, each of the holders 451 constituting the control terminals 45 has the first surface 454a and the first outer side surface 453a. The first surface 454a is located at the end on the z1 side in the z direction of the holder 451. The first surface 454a is located at a position different from the resin obverse surface 81 in the z direction. The first outer side surface 453a extends in the z direction and is in contact with the sealing resin **8.** The metal pins 452 constituting the control terminals 45 protrude from the resin obverse surface 81 toward the z1 side in the z direction. With such a configuration, the control terminals 45 are located in the regions surrounded by the resin obverse surface 81 (sealing resin 8) in plan view. The semiconductor device A13 having such a configuration allows reduction in size in plan view. Further, the first surface 454a is located at a position different from the resin obverse surface 81 in the z direction. Such a configuration increases the creepage distance between adjacent control terminals 45 along the surfaces (resin obverse surface 81, etc.) of the sealing resin 8. Thus, the semiconductor device A13 is suitable for increasing the withstand voltage of adjacent control terminals 45 while reducing the size in plan view.

The recess end edge 813 of the first recess 810, which is located on the z2 side in the z direction, is in contact with the first surface 454a of the first flange portion 454. Further, the first recess 810 has the tapered inner side surface 815 connected to the recess end edge 813, and the inner diameter of the tapered inner side surface 815 increases toward the z1 side in the z direction. With such a configuration, when the metal pin 452 is press-fitted into the holder 451, the metal pin 452 advanced into the first recess 810 can be guided by the tapered inner side surface 815 toward the holder 451 (tubular portion 453). Further, in the present variation, the recess end edge 813 is in contact with the radially inward edge of the first surface 454a. With such a configuration, when the metal pin is press-fitted into the holder 451, the metal pin 452 advanced into the first recess 810 can be reliably directed to the holder 451 (tubular portion 453). This further facilitates the work of press-fitting the metal pin 452 into the holder 451. In addition, a configuration in common with the semiconductor device A1 of the above-described embodiment provides the same effects as the above-described embodiment.

### Fourth variation of the first embodiment (First aspect):

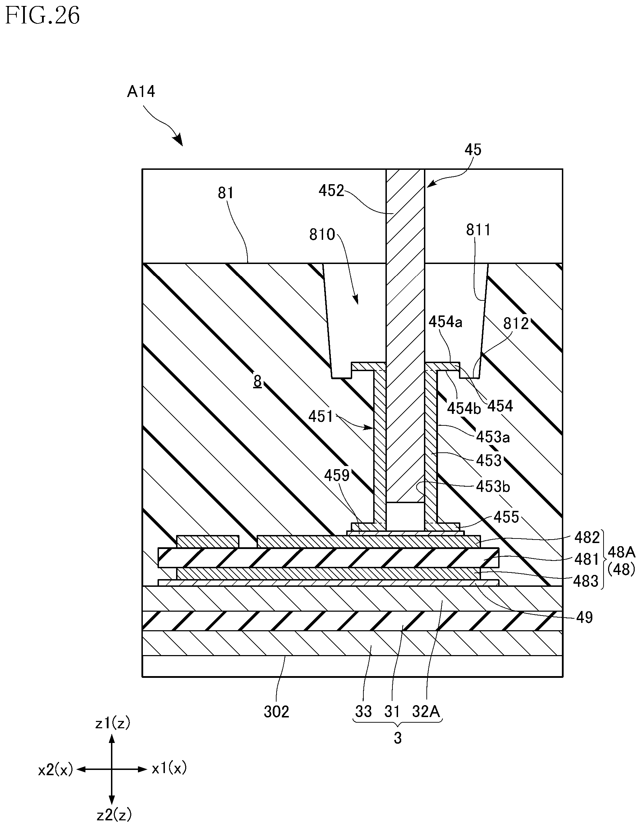

Fig. 26 shows a semiconductor device according to a fourth variation of the first embodiment. Fig. 26 is an enlarged sectional view corresponding to Fig. 16, showing relevant portions of the semiconductor device A14 of the present variation. The semiconductor device A14 of the present variation differs from the semiconductor device A1 of the above-described embodiment in the configuration of the first recesses 810.

Each of the first recesses 810 has the recess inner side surface 811 and the recess bottom surface 812. In the example shown in Fig. 26, the recess inner side surface 811 is inclined to form a conical shape having an inner diameter decreasing toward the z2 side in the z direction. The recess bottom surface 812, which is connected to the end on the z2 side in the z direction of the recess inner side surface 811, is a flat surface facing toward the z1 side in the z direction. The recess bottom surface 812 surrounds the first surface 454a of the holder 451 (the first flange portion 454) in plan view. In the present variation, the recess bottom surface 812 is located on the z2 side in the z direction relative to the first surface 454a. Therefore, the first surface 454a and the recess bottom surface 812 are not flush with each other but located at different positions in the z direction. In the example shown in Fig. 26, the outer periphery of the first flange portion 454 is exposed from the sealing resin 8.

In the semiconductor device A14 of the present variation, each of the holders 451 constituting the control terminals 45 has the first surface 454a and the first outer side surface 453a. The first surface 454a is located at the end on the z1 side in the z direction of the holder 451. The first surface 454a is located at a position different from the resin obverse surface 81 in the z direction. The first outer side surface 453a extends in the z direction and is in contact with the sealing resin **8.** The metal pins 452 constituting the control terminals 45 protrude beyond the resin obverse surface 81 toward the z1 side in the z direction. With such a configuration, the control terminals 45 are located in the regions surrounded by the resin obverse surface 81 (sealing resin 8) in plan view. The semiconductor device A14 having such a configuration allows reduction in size in plan view. Further, the first surface 454a is located at a position different from the resin obverse surface 81 in the z direction. Such a configuration increases the creepage distance between adjacent control terminals 45 along the surfaces (resin obverse surface 81, etc.) of the sealing resin 8. Thus, the semiconductor device A14 is suitable for increasing the withstand voltage of adjacent control terminals 45 while reducing the size in plan view. In addition, a configuration in common with the semiconductor device A1 of the above-described embodiment provides the same effects as the above-described embodiment.

### Fifth variation of the first embodiment (First aspect):

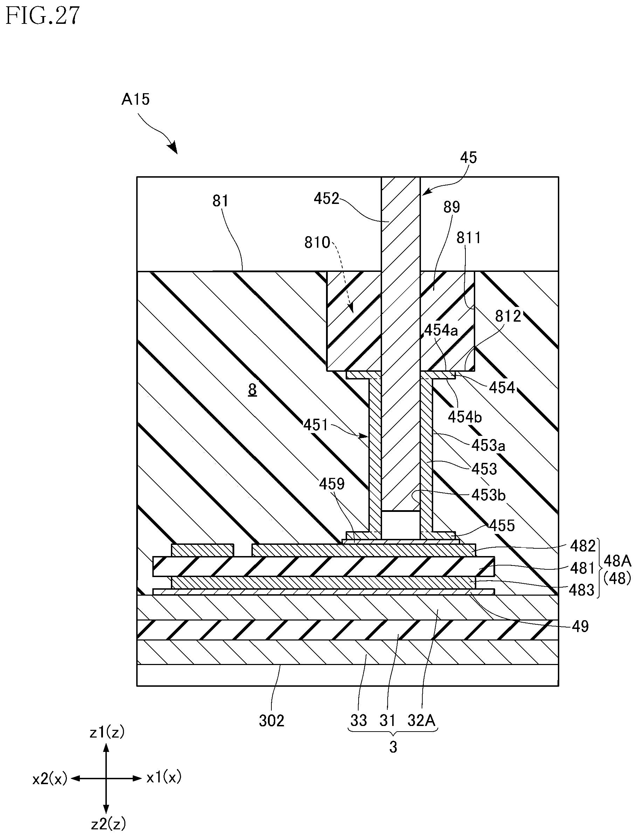

Fig. 27 shows a semiconductor device according to a fifth variation of the first embodiment. Fig. 27 is an enlarged sectional view corresponding to Fig. 16, showing relevant portions of the semiconductor device A15 of the present variation. The semiconductor device A15 of the present variation further includes first resin fill portions 89.

In the present variation, the first resin fill portions 89 are loaded into the first recesses 810 to fill the first recesses 810. The resin fill portions 88 may be made of an epoxy resin as with the sealing resin 8, but may be made of a material different from the sealing resin 8. The present variation prevents foreign matter (including moisture) from entering the first recesses 810, which are exposed from the sealing resin 8. The semiconductor device A15 having the above-described configuration is favorable for increasing the durability and the reliability. In addition, the semiconductor device A15 has the same effects as those of the semiconductor device A1 of the above-described embodiment.

### Second embodiment (First aspect):

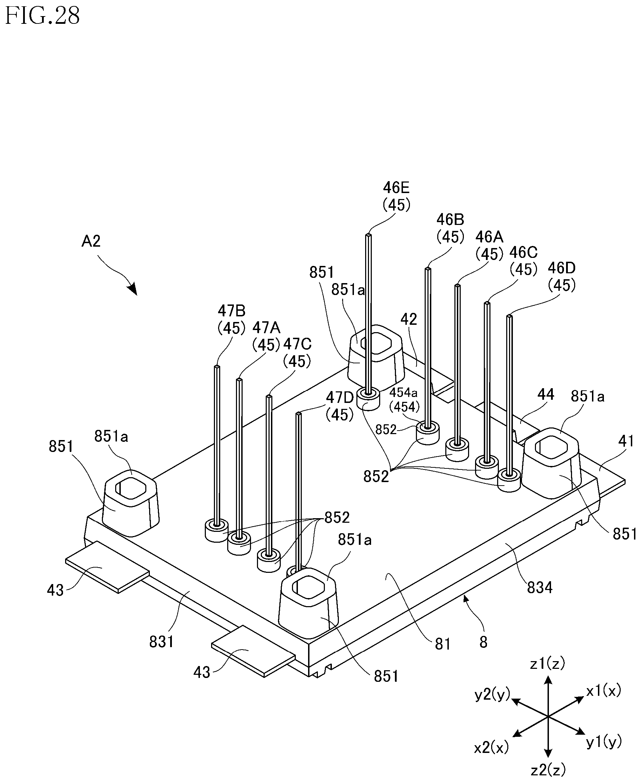

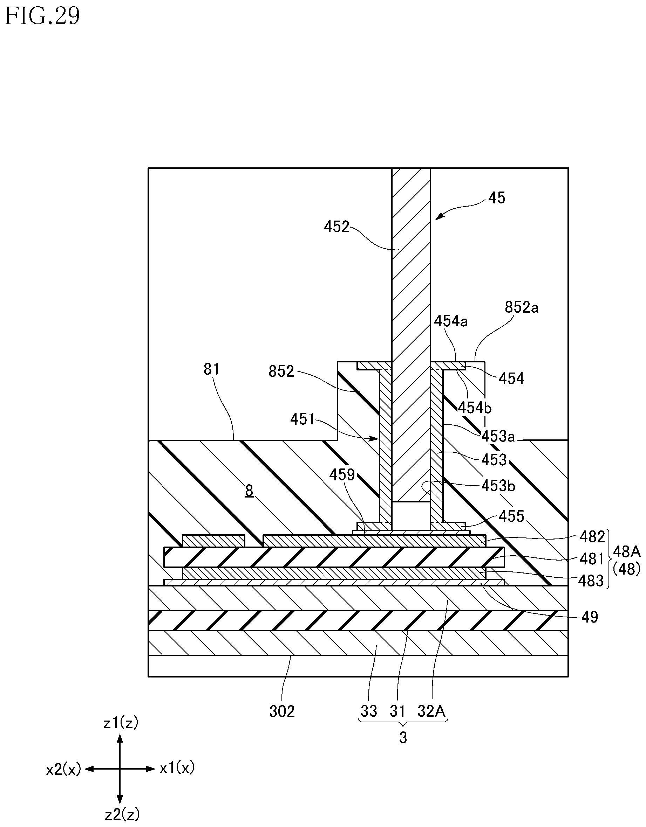

Figs. 28 and 29 show a semiconductor device according to a second embodiment of the present disclosure. Fig. 28 is a perspective view showing a semiconductor device A2 of the present embodiment. Fig. 29 is an enlarged sectional view corresponding to Fig. 16, showing relevant portions of the semiconductor device A2. In the semiconductor device A2 of the present embodiment, the sealing resin 8 does not include the first recesses 810 described above. On the other hand, the semiconductor device A2 has a plurality of first protrusions 852.

The first protrusions 852 protrude from the resin obverse surface 81 toward the z1 side in the z direction. The protrusions 852 are provided correspondingly to the control terminals 45 and overlap with the control terminals 45 in plan view. The metal pins 452 of the control terminals 45 protrude from the first protrusions 852. The first protrusions 852 are columnar. Each first protrusion 852 covers a part of the holder 451 of a control terminal 45. As shown in Fig. 29, the first outer side surface 453a of the tubular portion 453 and the second surface 454b of the first flange portion 454 of the holder 451 are both entirely in contact with the sealing resin **8.** Specifically, a part of the first outer side surface 453a and the entirety of the second surface 454b are in contact with the first protrusion 852. In contrast, the first surface 454a of the first flange portion 454 is exposed from the sealing resin 8.

The first protrusion 852 has a protrusion top surface 852a. The protrusion top surface 852a surrounds the first surface 454a of the holder 451 (the first flange portion 454) in plan view. The first surface 454a and the protrusion top surface 852a are flush with each other. The first surface 454a, which is flush with the protrusion top surface 852a, is located at a position different from the resin obverse surface 81 in the z direction. Specifically, the first surface 454a is located on the z1 side in the z direction with respect to the resin obverse surface 81.

Next, the effects of the present embodiment will be described.

In the semiconductor device A2 of the present embodiment, each of the holders 451 constituting the control terminals 45 has the first surface 454a and the first outer side surface 453a. The first surface 454a is located at the end on the z1 side in the z direction of the holder 451. The first surface 454a is located at a position different from the resin obverse surface 81 in the z direction. The first outer side surface 453a extends in the z direction and is in contact with the sealing resin **8.** The metal pins 452 constituting the control terminals 45 protrude beyond the resin obverse surface 81 toward the z1 side in the z direction. With such a configuration, the control terminals 45 are located in the regions surrounded by the resin obverse surface 81 (sealing resin 8) in plan view. The semiconductor device A2 having such a configuration allows reduction in size in plan view. Further, the first surface 454a is located at a position different from the resin obverse surface 81 in the z direction. Such a configuration increases the creepage distance between adjacent control terminals 45 along the surfaces (resin obverse surface 81, etc.) of the sealing resin 8. Thus, the semiconductor device A2 is suitable for increasing the withstand voltage of adjacent control terminals 45 while reducing the size in plan view.

The sealing resin 8 has the first protrusion 852. The first protrusion 852 protrudes from the resin obverse surface 81 toward the z1 side in the z direction. The first flange portion 454 is located on the z1 side in the z direction with respect to the resin obverse surface 81. The sealing resin 8 having the first protrusion 852 allows the first surface 454a (the first flange portion 454) to be appropriately located at a position different from the resin obverse surface 81 in the z direction.

The semiconductor device according to the first aspect of the present disclosure is not limited to the above-described embodiments. Various modifications in design may be made freely in the specific structure of each part of the semiconductor device.

The first aspect of the present disclosure includes embodiments described in the following clauses 1 to 16.

### Clause 1.

A semiconductor device comprising:
at least one terminal including a cylindrical holder having electrical conductivity and a metal pin inserted in the holder;
a terminal support supporting the holder; and
a sealing resin covering a part of the holder and covering the terminal support, wherein
the sealing resin includes a resin obverse surface facing a first side in a thickness direction,
the holder includes a first surface located at one end on the first side in the thickness direction and a first outer side surface extending in the thickness direction,
the first surface is located at a position different from the resin obverse surface in the thickness direction,
the first outer side surface is in contact with the sealing resin, and
the metal pin protrudes beyond the resin obverse surface toward the first side in the thickness direction.

### Clause 2.

The semiconductor device according to clause **1,** wherein the holder includes a tubular portion extending in the thickness direction and a first flange portion connected to an end on the first side in the thickness direction of the tubular portion,
the first flange portion includes the first surface facing the first side in the thickness direction and a second surface located on a second side in the thickness direction relative to the first surface and facing the second side in the thickness direction,
the tubular portion includes the first outer side surface, and
the first outer side surface and the second surface are entirely in contact with the sealing resin.

### Clause 3.

The semiconductor device according to clause 2, wherein the sealing resin includes a first recess that is recessed from the resin obverse surface toward the second side in the thickness direction,
the first flange portion is located on the second side in the thickness direction relative to the resin obverse surface, and
the first recess overlaps with entirety of the tubular portion as viewed in the thickness direction.

### Clause 4.

The semiconductor device according to clause 3, wherein at least a part of the first surface is exposed from the sealing resin.

### Clause 5.

The semiconductor device according to clause 4, wherein the first surface is entirely exposed from the sealing resin,
the first recess includes a recess inner side surface connected to the resin obverse surface, and a recess bottom surface connected to an end on the second side in the thickness direction of the recess inner side surface and facing the first side in the thickness direction, and
the recess bottom surface surrounds the first surface as viewed in the thickness direction.

### Clause 6.

The semiconductor device according to clause 3, wherein the first recess includes a recess end edge that is located on the second side in the thickness direction and in contact with the first surface.

### Clause 7.

The semiconductor device according to clause 6, wherein the first recess includes a tapered inner side surface connected to the recess end edge, and
the tapered inner side surface is inclined such that an inner diameter thereof increases toward the first side in the thickness direction.

### Clause 8.

The semiconductor device according to clause 6, wherein an outer periphery of the first flange portion surrounds the first recess as viewed in the thickness direction.

### Clause 9.

The semiconductor device according to any one of clauses 3 **to 8,** wherein a first dimension, which is a distance between the resin obverse surface and the first surface in the thickness direction, is smaller than a second dimension, which is a length of the holder in the thickness direction.

### Clause 10.

The semiconductor device according to clause 9, wherein a ratio of the first dimension to the second dimension is equal to or greater than 1/3.

### Clause 11.

The semiconductor device according to clause 3, further comprising a first resin fill portion loaded in the first recess.

### Clause 12.

The semiconductor device according to clause 2, wherein the sealing resin includes a first protrusion protruding from the resin obverse surface toward the first side in the thickness direction, and
a part of the first outer side surface and entirety of the second surface are in contact with the first protrusion.

### Clause 13.

The semiconductor device according to clause 12, wherein the first protrusion includes a protrusion top surface facing the first side in the thickness direction,
the protrusion top surface surrounds the first surface as viewed in the thickness direction, and
the first surface and the protrusion top surface are flush with each other.

### Clause 14.

The semiconductor device according to clause 1 or 2, further comprising a support conductor supporting the terminal support, and at least one semiconductor element electrically connected to the at least one terminal,
wherein the at least one semiconductor element is supported on the support conductor.

### Clause 15.

The semiconductor device according to clause 14, wherein the at least one terminal is a control terminal for controlling the at least one semiconductor element.

### Clause 16.

The semiconductor device according to clause 15, wherein the support conductor includes a first conductive portion and a second conductive portion spaced apart from each other in a first direction orthogonal to the thickness direction,
the at least one semiconductor element includes a first switching element bonded to the first conductive portion and a second switching element bonded to the second conductive portion,
the control terminal includes a first control terminal for controlling the first switching element and a second control terminal for controlling the second switching element, and
the terminal support includes a first support portion supporting the first control terminal and a second support portion supporting the second control terminal.

Next, a semiconductor device according to a first embodiment based on a second aspect of the present disclosure will be described based on Figs. 30 to 44. The semiconductor device B1 of the present embodiment includes a support substrate 11, a plurality of power terminals 13, a plurality of semiconductor elements 21, a thermistor 22, a first conductive member 31, a second conductive member 32, a plurality of wires, a plurality of control terminals 45, a control terminal support 48, and a sealing resin 8. The plurality of power terminals 13 include a first power terminal 14, two second power terminals 15, and two third power terminals 16. The plurality of wires include a plurality of first wires 41, a plurality of second wires 42, a plurality of third wires 43, and a fourth wire 44.

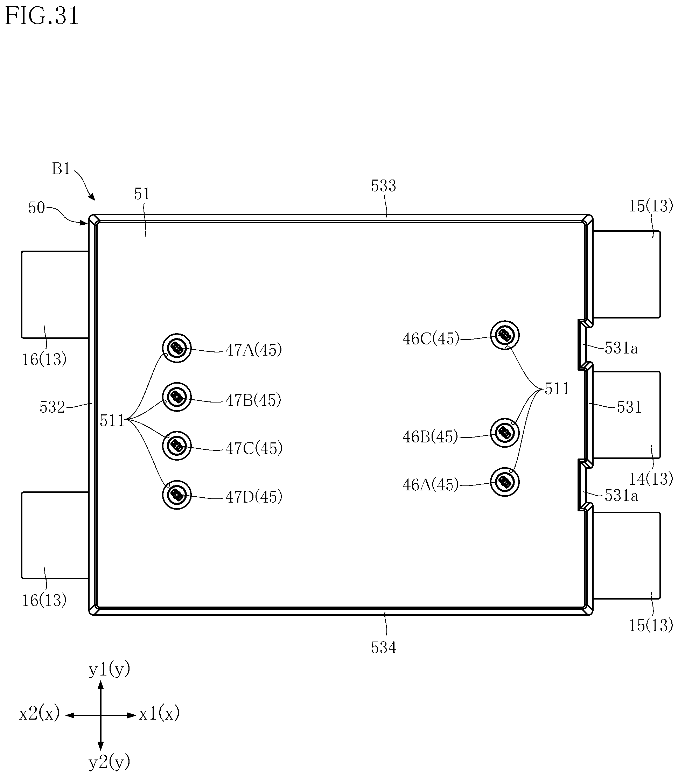

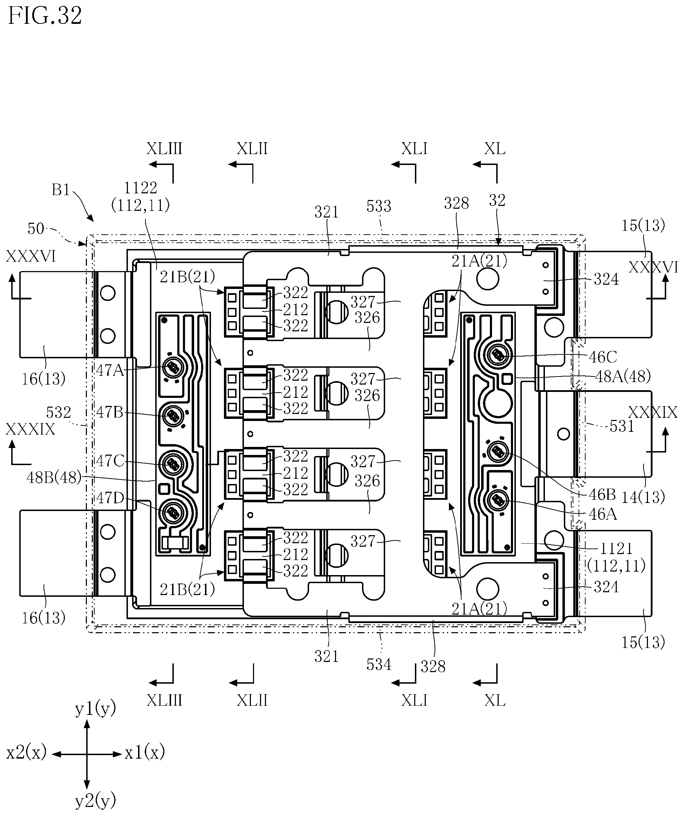

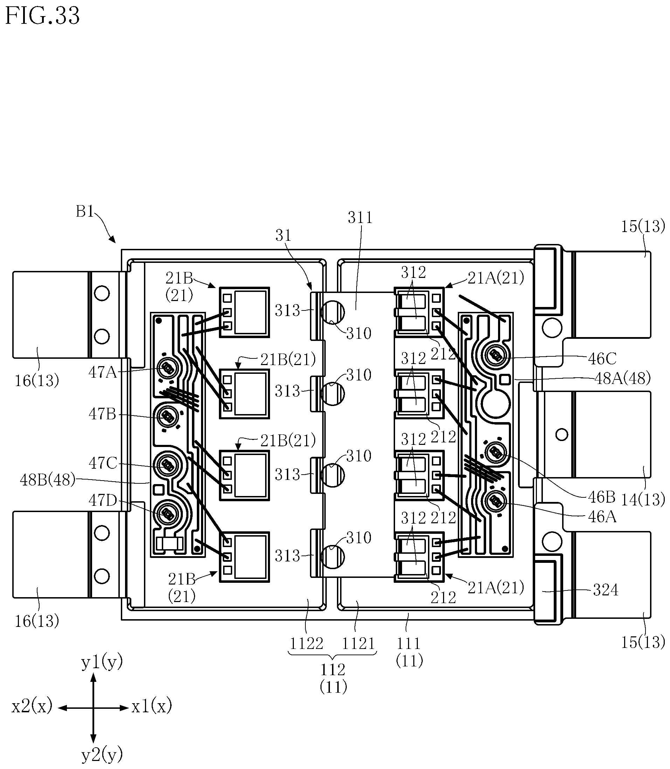

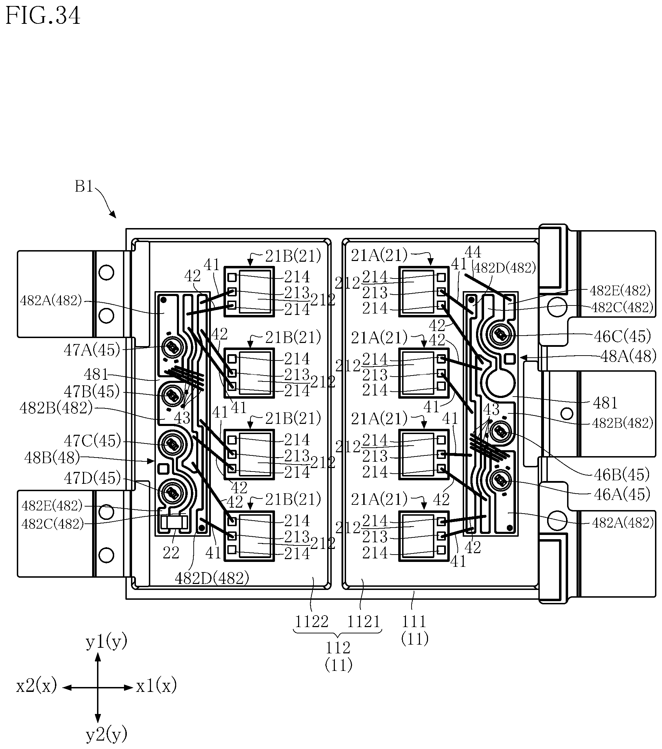

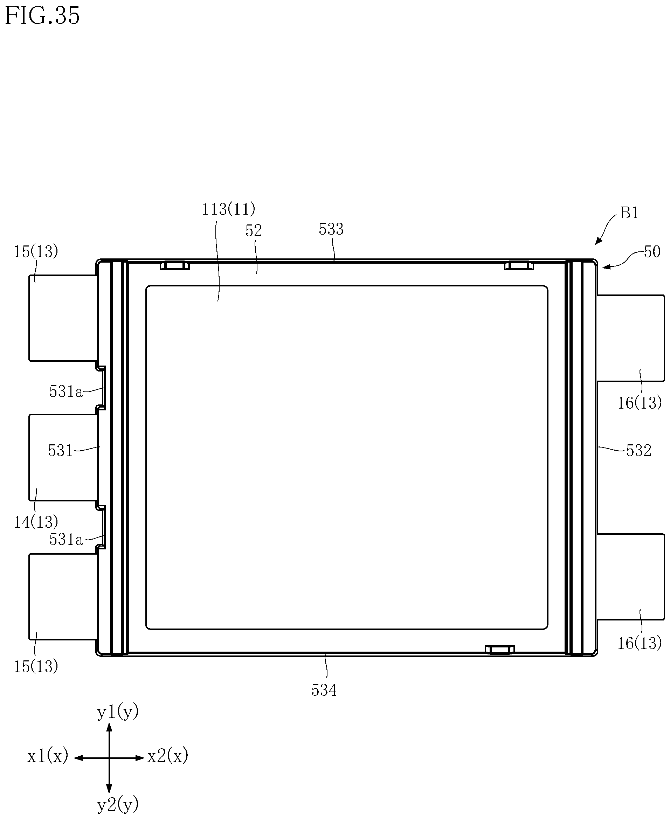

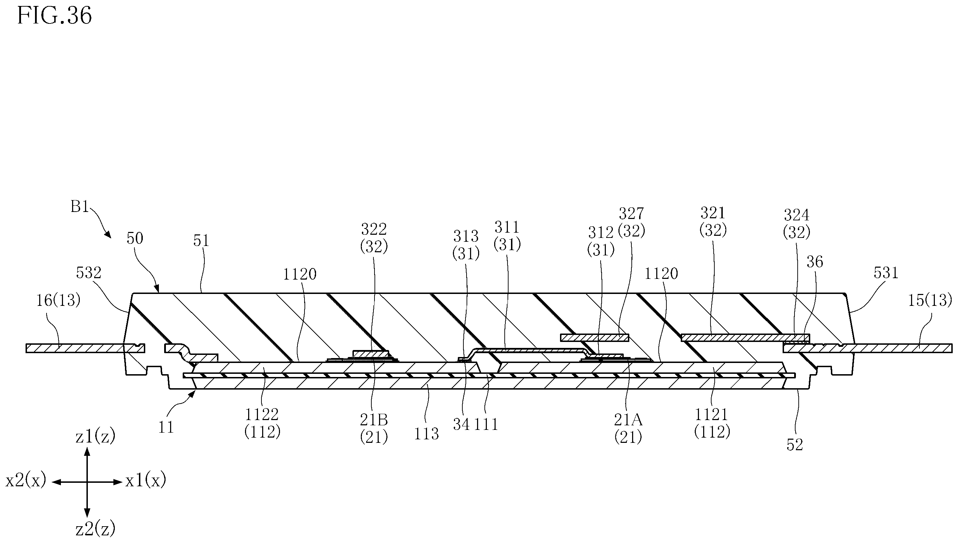

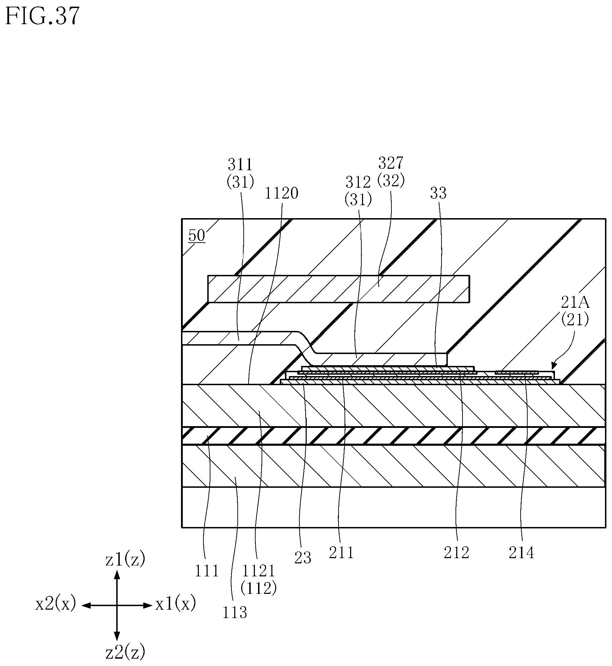

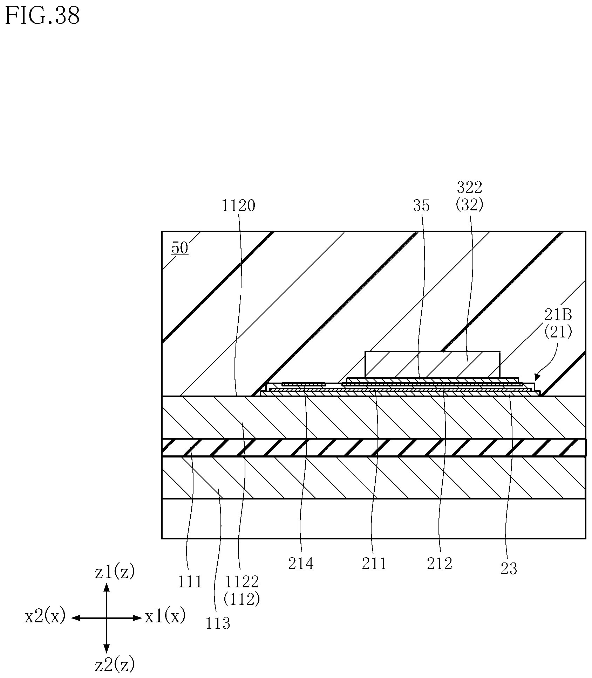

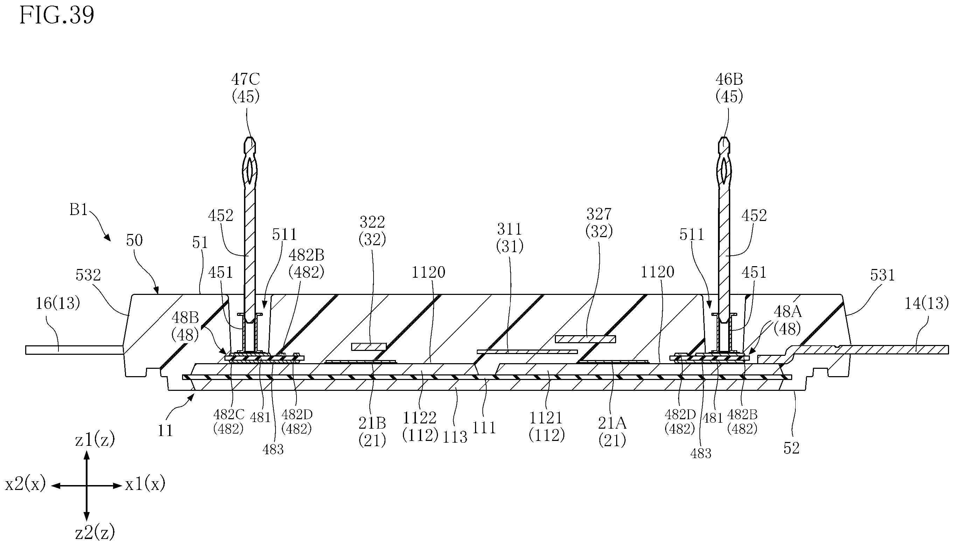

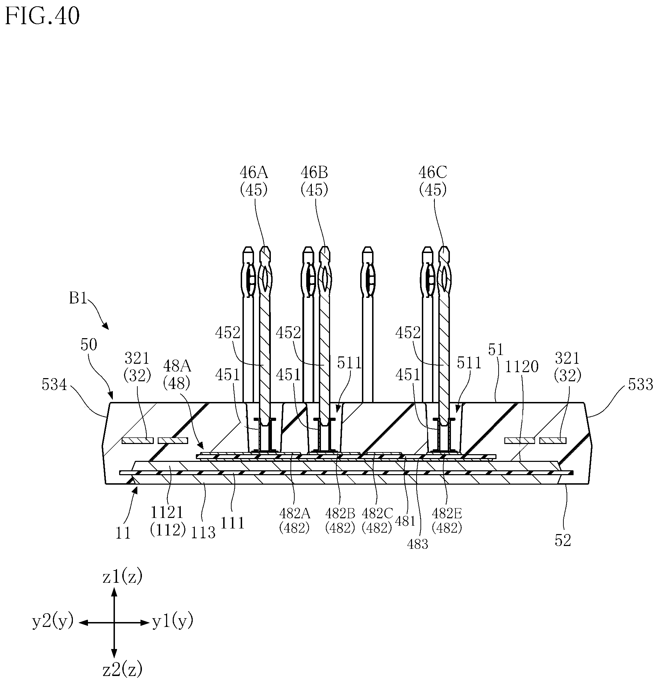

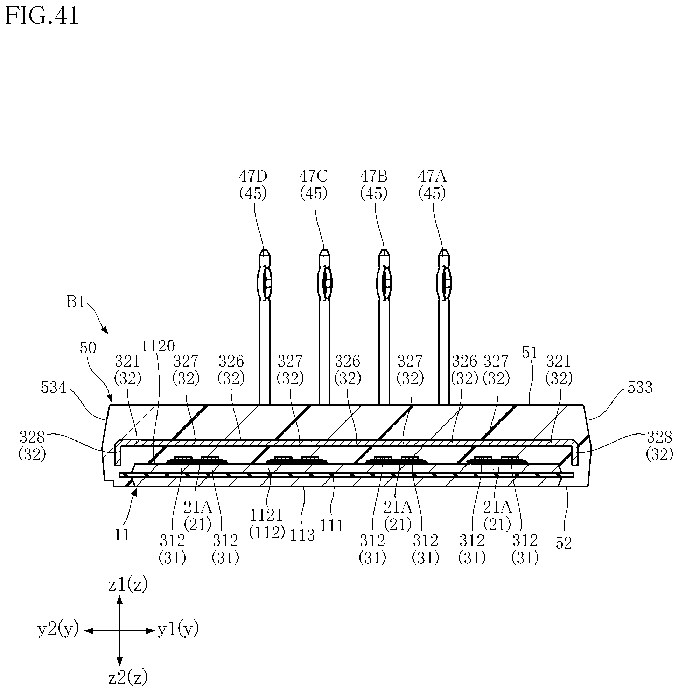

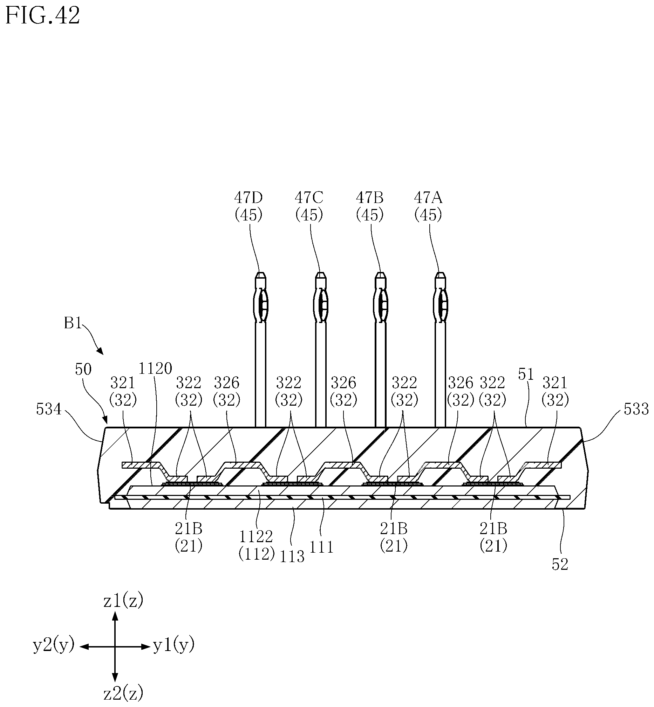

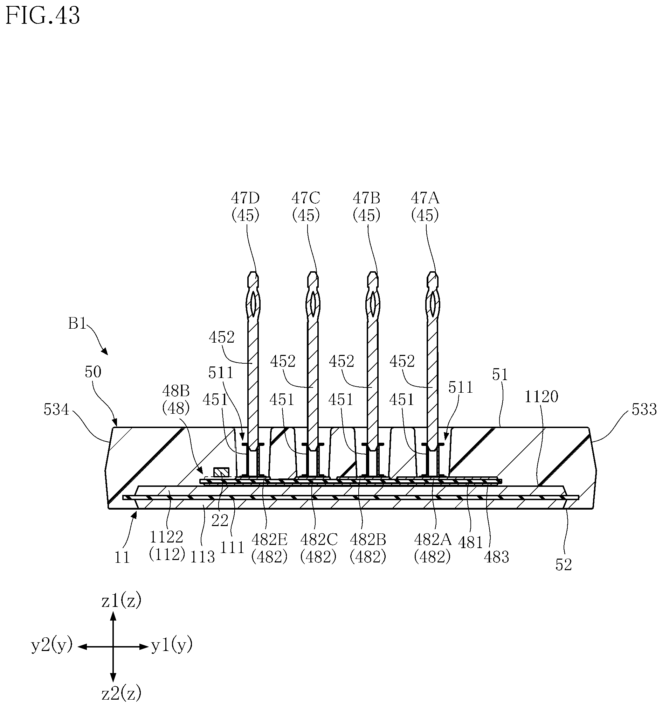

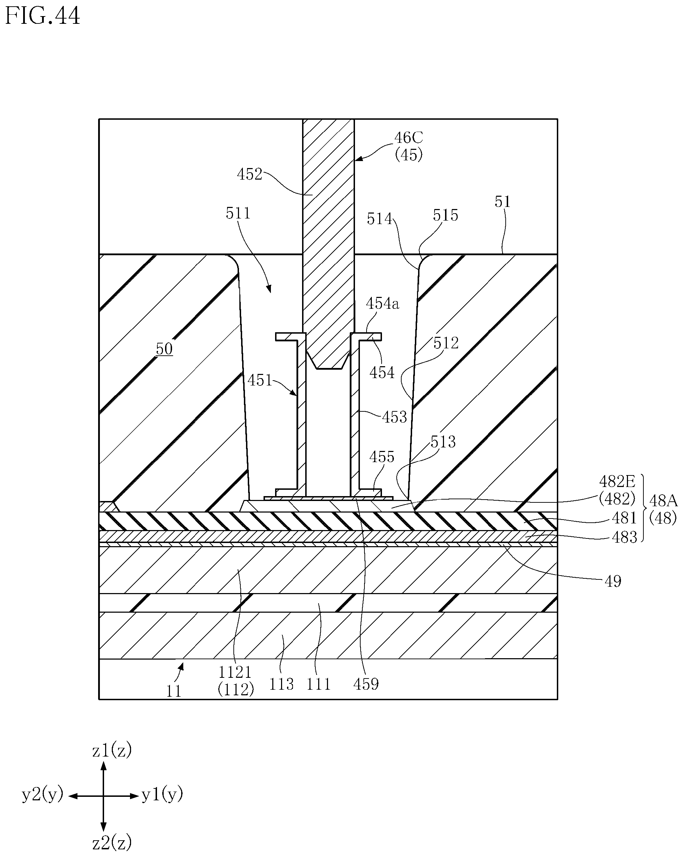

Fig. 30 is a perspective view of the semiconductor device B1. Fig. 31 is a plan view of the semiconductor device B1. Fig. 32 is a plan view of the semiconductor device B1, in which the sealing resin 50 is shown by imaginary lines. Fig. 33 is a plan view of the semiconductor device B1, in which the sealing resin 50 and the second conductive member 32 are omitted from the plan view of Fig. 32. Fig. 34 is a plan view corresponding to Fig. 33, from which the first conductive member 31 is omitted. Fig. 35 is a bottom view of the semiconductor device B1. Fig. 36 is a sectional view taken along line XXXVI-XXXVI in Fig. 32. Figs. 37 and 38 are partially enlarged sectional views showing a part of Fig. 36. Fig. 39 is a sectional view taken along line XXXIX-XXXIX in Fig. 32. Fig. 40 is a sectional view taken along line XL-XL in Fig. 32. Fig. 41 is a sectional view taken along line XLI-XLI in Fig. 32. Fig. 42 is a sectional view taken along line XLII-XLII in Fig. 32. Fig. 43 is a sectional view taken along line XLIII-XLIII in Fig. 32. Figs. 44 is a partially enlarged sectional view showing a part of Fig. 40.

In the following description, reference will be made to the thickness direction z, the first direction x, and the second direction y that are orthogonal to each other. The thickness direction z corresponds to the thickness direction of the semiconductor device B1. Also, "in plan view" means as viewed in the thickness direction **z.** The first direction x is orthogonal to the thickness direction z. The second direction y is orthogonal to the thickness direction z and the first direction x.

The semiconductor device B1 converts the DC power supply voltage applied to the first power terminal 14 and the two second power terminals 15 into AC power by the semiconductor elements 21. The converted AC power is inputted from the two third power terminals 16 to a power supply target, such as a motor.

As shown in Fig. 34, 36 to 39, 41, and 42, the support substrate 11 supports the semiconductor elements 21 in the thickness direction **z.** The support substrate 11 is provided by, for example, a DBC (Direct Bonded Copper) substrate. As shown in Figs. 33 to 43, the support substrate 11 includes an insulating layer 111, a support conductor 112, and a reverse-surface metal layer 113. As shown in Figs. 35 to 43, the support substrate 11 is covered with the sealing resin 50 except a part of the reverse-surface metal layer 113.

As shown in Figs. 36 to 43, the insulating layer 111 includes a portion interposed between the support conductor 112 and the reverse-surface metal layer 113 in the thickness direction **z.** The insulating layer 111 is made of a material with a relatively high thermal conductivity. The insulating layer 111 is made of, for example, a ceramic material including aluminum nitride (AlN). The insulating layer 111 may be made of a sheet of insulating resin rather than a ceramic material.

As shown in Figs. 33, 34, and 36 to 43, the support conductor 112 is located on the upper side (z1 side) of the insulating layer 111 in the thickness direction **z.** The composition of the support conductor 112 includes copper (Cu). As shown in Figs. 42 and 43, the support conductor 112 is surrounded by the periphery of the insulating layer 111 in plan view. As shown in Figs. 36 to 43, the support conductor 112 has an obverse surface 1120. The obverse surface 1120 is a flat surface facing the z1 side in the thickness direction. As shown in Figs. 33, 34, and 36 to 43, the support conductor 112 includes a first conductive portion 1121 and a second conductive portion 1122. The first conductive portion 1121 and the second conductive portion 1122 are rectangular in plan view. The first conductive portion 1121 and the second conductive portion 1122 are spaced apart from each other in the first direction x. The first conductive portion 1121 is located on the x1 side in the first direction x with respect to the second conductive portion 1122. Each of the semiconductor elements 21 is bonded to either the first conductive portion 1121 or the second conductive portion 1122.

As shown in Figs. 36 to 43, the reverse-surface metal layer 113 is located under (on the z2 side of) the insulating layer 111 in the thickness direction **z.** As shown in Fig. 35, the reverse-surface metal layer 113 is exposed from the sealing resin 50. A heat dissipating member (e.g., a heat sink), not shown, can be attached to the lower surface (the surface facing the z2 side) of the reverse-surface metal layer 113. The composition of the reverse-surface metal layer 113 includes copper. The reverse-surface metal layer 113 is rectangular in plan view. The reverse-surface metal layer 113 is surrounded by the periphery of the insulating layer 111 in plan view.

As shown in Figs. 34 and 36 to 39, each of the semiconductor elements 21 is mounted on either the first conductive portion 1121 or the second conductive portion 1122. Each semiconductor element 21 is, for example, a MOSFET (Metal-Oxide-Semiconductor Field-Effect Transistor). Alternatively, each semiconductor element 21 may be a switching element such as an IGBT (Insulated Gate Bipolar Transistor) or a diode. In the description of the semiconductor device B1, the semiconductor element 21 is an n-channel type MOSFET with a vertical structure. The semiconductor element 21 includes a compound semiconductor substrate. The composition of the compound semiconductor substrate includes silicon carbide (SiC) or silicon (Si).

As shown in Figs. 34 and 36 to 39, the semiconductor elements 21 in the semiconductor device B1 include a plurality of first elements 21A and a plurality of second elements 21B. The configuration of each second element 21B is the same as the configuration of each first element 21A. The first elements 21A are mounted on the first conductive portion 1121. The first elements 21A are arranged along the second direction y. The second elements 21B are mounted on the second conductive portion 1122. The second elements 21B are arranged along the second direction y. Each of the first elements 21A corresponds to the first switching element of the present disclosure. Each of the second elements 21B corresponds to the second switching element of the present disclosure.

As shown in Figs. 34, 37, and 38, each semiconductor element 21 has a first electrode 211, a second electrode 212, a third electrode 213, and two fourth electrodes 214.

As shown in Figs. 37 and 38, the first electrode 211 faces either the first conductive portion 1121 or the second conductive portion 1122. A current corresponding to the electric power before being converted by the semiconductor element 21 flows through the first electrode 211. That is, the first electrode 211 corresponds to the drain electrode of the semiconductor element 21.

As shown in Figs. 34, 37, and 38, the second electrode 212 is located opposite to the first electrode 211 in the thickness direction z. A current corresponding to the electric power after being converted by the semiconductor element 21 flows through the second electrode 212. That is, the second electrode 212 corresponds to the source electrode of the semiconductor element 21.

As shown in Fig. 34, the third electrode 213 is located on the same side as the second electrode 212 in the thickness direction **z.** A gate voltage for driving the semiconductor element 21 is applied to the third electrode 213. That is, the third electrode 213 corresponds to the gate electrode of the semiconductor element 21. As shown in Fig. 34, the area of the third electrode 213 is smaller than the area of the second electrode 212 in plan view.

As shown in Figs. 34, 37, and 38, the two fourth electrodes 214 are located on the same side as the second electrode 212 in the thickness direction z and located next to the third electrode 213 in the first direction x. In the illustrated example, the two fourth electrodes 214 are disposed on each side of the third electrode 213 in the second direction y. The potential of each fourth electrode 214 is equal to the potential of the second electrode 212. The fourth electrode 214 corresponds to a source sense electrode. Unlike the illustrated example, each semiconductor element 21 may include only one of the two fourth electrodes 214 or may include neither of the two fourth electrodes 214.

As shown in Figs. 37 and 38, a conductive bonding layer 23 is interposed between each of the first conductive portion 1121 and the second conductive portion 1122 and the first electrode 211 of each of the semiconductor elements 21. The conductive bonding layer 23 is, for example, solder. Alternatively, the conductive bonding layer 23 may include sintered metal particles. The first electrodes 211 of the first elements 21A are conductively bonded to the first conductive portion 1121 via the conductive bonding layers 23. Thus, the first electrodes 211 of the first elements 21A electrically conduct to the first conductive portion 1121. The first electrodes 211 of the second elements 21B are conductively bonded to the second conductive portion 1122 via the conductive bonding layers 23. Thus, the first electrodes 211 of the second elements 21B electrically conduct to the second conductive portion 1122. Unlike the present embodiment, the first elements 21A and the second elements 21B may be mounted on a metal member different from a part of a DBC substrate or the like. In such a case, the metal member corresponds to the first conductive portion and the second conductive portion of the present disclosure. The metal member may be supported on a DBC substrate or the like.

Each of the power terminals 13 electrically conducts to the semiconductor elements 21. A current corresponding to the electric power before being converted by the semiconductor element 21 or a current corresponding to the electric power after being converted by the semiconductor element 21 flows in each power terminal 13. The plurality of power terminals 13 include a first power terminal 14, two second power terminals 15, and two third power terminals 16.

As shown in Figs. 33 and 39, the first power terminal 14 is bonded to the first conductive portion 1121. This bonding is not limited in any way, and may be bonding using a conductive bonding material (e.g., solder), not shown, bonding by laser welding, or bonding by caulking. The first power terminal 14 electrically conducts to the first electrodes 211 of the first elements 21A via the first conductive portion 1121. The first power terminal 14 is a P terminal (positive electrode) to which a DC power supply voltage to be converted is applied. As shown in Fig. 33, the first power terminal 14 is located opposite to the second conductive portion 1122 with the first conductive portion 1121 interposed therebetween in the first direction x. The first power terminal 14 extends from the first conductive portion 1121 toward the x1 side in the first direction x and protrudes from the sealing resin 50 toward the x1 side in the first direction x. As shown in Fig. 32, the first power terminal 14 includes a portion covered with the sealing resin 50 and a portion exposed from the sealing resin 50. In the first power terminal 14, the portion covered with the sealing resin 50 is bonded to the first conductive portion 1121. In the first power terminal 14, the portion exposed from the sealing resin 50 is used as the above-described P terminal of the semiconductor device B1.

To the two second power terminals 15 is bonded the second conductive member 32. The two second power terminals 15 electrically conduct to the second electrodes 212 of the second elements 21B via the second conductive member 32. The two second power terminals 15 are N terminals (negative electrode) to which a DC power supply voltage to be converted is applied. The two second power terminals 15 are spaced apart from each other in the second direction y. The first power terminal 14 is located between the two second power terminals 15. As shown in Fig. 33, the two second power terminals 15 are located on the same side as the first power terminal 14 with respect to the first conductive portion 1121 and the second conductive portion 1122 in the first direction x. The two second power terminals 15 are spaced apart from the first conductive portion 1121 and the second conductive portion 1122. The two second power terminals 15 extend in the first direction x and protrude from the sealing resin 50 toward the x1 side in the first direction x. As shown in Fig. 32, each of the two second power terminals 15 includes a portion covered with the sealing resin 50 and a portion exposed from the sealing resin 50. The second conductive member 32 is bonded to the portion of each second power terminal 15 that is covered with the sealing resin 50. In each second power terminal 15, the portion exposed from the sealing resin 50 is used as the above-described N terminal of the semiconductor device B1.

As shown in Figs. 33 and 36, the two third power terminals 16 are bonded to the second conductive portion 1122. This bonding is not limited in any way, and may be bonding using a conductive bonding material (e.g., solder), not shown, bonding by laser welding, or bonding by caulking. The two third power terminals 16 electrically conduct to the first electrodes 211 of the second elements 21B via the second conductive portion 1122. Also, the two third power terminals 16 electrically conduct to the second electrodes 212 of the first elements 21A via the second conductive portion 1122 and the first conductive member 31. From the two third power terminals 16, AC power converted by the semiconductor elements 21 (the first elements 21A and the second elements 21B) is outputted. That is, the two third power terminals 16 are output terminals for the AC power. The two third power terminals 16 are spaced apart from each other in the second direction y. As shown in Fig. 33, the two third power terminals 16 are located opposite to the first conductive portion 1121 with the second conductive portion 1122 interposed therebetween in the first direction x. The two third power terminals 16 extend from the second conductive portion 1122 toward the x2 side in the first direction x and protrude from the sealing resin 50 toward the x2 side in the first direction x. As shown in Fig. 32, each of the two third power terminals 16 includes a portion covered with the sealing resin 50 and a portion exposed from the sealing resin 50. In each of the third power terminals 16, the portion covered with the sealing resin 50 is bonded to the second conductive portion 1122. In each of the third power terminals 16, the portion exposed from the sealing resin 50 is used as the above-described output terminal of the semiconductor device B1.

In the present embodiment, the semiconductor device B1 includes four first elements 21A and four second elements 21B. However, the number of first elements 21A and the number of second elements 21B are not limited to this configuration, and may be changed as appropriate in accordance with the performance required of the semiconductor device B1. In the example shown in Fig. 34, four each of the first elements 21A and the second elements 21B are provided. The number of first elements 21A and the number of second elements 21B may be two, three, or five or more. The number of first elements 21A and the number of second elements 21B may be the same or may be different. The number of first elements 21A and the number of second elements 21B are determined based on the current capacity of the semiconductor device B1.

The semiconductor device B1 may be configured as a half-bridge type switching circuit. In this case, the first elements 21A constitute the upper arm circuit of the semiconductor device B1, and the second semiconductor elements 10B constitute the lower arm circuit. In the upper arm circuit, the first elements 21A are connected in parallel with each other. In the lower arm circuit, the second elements 21B are connected in parallel with each other. Each first element 21A and a relevant second element 21B are connected in series to form a bridge layer.

Each of the control terminals 45 is a pin-shaped terminal for controlling the first elements 21A and the second elements 21B. The control terminals 45 are, for example, press-fit terminals. The control terminals 45 include a plurality of first control terminals 46A to 46C and a plurality of second control terminals 47A to 47D. The first control terminals 46A to 46C are used to control the first elements 21A, for example. The second control terminals 47A to 47D are used to control the second elements 21B, for example.

The first control terminals 46A to 46C are spaced apart from each other in the second direction y. As shown in Figs. 34, 39, and 40, the first control terminals 46A to 46C are supported on the first conductive portion 1121 via the control terminal support 48 (the first support portion 48A, described later). As shown in Figs. 33 and 34, the first control terminals 46A to 46C are located between the first elements 21A and the first power terminal 14 and two second power terminals 15 in the first direction x.

The first control terminal 46A is a terminal (a gate terminal) for inputting a drive signal for the first elements 21A. A drive signal for driving the first elements 21A is inputted (e.g., a gate voltage is applied) to the first control terminal 46A.

The first control terminal 46B is a terminal (a source sense terminal) for detecting a source signal of the first elements 21A. The voltage applied to the second electrode 212 (the source electrode) of each first element 21A (the voltage corresponding to the source current) is detected from the first control terminal 46B.

The first control terminal 46C is a terminal (a drain sense terminal) for detecting a drain voltage of the first elements 21A. The voltage applied to the first electrode 211 (the drain electrode) of each first element 21A (the voltage corresponding to the drain current) is detected from the first control terminal 46C.

The second control terminals 47A to 47D are spaced apart from each other in the second direction y. As shown in Figs. 34, 39, and 43, the second control terminals 47A to 47D are supported on the second conductive portion 1122 via the control terminal support 48 (the second support portion 48B, described later). As shown in Figs. 33 and 34, the second control terminals 47A to 47D are located between the second elements 21B and the two third power terminals 16 in the first direction x.

The second control terminal 47A is a terminal (a gate terminal) for inputting a drive signal for the second elements 21B. A drive signal for driving the second elements 21B is inputted (e.g., a gate voltage is applied) to the second control terminal 47A. The second control terminal 47B is a terminal (a source sense terminal) for detecting a source signal of the second element 21B. The voltage applied to the second electrode 212 (the source electrode) of each second element 21B (the voltage corresponding to the source current) is detected from the second control terminal 47B. The second control terminal 47C and the second control terminal 47D electrically conduct to none of the second elements 21B. The second control terminal 47C and the second control terminal 47D are terminals electrically conducting to a thermistor 22.

Each of the control terminals 45 (the first control terminals 46A to 46C and the second control terminals 47A to 47D) includes a holder 451 and a metal pin 452.

The holders 451 are made of an electrically conductive material. The holders 451 are disposed on the obverse surface 1120 of the support conductor 112 (support substrate 11). As shown in Fig. 44, the holders 451 are bonded to the control terminal support 48 (the first metal layer 482, described later) via a conductive bonding material 459. As shown in Fig. 44, each holder 451 includes a tubular portion 453, a first flange portion 454, and a second flange portion 455.

The tubular portion 453 extends in the thickness direction z and is, for example, cylindrical.

The first flange portion 454 is connected to the end on the z1 side in the thickness direction z of the tubular portion 453. The first flange portion 454 has a first surface 454a. The first surface 454a faces the z1 side in the thickness direction z. The first surface 454a is located at the end on the z1 side in the thickness direction z of the holder 451. The first surface 454a has the shape of a loop (a circular loop in the illustrated example) as viewed in the thickness direction z.

The second flange portion 455 is connected to the end on the z2 side in the thickness direction z of the tubular portion 453. In the present embodiment, the second flange portion 455 is bonded to the control terminal support 48 (the first metal layer 482, described later) via a conductive bonding material 459.

A metal pin 452 is inserted in the first flange portion 454 and a part of the tubular portion 453 of each holder 451. The entirety of the holder 451 is exposed from the sealing resin 50.

Each metal pin 452 is a bar-shaped member extending in the thickness direction z. The metal pin 452 is supported by a holder 451 by being press-fitted into the holder 451. The metal pin 452 electrically conducts to the control terminal support 48 (the first metal layer 482, described later) via the holder 451 and the conductive bonding layer 459. The metal pin 452 protrudes beyond the upper surface (the resin obverse surface 51, described later) of the sealing resin 50 toward the z1 side in the thickness direction z.

The control terminal support 48 supports the control terminals 45. The control terminal support 48 is interposed between the obverse surface 1120 of the first conductive portion 1121 or the obverse surface 1120 of the second conductive portion 1122 and the control terminals 45 in the thickness direction z.

The control terminal support 48 includes a first support portion 48A and a second support portion 48B. The first support portion 48A is disposed on the first conductive portion 1121 and supports the first control terminals 46A to 46C of the control terminals 45. As shown in Fig. 44, the first support portion 48A is bonded to the first conductive portion 1121 via a bonding layer 49. The bonding layer 49 may be electrically conductive or insulating, and may be solder, for example. The second support portion 48B is disposed on the second conductive portion 1122 and supports the second control terminals 47A to 47D of the control terminals 45. As with the first support portion 48A, the second support portion 48B is bonded to the second conductive portion 1122 via a bonding layer, not shown.

The control terminal support 48 (each of the first support portion 48A and the second support portion 48B) is provided by a DBC (Direct Bonded Copper) substrate, for example. The control terminal support 48 includes an insulating layer 481, a first metal layer 482, and a second metal layer 483 laminated on top of each other.

The insulating layer 481 is made of, for example, a ceramic material. The insulating layer 481 is, for example, rectangular in plan view.

As shown in Fig. 44, the first metal layer 482 is formed on the upper surface of the insulating layer 481. Each control terminal 45 stands on the first metal layer 482. The first metal layer 482 contains, for example, Cu (copper) or a Cu (copper) alloy. As shown in Fig. 34, the first metal layer 482 includes a first portion 482A, a second portion 482B, a third portion 482C, a fourth portion 482D, and a fifth portion 482E. The first portion 482A, the second portion 482B, the third portion 482C, the fourth portion 482D, and the fifth portion 482E are spaced apart and insulated from each other.

The fourth portion 482D, to which a plurality of first wires 41 are bonded, electrically conducts to the third electrodes 213 (gate electrodes) of the first elements 21A (the second elements 21B) via the first wires 41. A plurality of third wires 43 are connected to the fourth portion 482D and the first portion 482A. Thus, the first portion 482A electrically conducts to the third electrodes 213 (gate electrodes) of the first elements 21A (the second elements 21B) via the third wires 43 and the first wires 41. As shown in Fig. 34, the first control terminal 46A is bonded to the first portion 482A of the first support portion 48A, and the second control terminal 47A is bonded to the first portion 482A of the second support portion 48B.

The second portion 482B, to which a plurality of second wires 42 are bonded, electrically conducts to the fourth electrodes 214 (source sense electrodes) of the first elements 21A (the second elements 21B) via the second wires 42. As shown in Fig. 34, the first control terminal 46B is bonded to the second portion 482B of the first support portion 48A, and the second control terminal 47B is bonded to the second portion 482B of the second support portion 48B.

The second control terminal 47C is bonded to the third portion 482C. Specifically, as shown in Fig. 34, the second control terminal 47C is bonded to the third portion 482C of the second support portion 48B. The first control terminal 46C and the second control terminal 47D are bonded to the fifth portion 482E. Specifically, the first control terminal 46C is bonded to the fifth portion 482E of the first support portion 48A. The fifth portion 482E of the first support portion 48A, to which the fourth wire 44 is bonded, electrically conducts to the first electrodes 211 (drain electrodes) of the first elements 21A via the fourth wire 44. The second control terminal 47D is bonded to the fifth portion 482E of the second support portion 48B.

The thermistor 22 is conductively bonded across the third portion 482C and the fifth portion 482E of the second support portion 48B. The thermistor 22 is, for example, an NTC (Negative Temperature Coefficient) thermistor. An NTC thermistor has the characteristic that its resistance decreases gradually as the temperature increases. The thermistor 22 is used as a temperature detection sensor of the semiconductor device B1.

Each of the first wires 41, the second wires 42, the third wires 43, and the fourth wire 44 described above is, for example, a bonding wire. The constituent material of the first wires 41, the second wires 42, the third wires 43 and the fourth wire is not particularly limited and may include one of Au (Gold), Al (aluminum), or Cu (copper), for example. The first wires 41, the second wires 42, the third wires 43, and the fourth wire 44 are omitted in Figs. 32, 36 to 40, and 43.

As shown in Fig. 44, the second metal layer 483 is formed on the lower surface (the surface facing the z2 side in the thickness direction z) of the insulating layer 481. As shown in Fig. 44, the second metal layer 483 of the first support portion 48A is bonded to the first conductive portion 1121 via a bonding layer 49. As with the second metal layer 483 of the first support portion 48A, the second metal layer 483 of the second support portion 48B is bonded to the second conductive portion 1122 via a bonding layer, not shown.

As shown in Figs. 33 and 36, the first conductive member 31 is conductively bonded to the second electrodes 212 of the first elements 21A and the second conductive portion 1122. Thus, the second electrodes 212 of the first elements 21A electrically conduct to the second conductive portion 1122. The composition of the first conductive member 31 is not particularly limited and may include, for example, copper. The first conductive member 31 is a metal clip. As shown in Figs. 33 and 36, the first conductive member 31 includes a main body 311, a plurality of first bond portions 312, and a plurality of second bond portions 313.

The main body 311 forms the main portion of the first conductive member 31. As shown in Fig. 33, the main body 311 extends in the second direction y. As shown in Figs. 33 and 36, the main body 311 straddles the gap between the first conductive portion 1121 and the second conductive portion 1122. As shown in Fig. 33, the main body 311 is formed with a plurality of through-holes 310. The through-holes 310 penetrate the main body 311 in the thickness direction z. The through-holes 310 overlap with the gap between the first conductive portion 1121 and the second conductive portion 1122 in plan view. This facilitates the flow of the sealing resin 50 downward of the main body 311 in the thickness direction z (z2 side in the thickness direction z) during the formation of the sealing resin 50.

As shown in Figs. 33 and 36, the first bond portions 312 are individually bonded to the second electrodes 212 of the first elements 21A. Each of the first bond portions 312 faces the second electrode 212 of one of the first elements 21A. In plan view, each first bond portion 312 extends from the main body 311 toward the x1 side in the first direction x. Each first bond portion 312 is bifurcated from the main body 311 in the illustrated example, but it may not be bifurcated. The base end of each first bond portion 312 (the end connected to the main body 311) is bent downward in the thickness direction z (toward the z2 side in the thickness direction z). Thus, the extremity of each first bond portion 312 (the end opposite from the side connected to the main body 311) is located lower than the main body 311 in the thickness direction z (on the z2 side in the thickness direction z).

As shown in Figs. 33 and 36, the second bond portions 313 are bonded to the second conductive portion 1122. Each of the second bond portions 313 faces the second conductive portion 1122. In plan view, each second bond portion 313 extends from the main body 311 toward the x1 side in the first direction x. The base end of each second bond portion 313 (the end connected to the main body 311) is bent downward in the thickness direction z (toward the z2 side in the thickness direction z). Thus, the extremity of each second bond portion 313 (the end opposite from the side connected to the main body 311) is located lower than the main body 311 in the thickness direction z (on the z2 side in the thickness direction z).

As shown in Fig. 37, the semiconductor device B1 further includes a first conductive bonding layer 33. The first conductive bonding layer 33 is interposed between the second electrodes 212 of the first elements 21A and the first bond portions 312. The first conductive bonding layer 33 conductively bonds the second electrodes 212 of the first elements 21A and the first bond portions 312. The first conductive bonding layer 33 is, for example, solder. Alternatively, the first conductive bonding layer 33 may include sintered metal particles.

As shown in Fig. 36, the semiconductor device B1 further includes a second conductive bonding layer 34. The second conductive bonding layer 34 is interposed between the second conductive portion 1122 and the second bond portion 313. The second conductive bonding layer 34 conductively bonds the second conductive portion 1122 and the second bond portion 313. The second conductive bonding layer 34 is, for example, solder. Alternatively, the second conductive bonding layer 34 may include sintered metal particles.

As shown in Fig. 32, the second conductive member 32 is conductively bonded to the second electrodes 212 of the second elements 21B and the two second power terminals 15. Thus, the second electrodes 212 of the second elements 21B electrically conduct to the two second power terminals 15. The composition of the second conductive member 32 is not particularly limited and may include, for example, copper. The second conductive member 32 is a metal clip. As shown in Figs. 32, 36 and 39 to 42, the second conductive member 32 has a pair of main bodies 321, a plurality of third bond portions 322, a pair of fourth bond portions 324, a plurality of intermediate portions 326, a plurality of lateral beam portions 327, and a pair of suspended portions 328.

As shown in Fig. 32, the pair of main bodies 321 are spaced apart from each other in the second direction y. The pair of main bodes 321 extend in the first direction **x.** As shown in Figs. 36 and 40, the pair of main bodes are parallel to the upper surface of the first conductive portion 1121 and the upper surface of the second conductive portion 1122. The pair of main bodes 321 are located farther from the first conductive portion 1121 and the second conductive portion 1122 than is the main body 311 of the first conductive member 31.

As shown in Figs. 32, 41, and 42, the plurality of intermediate portions 326 are spaced apart from each other in the second direction y and located between the pair of main bodes 321 in the second direction y. The intermediate portions 326 extend in the first direction x.

As shown in Figs. 32 and 42, the third bond portions 322 are individually bonded to the second electrodes 212 of the second elements 21B. Each of the third bond portions 322 faces the second electrode 212 of one of the second elements 21B. In plan view, the third bond portions 322 extend from the intermediate portions 326 in the second direction y. The base end of each third bond portion 322 (the end connected to the intermediate portion 326) is bent downward in the thickness direction z (toward the z2 side in the thickness direction z). Thus, the extremity of each third bond portion 322 (the end opposite from the side connected to the intermediate portion 326) is located lower than the intermediate portion 326 in the thickness direction z (on the z2 side in the thickness direction z).

As shown in Figs. 32 and 36, the pair of fourth bond portions 324 are individually bonded to the two second power terminals 15. Each of the fourth bond portions 324 faces a relevant one of the two second power terminals 15.

As shown in Fig. 32, the lateral beam portions 327 are aligned in the second direction y. The lateral beam portions 327 include regions individually overlapping with the first bond portions 312 of the first conductive member 31 in plan view. As shown in Figs. 32 and 41, of the plurality of lateral beam portions 327, the lateral beam portions 327 located in the middle in the second direction y are connected, on each side in the second direction y, to an intermediate portion 326. Each of the remaining two lateral beam portions 327 is connected, on each side in the second direction y, to one of the main bodies 321 and one of the intermediate portions 326.

As shown in Figs. 32 and 41, the pair of suspended portions 328 are individually connected to the pair of main bodies 321. As shown in Fig. 41, each of the suspended portions 328 extends from one of the main bodies 321 downward in the thickness direction z (toward the z2 side in the thickness direction z). Each of the suspended portions 328 is connected to the outer edge in the second direction y of one of the main bodies 321. In the illustrated example, the lower ends of the suspended portions 328 (the edges on the z2 side in the thickness direction z) overlap with the first conductive portion 1121 as viewed along the second direction y.

As shown in Fig. 38, the semiconductor device B1 further includes a third conductive bonding layer 35. The third conductive bonding layer 35 is interposed between the second electrodes 212 of the second elements 21B and the third bond portions 322. The third conductive bonding layer 35 conductively bonds the second electrodes 212 of the second elements 21B and the third bond portions 322. The third conductive bonding layer 35 is, for example, solder. Alternatively, the third conductive bonding layer 35 may include sintered metal particles.

As shown in Fig. 36, the semiconductor device B1 further includes a fourth conductive bonding layer 36. The fourth conductive bonding layer 36 is interposed between the two second power terminals 15 and the pair of fourth bond portions 324. The fourth conductive bonding layer 36 conductively bonds the two second power terminals 15 and the pair of fourth bond portions 324. The fourth conductive bonding layer 36 is, for example, solder. Alternatively, the fourth conductive bonding layer 36 may include sintered metal particles.

As shown in Figs. 30 to 43, the sealing resin 50 covers the semiconductor elements 21, the first conductive member 31, the second conductive member 32, the first wires 41, the second wires 42, and the third wires 43. The sealing resin 50 also covers a part of each of the support substrate 11, the power terminals 13 and the control terminal support 48. The sealing resin 50 is electrically insulating. The sealing resin 50 includes, for example, black epoxy resin. The sealing resin 50 is formed by, for example, molding. As shown in Figs. 30 to 32 and 35 to 43, the sealing resin 50 has a resin obverse surface 51, a resin reverse surface 52, a plurality of resin side surfaces 531 to 534, a plurality of first recesses 511, and a pair of recesses 531a.

As shown in Figs. 36 and 39 to 43, the resin obverse surface 51 faces the same side in the thickness direction z as the upper surface of the first conductive portion 1121 (obverse surface 1120) and the upper surface of the second conductive portion 1122 (obverse surface 1120). The metal pins 452 of the control terminals 45 (the first control terminals 46A to 46C and the second control terminals 47A to 47D) protrude from the resin obverse surface 51. As shown in Figs. 36 and 39 to 43, the resin reverse surface 52 faces away from the resin obverse surface 51 in the thickness direction z. As shown in Fig. 35, the resin reverse surface 52 has a frame shape surrounding the lower surface (the surface facing the z2 side in the thickness direction z) of the reverse-surface metal layer 113 of the support substrate 3 in plan view. The reverse-surface metal layer 113 of the support substrate 11 is exposed from the resin reverse surface 52. The lower surface (the surface facing the z2 side in the thickness direction z) of the reverse-surface metal layer 113 may be flush with the resin reverse surface 52.

As shown in Figs. 31, 32, 36, and 39, the resin side surface 531 and the resin side surface 532 are spaced apart from each other in the first direction x. The resin side surface 531 and the resin side surface 532 face away from each other in the first direction x and extend in the second direction y. The resin side surface 531 and the resin side surface 532 are connected to the resin obverse surface 51. The resin side surface 531 faces the x1 side in the first direction x, and the resin side surface 532 faces the x2 side in the first direction x. The first power terminal 14 and the two second power terminals 15 protrude from the resin side surface 531. The two third power terminals 16 protrude from the resin side surface 532.

As shown in Figs. 31, 32, and 40 to 43, the resin side surface 533 and the resin side surface 534 are spaced apart from each other in the second direction y. The resin side surface 533 and the resin side surface 534 face away from each other in the second direction y and extend in the first direction x. The resin side surface 533 and the resin side surface 534 are connected to the resin obverse surface 51 and the resin reverse surface 52. The resin side surface 533 faces the y1 side in the second direction y, and the resin side surface 534 faces the y2 side in the second direction y.

As shown in Figs. 30, 39, 40, 43, and 44, each of the first recesses 511 is recessed from the resin obverse surface 51 toward the z2 side in the thickness direction z. In the present embodiment, the first recesses 810 are provided correspondingly to the control terminals 45, respectively. The control terminals 45 are disposed correspondingly to the first recesses 511.

As shown in Figs. 31, 39, 40, 43, and 44, each first recess 511 overlaps with the entirety of the holder 451 of a control terminal 45 in plan view. In the present embodiment, each first recess 511 has a first recess inner side surface 512 and a beveled portion 515 as shown in Fig. 44. The first recess inner side surface 512 extends in the thickness direction z and is inclined to form a conical shape having an inner diameter decreasing toward the z2 side in the thickness direction z.

As shown in Fig. 44, the first recess inner side surface 512 has a first end edge 513 and a second end edge 514. The first end edge 513 is located at the end on the z2 side in the thickness direction z of the first recess inner side surface 512 and is in contact with the control terminal support 48 (the first metal layer 482). The second end edge 514 is located at the end on the z1 side in the thickness direction z of the first recess inner side surface 512. The second end edge 514 surrounds the first end edge 513 in plan view.

The beveled portion 515 is connected to the resin obverse surface 51 and interposed between the resin obverse surface 51 and the first recess inner side surface 512. The specific shape of the beveled portion 515 is not particularly limited, and may be, for example, an R (round) shape or a C (chamfered) shape. In the illustrated example, the beveled portion 515 has an R (round) shape.

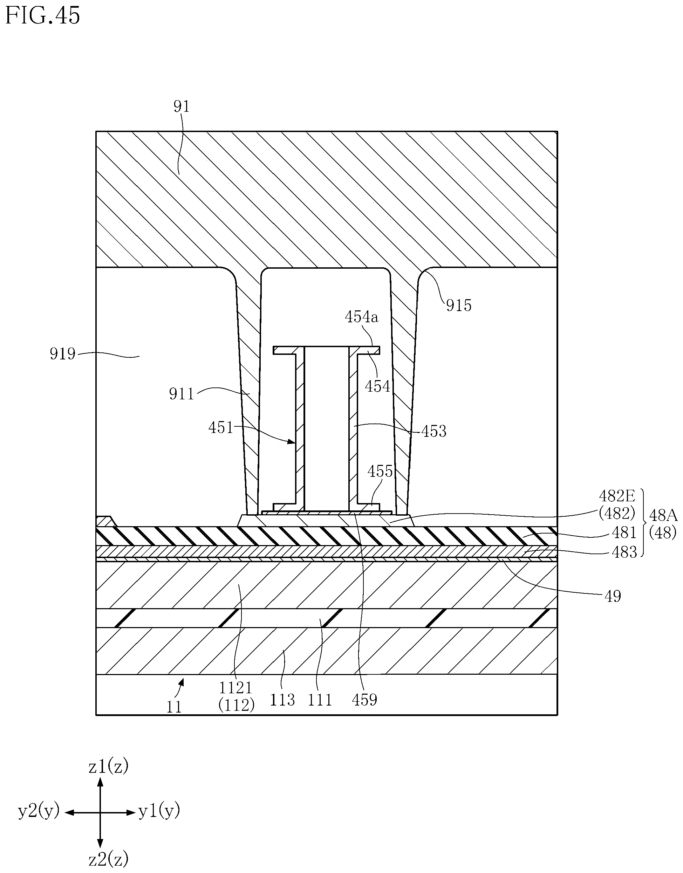

The first recess 810 having such a configuration is a trace of forming the sealing resin 8 by molding while pressing the control terminal support 48 with a pin or the like having a shape corresponding to the first recess 511, for example. Fig. 45 is a sectional view corresponding to Fig. 44, showing a step of a method for manufacturing the semiconductor device B1. As shown in Fig. 45, the mold 91 used for the molding is, for example, provided with a cylindrical tubular pin 911. With the holder 451 disposed in the internal space of the tubular pin 911 and the lower end (the end on the z2 side in the thickness direction z) of the tubular pin 911 pressed against the control terminal support 48 (the first metal layer 482), the flowable resin material is injected into the cavity 919 of the mold 91. As understood from Figs. 44 and 45, the first recess inner side surface 512 of the first recess 511 has a draft angle corresponding to the outer circumferential surface of the tubular pin 911. As shown in Fig. 45, the root of the tubular pin 911 of the mold 91 has a rounded portion 915. The beveled portion 515 of the first recess 511 has the shape corresponding to the rounded portion 915 of the mold 91. After the sealing resin 50 is formed by the molding process using the mold 91, the holder 451 disposed in the internal space of the tubular pin 911 is entirely exposed from the sealing resin 50.

Depending on the arrangement of the holder 451 of the control terminal 45, the lower end of the tubular pin 911 shown in Fig. 45 may be pressed against the region straddling the first metal layer 482 and the insulating layer 481 during the molding process. There is a step in the thickness direction z on the insulating layer 481 at the boundary between the portion on which the first metal layer 482 is formed and the portion on which the first metal layer 482 is not formed. Therefore, when the lower end of the tubular pin 911 is pressed against the region straddling the first metal layer 482 and the insulating layer 481, a gap may be formed between the lower end of the tubular pin 911 and the control terminal support 48 (the insulating layer 481). In light of such a case, a resist layer, for example, may be formed on the portion of the upper surface of the insulating layer 481 where the first metal layer 482 is not formed, to eliminate the above-described step between the portion where the first metal layer 482 is formed and the portion where the first metal layer 482 is not formed on the insulating layer 481. The lower end of the tubular pin 911 may be made of a cushioning material. In this case, when the tubular pin 911 is pressed against the control terminal support 48, the cushioning material can absorb the above-described step, thereby preventing a gap from being formed between the lower end of the tubular pin 911 and the control terminal support 48 (insulation layer 481).

The method for forming the first recess 511 is not limited to that described with reference to Fig. 45. For example, the sealing resin 50 may be formed by molding while pressing the control terminal support 48 with a columnar solid pin corresponding to the first recess 511. In this case, the holder 451 is not on the control terminal support 48 during the molding. The holder 451 is disposed within the first recess 511 on the control terminal support 48 after the molding.

In the illustrated example, the first surface 454a of the holder 451 (first flange portion 454) is located on the z2 side in the thickness direction z with respect to the resin obverse surface 51. Thus, the entirety of the holder 451 is housed in the first recess 511.

As shown in Fig. 31, the pair of recesses 531a are recessed from the resin side surface 531 toward the x2 side in the first direction x. The recesses 531a extend from the resin obverse surface 51 to the resin reverse surface 52 in the thickness direction **z.** The recesses 531a are located on each side of the first power terminal 14 in the second direction y.

Next, the effects of the present embodiment will be described.

Each of the holders 451 constituting the control terminals 45 is disposed on the obverse surface 1120 of the support conductor 112 (support substrate 11). The metal pins 452 constituting the control terminals 45 protrude beyond the resin obverse surface 51 toward the z1 side in the thickness direction z. With such a configuration, the control terminals 45 are located in the regions surrounded by the resin obverse surface 51 (sealing resin 50) in plan view. The semiconductor device B1 having such a configuration allows reduction in size in plan view.

The holder 451 of each control terminal 45 is entirely exposed from the sealing resin 50. With such a configuration, it is possible to prevent the sealing resin 50 from flowing into the holder 451, in which the metal pin 452 is to be inserted. Therefore, the semiconductor device B1 can properly maintain the electrical conduction of the holder 451 and the metal pin 452, thereby allowing the control terminal 45 including the holder 451 and the metal pin 452 to function properly.

The control terminals 45 are disposed in the first recesses 511 of the sealing resin 50. In the present embodiment, the sealing resin 50 has a plurality of first recesses 511, and the plurality of control terminals 45 are disposed correspondingly to the plurality of first recesses 511, respectively. Each first recess 511 (the first recess inner side surface 512) has a first end edge 513 that is in contact with the control terminal support 48 (the first metal layer 482). Such a configuration increases the creepage distance between adjacent control terminals 45 along the surfaces (the resin obverse surface 51, the first recess inner side surface 512 of the first recess 511, etc.) of the sealing resin 50. Thus, the semiconductor device B1 is suitable for increasing the withstand voltage of adjacent control terminals 45 while reducing the size in plan view.

Each first recess 511 overlaps with the entirety of the holder 451 of a control terminal 45 in plan view. With such a configuration, the holder 451 surrounded by the first recess 511 is clearly visible in plan view. This facilitates the work of press-fitting the metal pin 452 into the holder 451.

Variations of the semiconductor device according to the second aspect of the present disclosure will be described below. Various parts of the variations may be selectively used in any appropriate combination as long as it is technically compatible.

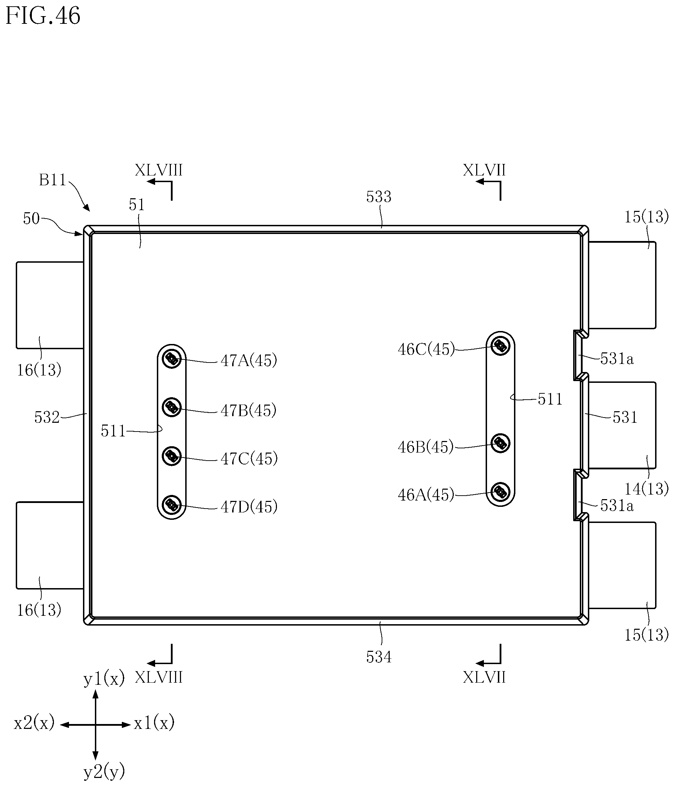

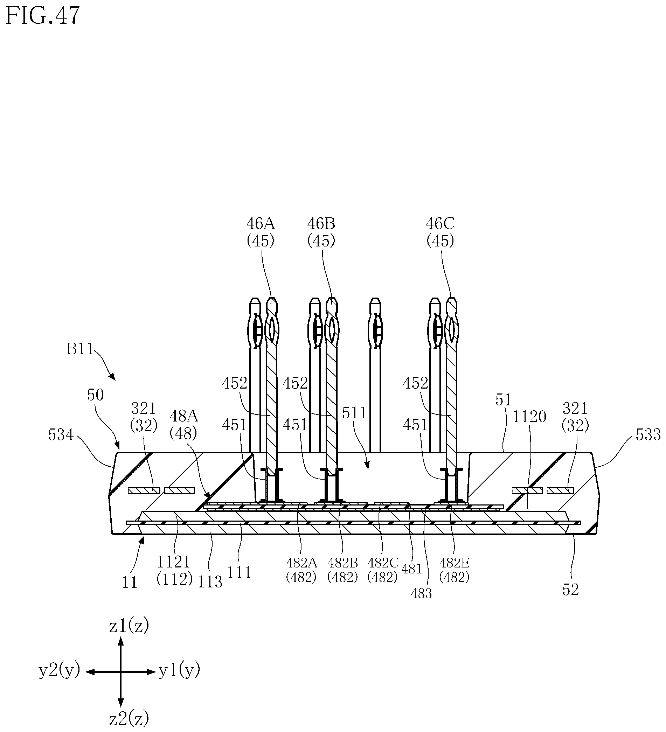

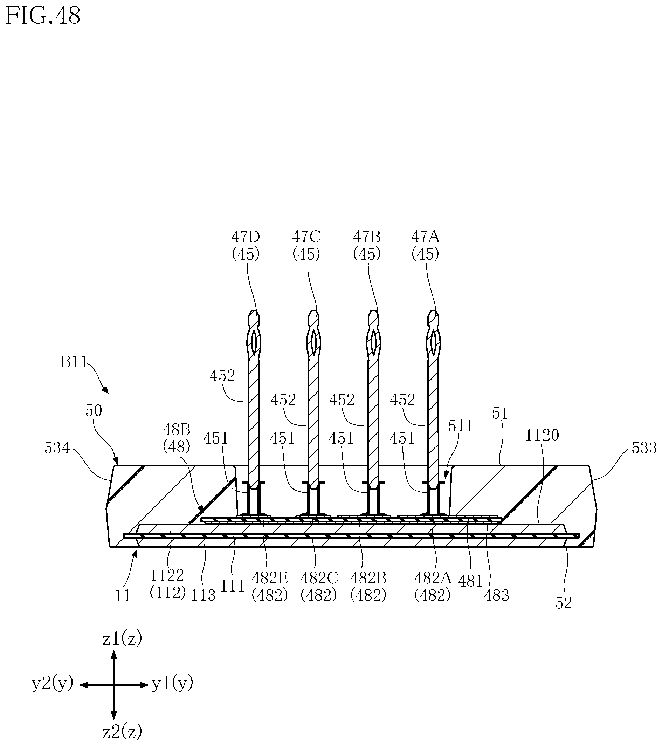

Figs. 46 to 48 show a semiconductor device according to a first variation of the first embodiment of the second aspect. Fig. 46 is a plan view of the semiconductor device B11 of the present variation. Fig. 47 is a sectional view taken along line XLVII-XLVII in Fig. 46. Fig. 48 is a sectional view taken along line XLVIII-XLVIII in Fig. 46. In Fig. 46 and the subsequent drawings, the elements that are identical or similar to those of the semiconductor device B1 of the above-described embodiment are denoted by the same reference signs as those used for the above-described embodiment, and the descriptions thereof are omitted.

The semiconductor device B11 of the present variation differs from the semiconductor device B1 of the above-described embodiment in the configuration of the first recesses 511 of the sealing resin 50. As shown in Figs. 46 to 48, in the semiconductor device B11, the sealing resin 50 has two first recesses 511. The first one of the two first recesses 511 corresponds to a plurality of control terminals 45 (the first control terminals 46A to 46C), and these control terminals 45 (the first control terminals 46A to 46C) are disposed in the first one of the first recesses 511. The first one of the first recesses 511 overlaps with the entirety of the holder 451 of each of these control terminals 45 (the first control terminals 46A to 46C) in plan view. The second one of the two first recesses 511 corresponds to a plurality of control terminals 45 (the second control terminals 47A to 47D), and these control terminals 45 (the second control terminals 47A to 47D) are disposed in the second one of the first recesses 511. The second one of the first recesses 511 overlaps with the entirety of the holder 451 of each of these control terminals 45 (the second control terminals 47A to 47D) in plan view.

In the semiconductor device B11 of the present variation, each of the holders 451 constituting the control terminals 45 is disposed on the obverse surface 1120 of the support conductor 112 (support substrate 11). The metal pins 452 constituting the control terminals 45 protrude beyond the resin obverse surface 51 toward the z1 side in the thickness direction z. With such a configuration, the control terminals 45 are located in the regions surrounded by the resin obverse surface 51 (sealing resin 50) in plan view. The semiconductor device B1 having such a configuration allows reduction in size in plan view.

The holder 451 of each control terminal 45 is entirely exposed from the sealing resin 50. With such a configuration, it is possible to prevent the sealing resin 50 from flowing into the holder 451, in which the metal pin 452 is to be inserted. Therefore, the semiconductor device B11 can properly maintain the electrical conduction of the holder 451 and the metal pin 452, thereby allowing the control terminal 45 including the holder 451 and the metal pin 452 to function properly.

The control terminals 45 are disposed in the first recesses 511 of the sealing resin 50. In the semiconductor device B11, the sealing resin 50 has two first recesses 511. A plurality of control terminals 45 (the first control terminals 46A to 46C) are disposed in one of the first recesses 511, and a plurality of control terminals 45 (the second control terminals 47A to 47D) are disposed in the other first recess 511. With the configuration in which a plurality of control terminals 45 are collectively disposed in one first recess 511, the sealing resin 50 can be formed relatively easily by molding.

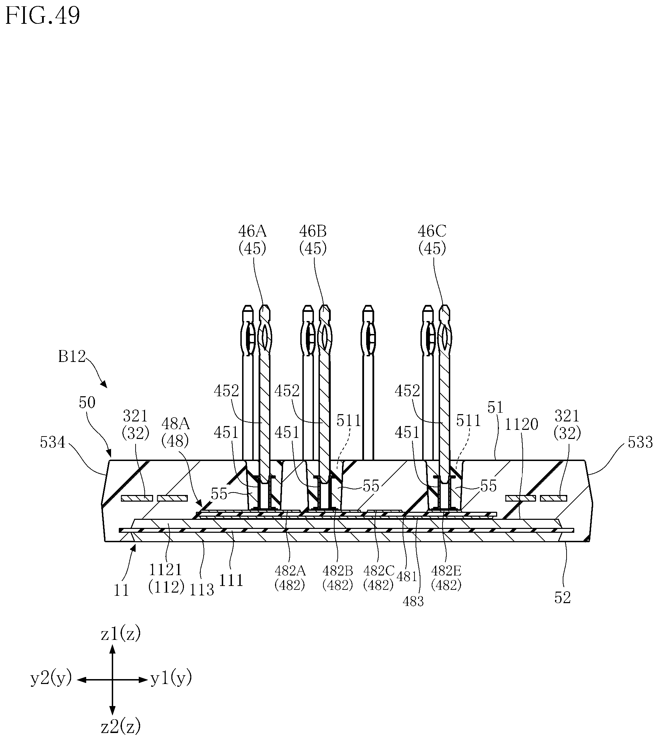

Fig. 49 shows a semiconductor device according to a second variation of the first embodiment of the second aspect. Fig. 49 is a sectional view corresponding to Fig. 40, showing the semiconductor device B12 of the present variation. The semiconductor device B12 of the present variation further includes first resin parts 55 and differs from the semiconductor device B1 of the above-described embodiment in the inclusion of the first resin parts 55.

Each of the first resin parts 55 fills at least a part of a first recess 511 and is in contact with at least a part of a holder 451. In the semiconductor device B12, the first resin part 55 is loaded in each first recess 511 to fill the first recess 511. The first resin part 55 covers the entirety of the holder 451 disposed in the first recess 511. The constituent material of the first resin part 55 is not particularly limited. The first resin part 55 may be made of the same material as the sealing resin 50 or may be made of a material different from the sealing resin 50. In the semiconductor device B12, the constituent material of the first resin part 55 is, for example, different from the constituent material of the sealing resin 50. In the semiconductor device B12, the modulus of elasticity of the first resin part 55 is, for example, smaller than that of the sealing resin 50. The constituent material of the first resin part 55 in the case where the modulus of elasticity of the first resin part 55 is smaller than that of the sealing resin 50 is not particularly limited, but may be silicone resin or silicone gel, for example.

In the semiconductor device B12 of the present variation, each of the holders 451 constituting the control terminals 45 is disposed on the obverse surface 1120 of the support conductor 112 (support substrate 11). The metal pins 452 constituting the control terminals 45 protrude beyond the resin obverse surface 51 toward the z1 side in the thickness direction z. With such a configuration, the control terminals 45 are located in the regions surrounded by the resin obverse surface 51 (sealing resin 50) in plan view. The semiconductor device B1 having such a configuration allows reduction in size in plan view.

The holder 451 of each control terminal 45 is entirely exposed from the sealing resin 50. With such a configuration, it is possible to prevent the sealing resin 50 from flowing into the holder 451, in which the metal pin 452 is to be inserted. Therefore, the semiconductor device B12 can properly maintain the electrical conduction of the holder 451 and the metal pin 452, thereby allowing the control terminal 45 including the holder 451 and the metal pin 452 to function properly.

In the semiconductor device B12, the first resin part 55 is loaded in each first recess 511 to fill the first recess 511. The first resin part 55 covers the holder 451 disposed in the first recess 511. The modulus of elasticity of the first resin part 55 is smaller than that of the sealing resin 50. Such a configuration reduces the stress around the holder 451 covered with the first resin part 55. Further, in the semiconductor device B12, the provision of the first resin parts 55 prevents foreign matter (including moisture) from entering the first recesses 511, which are exposed from the sealing resin 50. The semiconductor device B12 having the above-described configuration is favorable for increasing the durability and the reliability. In addition, the semiconductor device B12 has a configuration in common with the semiconductor device B1 of the above-described embodiment to have the same effects as the above-described embodiment.

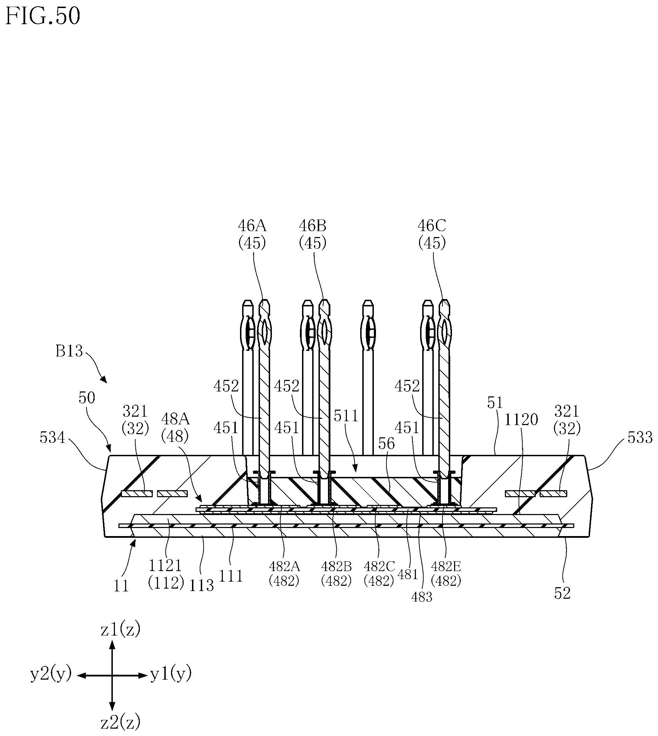

Fig. 50 shows a semiconductor device according to a third variation of the first embodiment of the second aspect. Fig. 50 is a sectional view corresponding to Fig. 47, showing the semiconductor device B13 of the present variation. The semiconductor device B13 of the present variation further includes first resin parts 55 and differs from the semiconductor device B11 of the above-described variation in the inclusion of the first resin parts 55.

Each of the first resin parts 55 fills at least a part of a first recess 511 and is in contact with at least a part of each holder 451. In the semiconductor device B13, the first resin part 55 fills a part of the first recess 511. The first resin part 55 covers a part of each of the holders 451 disposed in the first recess 511. The constituent material of the first resin part 55 is not particularly limited. The first resin part 55 may be made of the same material as the sealing resin 50 or may be made of a material different from the sealing resin 50. In the semiconductor device B13, the constituent material of the first resin part 55 is, for example, different from the constituent material of the sealing resin 50. In the semiconductor device B13, the modulus of elasticity of the first resin part 55 is, for example, greater than that of the sealing resin 50. The constituent material of the first resin part 55 in the case where the modulus of elasticity of the first resin part 55 is greater than that of the sealing resin 50 is not particularly limited, but may be an epoxy-based potting material, for example.

In the semiconductor device B13 of the present variation, each of the holders 451 constituting the control terminals 45 is disposed on the obverse surface 1120 of the support conductor 112 (support substrate 11). The metal pins 452 constituting the control terminals 45 protrude beyond the resin obverse surface 51 toward the z1 side in the thickness direction z. With such a configuration, the control terminals 45 are located in the regions surrounded by the resin obverse surface 51 (sealing resin 50) in plan view. The semiconductor device B13 having such a configuration allows reduction in size in plan view.

The holder 451 of each control terminal 45 is entirely exposed from the sealing resin 50. With such a configuration, it is possible to prevent the sealing resin 50 from flowing into the holder 451, in which the metal pin 452 is to be inserted. Therefore, the semiconductor device B13 can properly maintain the electrical conduction of the holder 451 and the metal pin 452, thereby allowing the control terminal 45 including the holder 451 and the metal pin 452 to function properly.

In the semiconductor device B13, the first resin part 55 is loaded in each first recess 511. The first resin part 55 covers at least a part of each holder 451 disposed in the first recess 511. The modulus of elasticity of the first resin part 55 is greater than that of the sealing resin 50. Such a configuration improves the shock resistance of the holders 451 covered with the first resin part 55. The semiconductor device B13 having the above-described configuration is favorable for improving the performance. In addition, the semiconductor device B13 has the same effects as those of the semiconductor device B11 of the above-described variation.

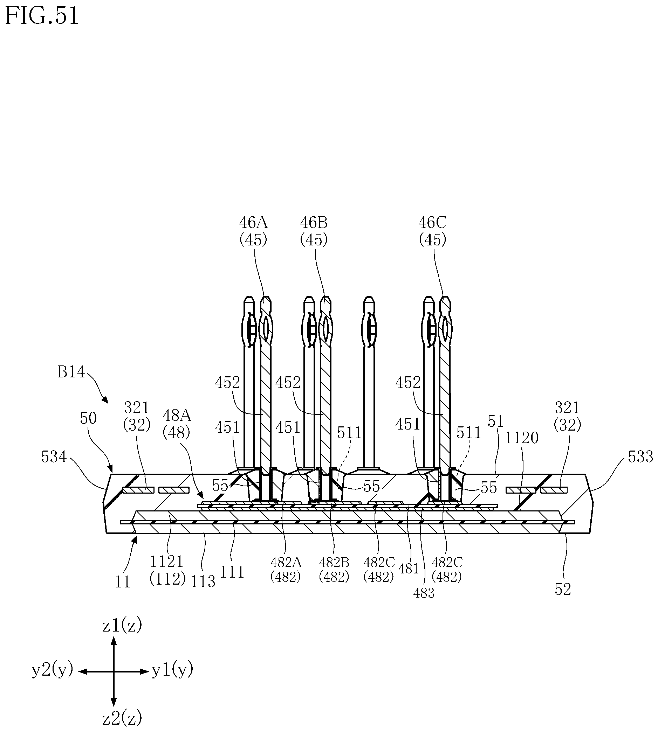

Fig. 51 shows a semiconductor device according to a fourth variation of the first embodiment of the second aspect. Fig. 51 is a sectional view corresponding to Fig. 40, showing the semiconductor device B14 of the present variation. The semiconductor device B14 of the present variation further includes first resin parts 55. In the semiconductor device B14, the dimension of the sealing resin 50 in the thickness direction z is smaller than that in the semiconductor device B1 of the above-described embodiment. Accordingly, the dimension of each first recess 511 in the thickness direction z is also smaller than that in the semiconductor device B1. Further, the holder 451 of each control terminal 45 protrudes beyond the resin obverse surface 51 of the sealing resin 50 toward the z1 side in the thickness direction z. The first surface 454a of the holder 451 (first flange portion 454) is located on the z1 side in the thickness direction z with respect to the resin obverse surface 51. Thus, a part of the holder 451 is housed in the first recess 511.

Each of the first resin parts 55 fills at least a part of a first recess 511 and is in contact with at least a part of a holder 451. In the semiconductor device B14, the first resin part 55 is loaded in each first recess 511 to fill the first recess 511. The constituent material of the first resin part 55 is not particularly limited. The first resin part 55 may be made of the same material as the sealing resin 50 or may be made of a material different from the sealing resin 50. In the semiconductor device B14, the constituent material of the first resin part 55 is, for example, different from the constituent material of the sealing resin 50. In the semiconductor device B14, the modulus of elasticity of the first resin part 55 is, for example, smaller than that of the sealing resin 50. The constituent material of the first resin part 55 in the case where the modulus of elasticity of the first resin part 55 is smaller than that of the sealing resin 50 is not particularly limited, but may be silicone resin or silicone gel.

In the semiconductor device B14, each first resin part 55 has a portion located on the z1 side in the thickness direction z relative to the resin obverse surface 51. The portion of the first resin part 55 that is located on the z1 side in the thickness direction z relative to the resin obverse surface 51 is the portion that has risen along the outer circumferential surface of the holder 451 (tubular portion 453) toward the z1 side in the thickness direction z due to, for example, the surface tension of the first resin part 55. In the illustrated example, the first surface 454a of the holder 451 (the first flange portion 454) is exposed from the first resin part 55.

In the semiconductor device B14 of the present variation, each of the holders 451 constituting the control terminals 45 is disposed on the obverse surface 1120 of the support conductor 112 (support substrate 11). The metal pins 452 constituting the control terminals 45 protrude beyond the resin obverse surface 51 toward the z1 side in the thickness direction z. With such a configuration, the control terminals 45 are located in the regions surrounded by the resin obverse surface 51 (sealing resin 50) in plan view. The semiconductor device B14 having such a configuration allows reduction in size in plan view.

The holder 451 of each control terminal 45 is entirely exposed from the sealing resin 50. With such a configuration, it is possible to prevent the sealing resin 50 from flowing into the holder 451, in which the metal pin 452 is to be inserted. Therefore, the semiconductor device B14 can properly maintain the electrical conduction of the holder 451 and the metal pin 452, thereby allowing the control terminal 45 including the holder 451 and the metal pin 452 to function properly.

In the semiconductor device B14, the first resin part 55 is loaded in each first recess 511. The first resin part 55 covers the holder 451 disposed in the first recess 511. The modulus of elasticity of the first resin part 55 is smaller than that of the sealing resin 50. Such a configuration reduces the stress around the holder 451 covered with the first resin part 55. In the semiconductor device B14, the first surface 454a of each holder 451 is exposed from the first resin part 55. This makes it possible to press-fit the metal pin 452 into the holder 451 after the first resin part 55 is loaded in the first recess 511. Also, the work of press-fitting the metal pin 452 into the holder 451 is stabilized. In addition, the semiconductor device B14 has a configuration in common with the semiconductor device B1 of the above-described embodiment to have the same effects as the above-described embodiment.

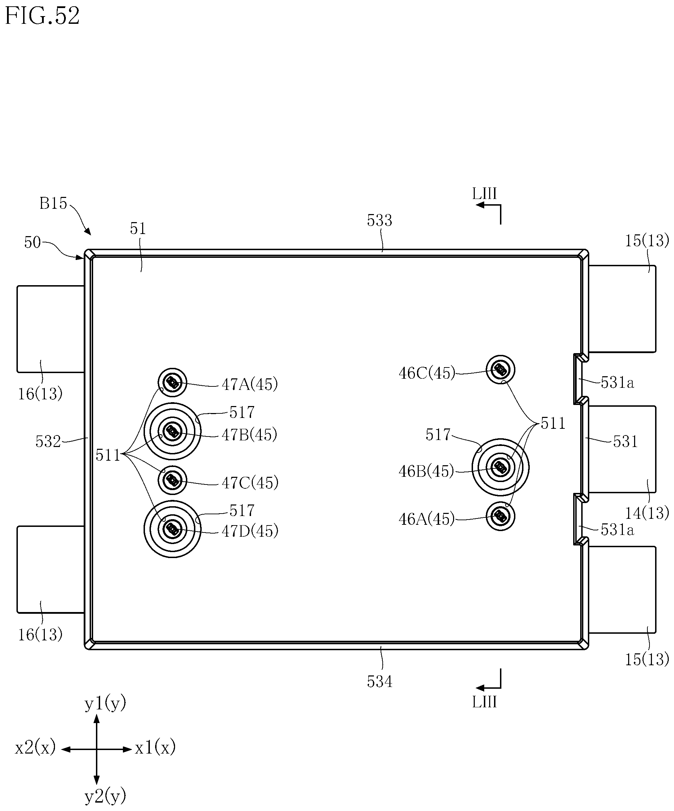

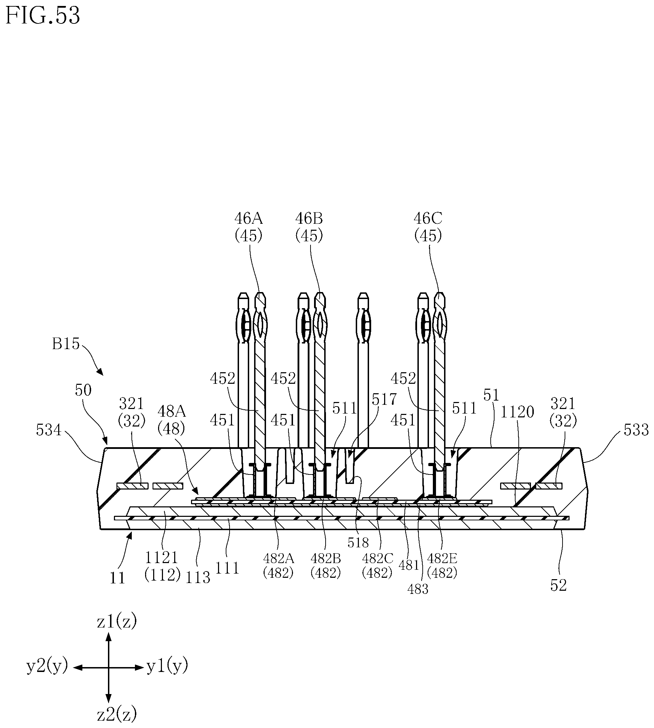

Figs. 52 and 53 show a semiconductor device according to a fifth variation of the first embodiment of the second aspect. Fig. 52 is a plan view of the semiconductor device B15 of the present variation. Fig. 53 is a sectional view taken along line LIII-LIII in Fig. 52. In the semiconductor device B15 of the present variation, the sealing resin 50 has a plurality of second recesses 517. The semiconductor device B15 differs from the semiconductor device B1 of the above-described embodiment in that the sealing resin 50 has the second recesses 517.

The second recesses 517 are recessed from the resin obverse surface 51 toward the z2 side in the thickness direction z. In the semiconductor device B15, the sealing resin 50 has a plurality of second recesses 517. Each of the second recesses 517 is provided correspondingly to one of the first recesses 511. As shown in Fig. 52, each second recess 517 surrounds a corresponding first recess 511 in plan view. In the illustrated example, the second recess 517 has the shape of a circular loop in plan view.

As shown in Fig. 53, each second recess 517 has a second recess bottom surface 518. The second recess bottom surface 518 is located at the end on the z2 side in the thickness direction z of the second recess 517. The second recess bottom surface 518 is spaced apart from the control terminal support 48 to the z1 side in the thickness direction z.

In the semiconductor device B15 of the present variation, each of the holders 451 constituting the control terminals 45 is disposed on the obverse surface 1120 of the support conductor 112 (support substrate 11). The metal pins 452 constituting the control terminals 45 protrude beyond the resin obverse surface 51 toward the z1 side in the thickness direction z. With such a configuration, the control terminals 45 are located in the regions surrounded by the resin obverse surface 51 (sealing resin 50) in plan view. The semiconductor device B15 having such a configuration allows reduction in size in plan view.

The holder 451 of each control terminal 45 is entirely exposed from the sealing resin 50. With such a configuration, it is possible to prevent the sealing resin 50 from flowing into the holder 451, in which the metal pin 452 is to be inserted. Therefore, the semiconductor device B15 can properly maintain the electrical conduction of the holder 451 and the metal pin 452, thereby allowing the control terminal 45 including the holder 451 and the metal pin 452 to function properly.

In the semiconductor device B15, the sealing resin 50 has the second recess 517. The second recess 517 surrounds the first recess 511 in plan view. The end on the z2 side in the thickness direction z of the second recess 517 (the second recess bottom surface 518) is spaced apart from the control terminal support 48 to the z1 side in the thickness direction z. Such a configuration increases the creepage distance between the control terminal 45 surrounded by the second recess 517 in plan view and an adjacent control terminal 45 along the surfaces (the resin obverse surface 51, the first recess inner side surface 512 of the first recess 511, the second recess 517, etc.) of the sealing resin 50. Thus, the semiconductor device B15 can increase the withstand voltage of adjacent control terminals 45 while reducing the size in plan view. In addition, the semiconductor device B15 has a configuration in common with the semiconductor device B1 of the above-described embodiment to have the same effects as the above-described embodiment.

The semiconductor device according to the present disclosure is not limited to the above-described embodiments. Various modifications in design may be made freely in the specific structure of each part of the semiconductor device according to the present disclosure.

Although the foregoing embodiments and variations describe the case where all of the holders 451 of the control terminals 45 are exposed from the sealing resin 50, the present disclosure is not limited to such a case. For example, the holders 451 of some of the control terminals 45 may be covered with the sealing resin 50.

The second aspect of the present disclosure includes the configurations described in the following clauses 1B to 17B.

### Clause 1B.

A semiconductor device comprising:
a support substrate including an obverse surface facing a first side in a thickness direction;
at least one terminal including a holder disposed on the obverse surface and having electrical conductivity and a metal pin inserted in the holder; and
a sealing resin including a resin obverse surface facing the first side in the thickness direction and covering at least a part of the support substrate, wherein
the holder of at least one of the at least one terminal is entirely exposed from the sealing resin, and
the metal pin protrudes beyond the resin obverse surface toward the first side in the thickness direction.

### Clause 2B.

The semiconductor device according to clause 1B, further comprising a terminal support interposed between the support substrate and the at least one terminal in the thickness direction,
wherein the holder is supported on the terminal support.

### Clause 3B.

The semiconductor device according to clause 2B, wherein the sealing resin covers a part of the terminal support.

### Clause 4B.

The semiconductor device according to clause 3B, comprising a plurality of said terminals, wherein
the sealing resin includes at least one first recess that is recessed from the resin obverse surface toward a second side in the thickness direction,
the at least one first recess includes a first end edge that is in contact with the terminal support, and
the plurality of terminals are disposed in the at least one first recess.

### Clause 5B.

The semiconductor device according to clause 4B, comprising a plurality of said first recesses, wherein
the plurality of terminals are disposed correspondingly to the plurality of first recesses, respectively,
each of the plurality of first recesses overlaps with entirety of the holder of a corresponding one of the terminals as viewed in the thickness direction.

### Clause 6B.

The semiconductor device according to clause 4B, wherein the first recess overlaps with entirety of the holders of the plurality of terminals.

### Clause 7B.

The semiconductor device according to clause 5B or 6B, further comprising a first resin part filling at least a part of the first recess,
wherein the first resin part is in contact with at least a part of the holder.

### Clause 8B.

The semiconductor device according to clause 7B, wherein a constituent material of the first resin part differs from a constituent material of the sealing resin, and
a modulus of elasticity of the first resin part is smaller than a modulus of elasticity of the sealing resin.

### Clause 9B.

The semiconductor device according to clause 7B, wherein a constituent material of the first resin part differs from a constituent material of the sealing resin, and
a modulus of elasticity of the first resin part is greater than a modulus of elasticity of the sealing resin.

### Clause 10B.

The semiconductor device according to any one of clause 4B to 9B, wherein the sealing resin includes a second recess that is recessed from the resin obverse surface toward the second side in the thickness direction, and
the second recess surrounds the first recess as viewed in the thickness direction.

### Clause 11B.

The semiconductor device according to clause 10B, wherein the second recess includes a second recess bottom surface located at an end on the second side in the thickness direction, and
the second recess bottom surface is spaced apart from the terminal support to the first side in the thickness direction.

### Clause 12B.

The semiconductor device according to any one of clause 4B to 11B (or any one of clauses 4B to 6B), wherein the at least one first recess includes a first recess inner side surface,
the first recess inner side surface includes a first end edge located at an end on the second side in the thickness direction and a second end edge located at an end on the first side in the thickness direction, and
the second end edge surrounds the first end edge as viewed in the thickness direction.

### Clause 13B.

The semiconductor device according to clause 12B, wherein the at least one first recess includes a beveled portion interposed between the resin obverse surface and the first recess inner side surface.

### Clause 14B.

The semiconductor device according to any one of clause 1B to 13B (or any one of clauses 1B to 6B), wherein the holder includes a first surface located at an end on the first side in the thickness direction, and
the first surface is located on the second side in the thickness direction relative to the resin obverse surface.

### Clause 15B.

The semiconductor device according to any one of clause 2B to 13B (or any one of clauses 2B to 6B), further comprising at least one semiconductor element disposed on the obverse surface and electrically connected to the at least one terminal.

### Clause 16B.

The semiconductor device according to clause 15B, wherein the at least one terminal is a control terminal for controlling the at least one semiconductor element.

### Clause 17B.

The semiconductor device according to clause 16B, wherein the support substrate includes a first conductive portion and a second conductive portion spaced apart from each other in a first direction orthogonal to the thickness direction,
the at least one semiconductor element includes a first switching element bonded to the first conductive portion and a second switching element bonded to the second conductive portion,
the control terminal includes a first control terminal for controlling the first switching element and a second control terminal for controlling the second switching element, and
the terminal support includes a first support portion supporting the first control terminal and a second support portion supporting the second control terminal.

### REFERENCE NUMERALS

### (Reference numerals for the first aspect)

A1, A11, A12, A13, A14, A15, A2: Semiconductor device
10A: First semiconductor element
10B: Second semiconductor element
101: Element obverse surface
102: Element reverse surface
11: First obverse-surface electrode
12: Second obverse-surface electrode
121: Gate finger 13: Third obverse-surface electrode
15: Reverse-surface electrode 17: Thermistor
19: Conductive bonding material 3: Support substrate
301: Support surface 302: Bottom surface
31: Insulating layer 32: Support conductor
32A: First conductive portion 32B: Second conductive portion
321: First bonding layer 33: Reverse-surface metal layer
41: First terminal 42: Second terminal
43: Third terminal 44: Fourth terminal
45: Control terminal 451: Holder
452: Metal pin 453: Tubular portion
453a: First outer side surface 453b: First inner side surface
454: First flange portion 454a: First surface
454b: Second surface 455: Second flange portion
459: Conductive bonding material
46A, 46B, 46C, 46D, 46E: First control terminal
47A, 47B, 47C, 47D: Second control terminal
48: Control terminal support (Terminal support)
48A: First support portion 48B: Second support portion
481: Insulating layer 482: First metal layer
482A: First portion 482B: Second portion
482C: Third portion 482D: Fourth portion
482E: Fifth portion 482F: Sixth portion
483: Second metal layer 49: Bonding material
5: First conductive member 51: Main portion
514: First opening 52: First bond portion
53: Second bond portion 59: Conductive bonding material
6: Second conductive member 602: First stepped portion
603: Second stepped portion 61: Third bond portion
611: Flat section 612: First inclined section
64: First path portion 641: First strip portion
643: First extension portion 649: Recess
65: Second path portion 651: Second strip portion
653: Second extension portion 659: Recess
66: Third path portion 669: Recess
67: Fourth path portion 69: Conductive bonding material
71, 72, 73, 74: Wire 8: Sealing resin
81: Resin obverse surface 810: First recess
811: Recess inner side surface 812: Recess bottom surface
813: Recess end edge 814: Cylindrical inner side surface
815: Tapered inner side surface 82: Resin reverse surface
831, 832: Resin side surface 832a: Recess
833, 834: Resin side surface 851: Protrusion
851a: Protrusion end surface 851b: Recess
851c: Inner wall surface 852: First protrusion
852a: Protrusion top surface 89: First resin fill portion
L1: First dimension L2: Second dimension

### (Reference numerals for the second aspect)

B1, B11, B12, B13, B14, B15: Semiconductor device
11: Support substrate 111: Insulating layer
112: Support conductor 1120: Obverse surface
1121: First conductive portion 1122: Second conductive portion
113: Reverse-surface metal layer 13: Power terminal
14: First power terminal 15: Second power terminal
16: Third power terminal 21: Semiconductor element
21A: First element (First switching element)
21B: Second element (Second switching element)
211: First electrode 212: Second electrode
213: Third electrode 214: Fourth electrode
22: Thermistor 23: Conductive bonding layer
31: First conductive member 310: Through-hole
311: Main body 312: First bond portion
313: Second bond portion 32: Second conductive member
321: Main body 322: Third bond portion
324: Fourth bond portion 326: Intermediate portion
327: Lateral beam portion 328: Suspended portion
33: First conductive bonding layer
34: Second conductive bonding layer
35: Third conductive bonding layer
36: Fourth conductive bonding layer
41: First wire 42: Second wire
43: Third wire 44: Fourth wire
45: Control terminal (Terminal) 451: Holder
452: Metal pin 453: Tubular portion
454: First flange portion 454a: First surface
455: Second flange portion 459: Conductive bonding layer
46A, 46B, 46C: First control terminal
47A, 47B, 47C, 47D: Second control terminal
48: Control terminal support (Terminal support)
48A: First support portion 48B: Second support portion
481: Insulating layer 482: First metal layer
482A: First portion 482B: Second portion
482C: Third portion 482D: Fourth portion
482E: Fifth portion 483: Second metal layer
49: Bonding layer 50: Sealing resin
51: Resin obverse surface 511: First recess
512: First recess inner side surface 513: First edge
514: Second edge 515: Beveled portion
517: Second recess 518: Second recess bottom surface
52: Resin reverse surface
531, 532, 533, 534: Resin side surface
531a: Recess 55: First resin part
91: Mold 911: Tubular pin
915: Rounded portion 919: Cavity

## Claims

1. A semiconductor device (B1) comprising:
a support substrate (11) including an insulating layer (111), a support conductor (112) and a reverse-surface metal layer (113), the support conductor (112) having an obverse surface (1120) facing one side (z1) of a thickness direction (z);
at least one semiconductor element (21) disposed on the obverse surface (1120);
at least one control terminal (45) for controlling the at least one semiconductor element (21);
a control terminal support (48) disposed between the support substrate (11) and the at least one control terminal (45) in the thickness direction (z) for supporting the control terminal (45); and
a sealing resin (50) having a resin obverse surface (51) facing the one side (z1) of the thickness direction (z), the sealing resin (50) covering at least a part of the support substrate (11),
wherein the control terminal (45) protrudes toward the one side (z1) of the thickness direction (z) with respect to the resin obverse surface (51),
the sealing resin (50) is formed with at least one first recess (511) recessed toward an opposite side (z2) of the thickness direction (z) from the resin obverse surface (51),
the at least one first recess (511) includes a first recess inner side surface (512) having a first end edge (513) held in contact with the control terminal support (48), and
the control terminal (45) is disposed in the at least one first recess (511) in a manner such that an entirety of the control terminal (45) is exposed from the sealing resin (50),
wherein the semiconductor device (B1) further comprises:
a first power terminal (14) and at least one second power terminal (15) that are disposed on one side (x1) of a first direction (x) relative to the support substrate (11), the first direction (x) being perpendicular to the thickness direction (z); and
at least one third power terminal (16) disposed on an opposite side (x2) of the first direction (x) relative to the support substrate (11),
wherein the first power terminal (14) and the at least one second power terminal (15) each include a portion covered by the sealing resin (50) and another portion exposed from the sealing resin (50).

2. The semiconductor device (B1) according to claim 1, wherein the control terminal (45) comprises an electrically conductive cylindrical holder (451) and a metal pin (452) inserted in the holder (451),
the holder (451) includes a tubular portion (453) extending in the thickness direction (z), a first flange portion (454) connected to an end of the tubular portion (453) on the one side (z1) of the thickness direction (z), and a second flange portion (455) connected to an end of the tubular portion (453) on the opposite side (z2) of the thickness direction (z), and
an entirety of the holder (451) is exposed from the sealing resin (50).

3. The semiconductor device (B1) according to claim 2, wherein the first recess (511) overlaps with the entirety of the holder (451) as viewed in the thickness direction (z).

4. The semiconductor device (B1) according to claim 2, wherein the at least one control terminal (45) comprises a plurality of control terminals (45) and the at least one first recess (511) comprises a plurality of first recesses (511),
the plurality of control terminals (45) are disposed correspondingly in position to the plurality of first recesses (511), respectively,
each of the plurality of first recesses (511) overlaps with the entirely of the holder (451) of a corresponding one of the plurality of control terminals (45).

5. The semiconductor device (B1) according to claim 1, wherein the first recess inner side surface (512) extends in the thickness direction (z) in an inclined manner such that an inner diameter thereof decreases toward the opposite side (z2) of the thickness direction (z).

6. The semiconductor device (B1) according to claim 1, wherein the first recess inner side surface (512) has the first end edge (513) located on the opposite side (z2) of the thickness direction (z) and a second end edge (514) located on the one side (z1) of the thickness direction (z),
the second end edge (514) surrounds the first end edge (513) as viewed in the thickness direction (z).

7. The semiconductor device (B1) according to claim 1, wherein the at least one first recess (511) includes a beveled portion (515) disposed between the resin obverse surface (51) and the first recess inner side surface (512).

8. The semiconductor device (B1) according to claim 1, wherein the control terminal (45) is a pin-shaped terminal for control of driving of the semiconductor element (21).

9. The semiconductor device (B1) according to claim 1, wherein the at least one control terminal (45) comprises a plurality of control terminals (45) and the at least one first recess (511) comprises a plurality of first recesses (511), and
the plurality of control terminals (45) are disposed correspondingly in position to the plurality of first recesses (511), respectively.

10. The semiconductor device (B1) according to claim 1, wherein the at least one control terminal (45) comprises a plurality of control terminals (45), and
the plurality of control terminals (45) are disposed in the at least one first recess (511).

11. The semiconductor device (B1) according to any one of claims 1 to 10, further comprising a first resin part (55) filled in the first recess (511).

12. The semiconductor device (B1) according to claim 1, wherein the at least one second power terminal (15) comprises two second power terminal (15),
the two second power terminals (15) are spaced apart from each other in a second direction (y) perpendicular to the thickness direction (z) and the first direction (x), and the two second power terminals (15) are disposed on one side (y1) and an opposite side (y2) of the second direction (y), respectively, thereby sandwiching the first power terminal (14) therebetween.

13. The semiconductor device (B1) according to claim 1, wherein the control terminal support (48) comprises an insulating layer (481) and a metal layer (482) disposed on a surface of the insulating layer (481) that faces the one side (z1) of the thickness direction (z),
the control terminal (45) is provided upright on the metal layer (482).

14. The semiconductor device (B1) according to claim 1, wherein the sealing resin (50) covers a part of the control terminal support (48).

15. A method of manufacturing a semiconductor device (B1) that comprises: a support substrate (11) having an obverse surface (1120) facing one side (z1) of a thickness direction (z); at least one semiconductor element (21) disposed on the obverse surface (1120); at least one control terminal (45) disposed on the obverse surface (1120) for controlling the at least one semiconductor element (21); a control terminal support (48) disposed between the support substrate (11) and the at least one control terminal (45) in the thickness direction (z) for supporting the control terminal (45); a sealing resin (50) having a resin obverse surface (51) facing the one side (z1) of the thickness direction (z), the sealing resin (50) covering at least a part of the support substrate (11); a first power terminal (14) and at least one second power terminal (15) that are disposed on one side (x1) of a first direction (x) relative to the support substrate (11), the first direction (x) being perpendicular to the thickness direction (z); and at least one third power terminal (16) disposed on an opposite side (x2) of the first direction (x) relative to the support substrate (11), wherein the control terminal (45) protrudes toward the one side (z1) of the thickness direction (z) with respect to the resin obverse surface (51),
the method comprising a sealing resin forming step of forming the sealing resin (50) by molding in a manner such that the sealing resin (50) covers at least a part of the support substrate (11), a part of the control terminal support (48), a part of each of the first power terminal (14) and the at least one second power terminal (15), and a part of each of the at least one third power terminal (16),
wherein the sealing resin forming step comprises performing the molding with a mold (91) being pressed against the control terminal support (48) in a state where the control terminal (45) is not placed on the control terminal support (48), so that a first recess (511) is formed in the sealing resin (50).

16. The method of manufacturing a semiconductor device (B1) according to claim 15, wherein in the sealing resin forming step, the resin obverse surface (51) and the first recess (511) are formed, the first recess (511) being recessed toward an opposite side (z2) of the thickness direction (z) from the resin obverse surface (51) and having a shape corresponding to the mold (91),
the first recess (511) includes a first recess inner side surface (512) extending in the thickness direction (z), and
the first recess inner side surface (512) is inclined such that an inner diameter thereof decreases toward the opposite side (z2) of the thickness direction (z).

17. The method of manufacturing a semiconductor device (B1) according to claim 16, wherein in the sealing resin forming step, the molding is performed in a manner such that the first recess (511) includes a beveled portion (515) between the resin obverse surface (51) and the first recess inner side surface (512).

18. The method of manufacturing a semiconductor device (B1) according to claim 17, wherein in the sealing resin forming step, the molding is performed in a manner such that each of a plurality of first recesses (511) is disposed to overlap with a corresponding control terminal (45) as viewed in the thickness direction (z).

19. The method of manufacturing a semiconductor device (B1) according to claim 15, wherein in the sealing resin forming step, the molding is performed in a manner such that the first recess (511) is disposed to overlap with a plurality of control terminals (45) as viewed in the thickness direction (z).

20. The method of manufacturing a semiconductor device (B1) according to claim 15, further comprising a step of forming an insulating layer (481) for the control terminal support (48) and a resist layer before the sealing resin forming step, the resist layer being formed in a region of an obverse surface of the insulating layer (481) where a first metal layer (482) is not formed.

21. The method of manufacturing a semiconductor device (B1) according to claim 15, wherein the mold (91) includes a lower end constituted by a cushioning material.

22. The method of manufacturing a semiconductor device (B1) according to any one of claims 15 to 21, further comprising a control terminal setting step of setting the control terminal (45) in the first recess (511) after the sealing resin forming step.

23. The method of manufacturing a semiconductor device (B1) according to claim 22, wherein in the control terminal setting step, a plurality of control terminals (45) are individually set in a plurality of first recesses (511), respectively.

24. The method of manufacturing a semiconductor device (B1) according to claim 22, wherein in the control terminal setting step, a plurality of control terminals (45) are set in the at least one first recess (511).

25. The method of manufacturing a semiconductor device (B1) according to claim 22, further comprising a step of filling a first resin part (55) in the first recess (511) after the control terminal setting step.
